(19) Europäisches Patentamt
European Patent Office
Office européen des brevets

(11) **EP 4 625 797 A1**

(12) **EUROPEAN PATENT APPLICATION**

(43) Date of publication:
01.10.2025 Bulletin 2025/40

(21) Application number: 25165790.4

(22) Date of filing: 24.03.2025

(51) International Patent Classification (IPC):
$H02M\ 1/32^{(2007.01)}$    $H02M\ 7/5387^{(2007.01)}$

(52) Cooperative Patent Classification (CPC):
H02M 1/32; H02M 7/53871

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 25.03.2024 US 202463569310 P

(71) Applicant: MagniX USA, Inc.
Redmond, WA 98052 (US)

(72) Inventors:
• ROGGIA, Sara
71045 Orta Nova (IT)
• CASTRO PALAVICINO, Pablo
Seattle 98107 (US)

(74) Representative: Brand Murray Fuller LLP
50 Eastcastle Street
London W1W 8EA (GB)

(54) **POWER SWITCH FAULT DETECTION IN AN ELECTRICAL POWER CONVERTER**

(57)    A system, method, and/or programming instructions for detecting a fault in a power switch in a circuit having a plurality of power switches for converting direct current (DC) to multiphase alternating current (AC) output power, the system configured to: calculate alpha currents and/or beta currents using respective alpha-beta transformations in each of a multiple of different reference frames; check the signs of the alpha currents and/or the beta currents calculated in each of the multiple of different reference frames; and determine, based upon the signs of at least one of the alpha currents, the beta currents, and the combinations thereof calculated in each of the multiple of different reference frames, whether one of a short circuit fault or an open circuit fault occurred in one of the plurality of power switches.

Fig. 10A

**Description**

FIELD OF THE INVENTION

This disclosure relates to diagnostic methods, techniques, and systems for detecting faults or failures in power switches (e.g., power transistor switches) used in power inverters/converters, for example, to convert direct current (DC) power into alternating current (AC) power, including multiphase (e.g., 3 phase) AC power, and in one or more embodiments determining the type of fault and identifying the faulty power switch.

BACKGROUND

Power converters for converting DC input power, including, for example, high voltage DC input power, into AC output power, including, for example, high voltage AC output power are known. An example embodiment of a power converter that converts DC input into AC output power uses one or more power switches, including for example power transistor switches. In an example embodiment two power switches are used to produce a single phase of AC output power, and additional groups of two paired power switches can be used to produce further phases of AC output power to create multiphase AC output power. In an example embodiment, six power switches are configured to produce three phases (phases U, V, W) of AC output power.

Electric power converters are used in energy conversion. Motor controllers often include power converters which, for example, convert DC power, including high voltage DC (HVDC) power, into AC power, including high voltage AC (HVAC) power. In one or more instances motor controllers are used to power, control, and monitor electric motors, including variable speed electric motors, which can be used for example in electric vehicles including, for example, in the aerospace field, for example in manned aircraft. There are several types of faults associated with such power converters including controller faults, sensor (e.g., current sensor) faults, motor faults, and/or switching device faults including power (transistor) switch faults, for example open circuit and/or short circuit faults of such power switches. These faults can cause a power interruption, and in instances these faults can result in complications in the operation of the power converters. The ability to detect faults in these power converters, motor controllers, and/or voltage inverter/converters, including in the power switches used in such power converters, motor controllers, and/or voltage inverters/converters, is an important factor in ensuring safe and efficient performance.

It would be advantageous to detect faults or failures in power switches, e.g., power transistor switches, used in power inverters/converters to convert DC power input to AC output power. It would be further advantageous to detect and distinguish between the different types of power switch failures (e.g., open circuit and short circuit faults) as well as identify the specific failed power switch where multiple power switches are used together including multiple power switches to produce multiphase AC output power. It would be further advantageous to detect open circuit power switch faults, short circuit power switch faults, and/or both open circuit power switch faults and shorted power switch faults.

SUMMARY OF THE INVENTION

The summary of the disclosure is given to aid the understanding of DC to AC power inverters/converters and in an approach DC to AC power inverters/converters that use power (transistor) switches to produce AC output power, including multiple power (transistor) switches to produce multiphase AC output power. The present disclosure is directed to a person of ordinary skill in the art. The summary of the disclosure is given to aid the understanding, detection and identification of faults in or failure of power switches including detection and identification of open circuit and short circuit faults and/or failures of power switches used in power inverter/converter circuits. It should be understood that various aspects and features of the disclosure may advantageously be used separately in some instances, or in combination with other aspects and features of the disclosure in other instances.

In one or more embodiments, a method, technique, platform, system, and/or programming instructions for detecting a fault, e.g., an open circuit fault and/or a short circuit fault in a circuit for converting direct current (DC), preferably high voltage DC, to multiphase alternating current (AC), preferably high voltage AC, output power in a circuit that includes one or more, preferably a plurality of power switches is disclosed, preferably detecting a fault in the one or more power switches, and preferably identifying the specific power switch that had the fault and determining the specific type of fault.

Disclosed according to one or more embodiments is a method, technique, platform, system, and/or programming instructions for detecting a fault in a power switch in a circuit, preferably an inverter circuit, for converting direct current (DC) to multiphase alternating current (AC) output power where the circuit comprises a plurality of power switches, the method comprising: calculating alpha currents and beta currents in each of a multiple of different reference frames using respective alpha-beta transformations in each of the multiple of different reference frames; checking the signs of the alpha currents calculated in each of the multiple of different reference frames; checking the signs of the beta currents calculated in each of the multiple of different reference frames; and determining, based upon the signs of the alpha currents and the beta currents calculated in each of the multiple of different reference frames, whether a short circuit fault occurred in one of the plurality of power switches. The method, technique, platform, system, and/or programming instructions according to an approach further includes identifying, based upon the signs of the alpha currents and the beta currents calculated in each of the multiple different reference frames, the specific power switch out of the plurality of power switches that had the short circuit fault. In an embodiment the method, technique, platform, system, and/or programming instructions can further include: receiving current values of each multiphase AC output of the circuit; and using the alternating current values to calculate the alpha current and the beta current in each of the multiple different reference frames.

In an arrangement of the method, technique, platform, system, and/or programming instructions the number of multiple different reference frames is equal to the number of phases of multiphase AC output power of the circuit. In a further configuration of the method, technique, platform, system, and/or programming instructions the number of phases of multiphase AC output power of the circuit is three (3) phases and the number of multiple different reference frames is three (3) reference frames. In a further embodiment, each of the multiple different reference frames is rotated with respect to an adjacent different reference frame, and optionally the three different reference frames are rotated in the same direction 120 degrees from each adjacent reference frame. In yet another embodiment, each of the multiple different reference frames are rotated 360 degrees divided by the number of phases of multiphase AC output power of the inverter circuit with respect to the adjacent different reference frame, for example in a three phase system the different reference frames are rotated 360/3 (120) degrees apart.

The method, technique, platform, system, and/or programming instructions can in an approach further include determining, based upon the signs of the alpha currents calculated in each of the multiple different reference frames, whether an open circuit fault or potential open circuit fault occurred in one of the plurality of power switches. In a further approach, the method, technique, platform, system, and/or programming instructions can further include confirming whether the open circuit fault or the potential open circuit fault occurred in one of the plurality of power switches. In one or more embodiments, confirming whether the open circuit fault or potential open circuit fault occurred in one of the plurality of power switches further includes: determining the absolute voltage using the alpha voltage and the beta voltage; and determining if the absolute voltage is greater than the minimum voltage (Vlim) output by the circuit. The minimum voltage (Vlim) in an embodiment is the minimum voltage threshold of the circuit by running open switch fault scenarios at different operating points (speed v. torque) to define the minimum voltage level in each fault scenario, where Vlim equals a factor k times motor speed $\omega$ in revolutions per minute (Vlim = $k*\omega$) where factor $k$ is a proportional gain that will depend upon the circuit and motor configuration, as well as on the system configuration (Volts/RPM) and $\omega$ is motor speed in revolutions per minute (RPM). The method, technique, platform, system, and/or programming instructions can further include identifying, based upon the signs of the alpha currents in each of the multiple different reference frames, the specific power switch out of the plurality of power switches that had the open circuit fault or the potential open circuit fault.

A method, technique, platform, system, and/or programming instructions for detecting a fault in a power switch in a circuit, preferably an inverter circuit, for converting direct current (DC) to multiphase alternating current (AC) output power, where the circuit comprises a plurality of power switches, can in one or more embodiments include: calculating alpha currents in each of a multiple of different reference frames using respective alpha-beta transformations in each of the multiple of different reference frames; checking the signs of the alpha currents calculated in each of the multiple of different reference frames; and determining based upon the signs of the alpha currents calculated in each of the multiple of different reference frames whether an open circuit fault or a potentially open circuit fault occurred in one of the plurality of power switches. The method, technique, platform, system, and/or programming instructions can according to an approach further include confirming whether the open circuit fault or the potential open circuit fault occurred in one of the plurality of power switches. Confirming whether the open circuit fault or the potential open circuit fault occurred in one of the plurality of power switches according to an embodiment further includes: determining the absolute voltage using the alpha voltage and the beta voltage; and determining if the absolute voltage is greater than the minimum voltage (Vlim) output by the circuit. In a further aspect, the method, technique, platform, system, and/or programming instructions can further include identifying, based upon the signs of the alpha currents calculated in each of the multiple different reference frames, the specific power switch out of the plurality of power switches that had the open circuit fault or the potential open circuit fault.

The method, technique, platform, system, and/or programming instructions in a configuration can further include: receiving current values of each multiphase AC output power of the circuit; and using the alternating current values to calculate the alpha current and the beta current in each of the multiple different reference frames. The method, technique, platform, system, and/or programming instructions can further include: calculating beta currents in each of the multiple of different reference frames using the respective alpha-beta transformations in each of the multiple of different reference frames; checking the signs of the beta currents calculated in each of the multiple of different reference frames; and determining, based upon the signs of the alpha currents and the beta currents calculated in each of the multiple of different reference frames, whether a short circuit fault occurred in one of the plurality of power switches. The method, technique, platform, system, and/or programming instructions in an embodiment can further include identifying, based upon the signs of the alpha currents and the beta currents in each of the multiple different reference frames, the specific power switch out of the plurality of power switches that had the short circuit fault.

A system for detecting a fault in a power switch in a circuit, preferably an inverter circuit, for converting direct current (DC) to multiphase alternating current (AC) output power where the circuit comprises a plurality of power switches is disclosed, the system in one or more embodiments is configured to: calculate at least one of alpha currents, beta currents, and combinations thereof in each of a multiple of different reference frames using respective alpha-beta transformations in each of the multiple of different reference frames; check the signs of the alpha currents, the beta currents, and the combinations thereof calculated in each of the multiple of different reference frames; and determine, based upon the signs of at least one of the alpha currents, the beta currents, and the combinations thereof calculated in each of the multiple of different reference frames, whether one of a short circuit fault or an open circuit fault occurred in one of the plurality of power switches.

The system in an embodiment is further configured to identify, based upon the signs of the at least one of the alpha currents, the beta currents, and the combinations thereof calculated in each of the multiple different reference frames, the specific power switch out of the plurality of power switches that had the short circuit fault or the open circuit fault. In one or more arrangements, the system is further configured to: receive current values of each multiphase AC output of the circuit; and using the alternating current values to calculate the at least one of the alpha currents, the beta current, and the combinations thereof in each of the multiple different reference frames. In an approach, the system is further configured to determine, based upon the signs of the alpha currents and the beta currents calculated in each of the multiple different reference frames, whether a short circuit fault occurred in one of the plurality of power switches. In yet a further approach, the system is further configured to determine, based upon the signs of the alpha currents calculated in each of the multiple different reference frames, whether an open circuit fault or potential open circuit fault occurred in one of the plurality of power switches, and in a further embodiment is configured to confirm whether the open circuit fault or the potential open circuit fault occurred in one of the plurality of power switches. The system in an embodiment is further configured to identify, based upon the signs of the alpha currents in each of the multiple different reference frames, the specific power switch out of the plurality of power switches that had the open circuit fault or the potential open circuit fault. Configuring the system to confirm whether the open circuit fault or potential open circuit fault occurred in one of the plurality of power switches includes in an embodiment configuring the system to: determine the absolute voltage using the alpha voltage and the beta voltage; and determine if the absolute voltage is greater than the minimum voltage (Vlim) output by the circuit.

BRIEF DESCRIPTION OF THE DRAWINGS

The various aspects, features, and embodiments of a system and/or method of detecting power switch faults, including power transistor switch faults; determining the fault type, for example, short and/or open circuit faults; and/or identifying which switch out of multiple switches in an inverter/converter circuit failed will be better understood when read in conjunction with the figures provided. Embodiments are provided in the figures for the purpose of illustrating aspects, features, embodiments, and details of systems and/or methods of detecting failures or faults, including, for example, open and/or shorted faults, in power switches (e.g., power transistor switches), and in an embodiment identifying the specific failed power switch, but the disclosure should not be limited to the precise arrangement, structures, assemblies, subassemblies, systems, features, aspects, embodiments, methods, processes, devices, or uses shown. The arrangements, structures, assemblies, subassemblies, configurations, systems, devices, features, aspects, embodiments, methods, processes, and techniques shown may be used singularly or in combination with other arrangements, structures, assemblies, subassemblies, configurations, systems, devices, features, aspects, embodiments, methods, processes, and/or techniques.

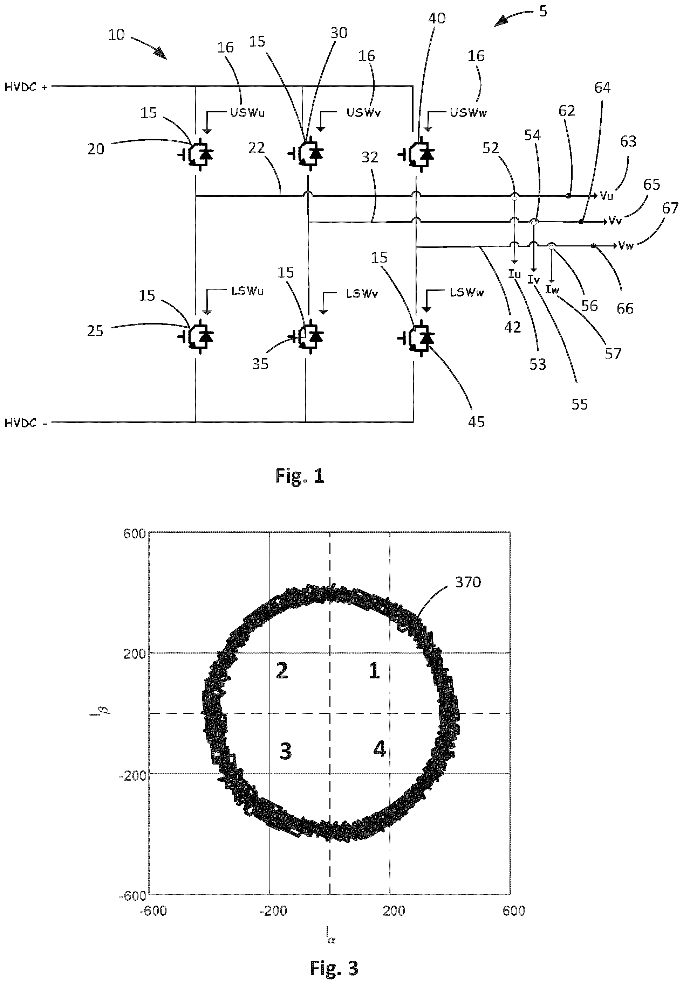

FIG. 1 illustrates a schematic diagram of multiple power switches arranged in and as part of power inverter/converter circuitry configured to produce alternating current (AC) output power, including multiphase (three-phase) AC output power, in response to direct current (DC) input power.

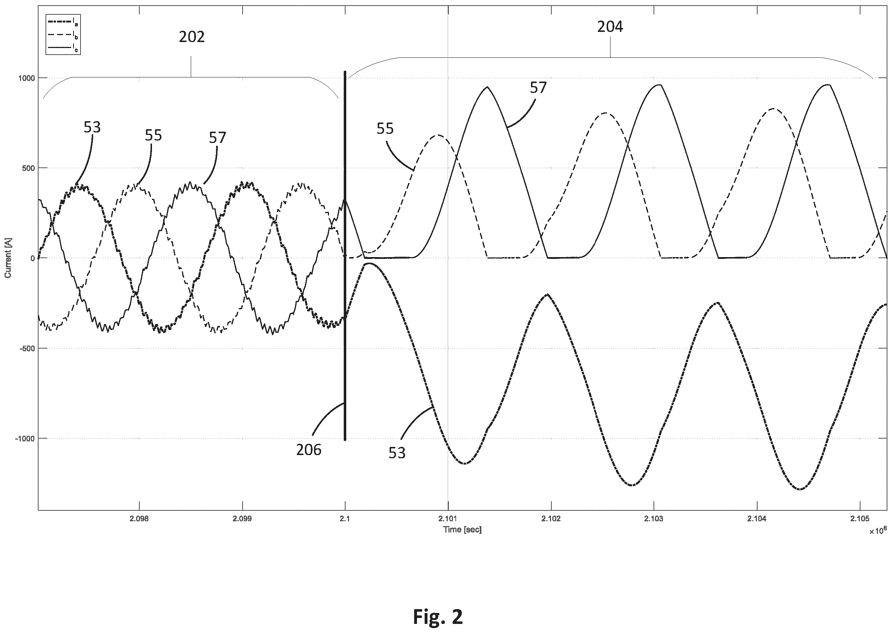

FIG. 2 illustrates the AC current output of a multiphase (three-phase) current over time before and after a power switch fault.

FIG. 3 illustrates a plot of the alpha current ($I\alpha$) v. beta current ($I\beta$) calculated using the AC current output of power switches in the alpha beta transformation where the power switches are operating properly and under normal conditions where there are no faults.

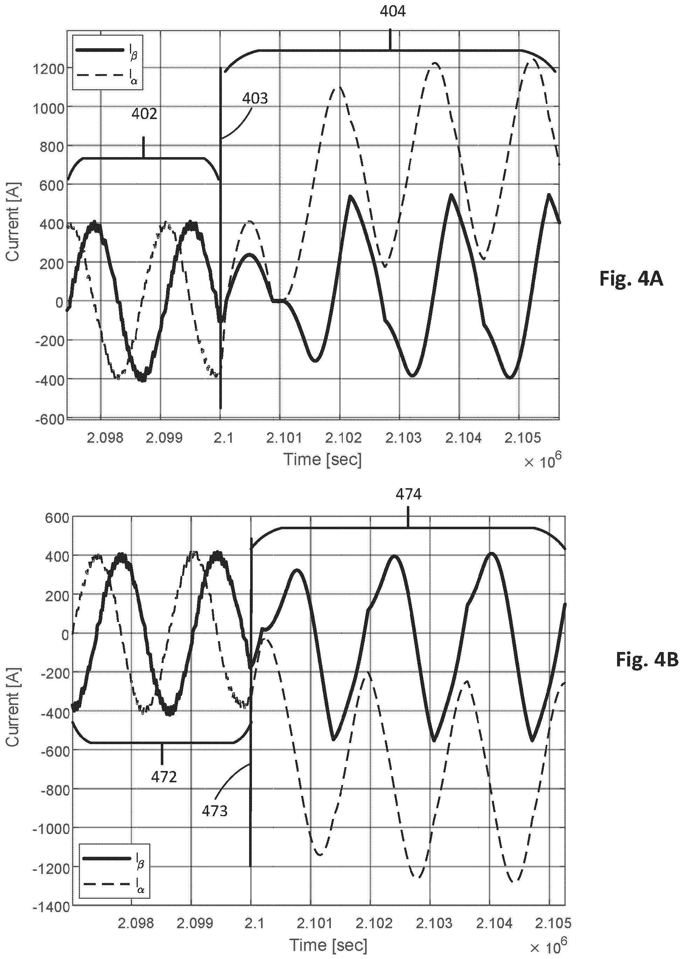

FIGs. 4A and 4B each illustrate a plot over time, before and after a short circuit fault of respective upper and lower first phase (phase U) power switches, of both the alpha current ($I\alpha$) and beta current ($I\beta$) calculated using the AC output current from the multiphase (e.g., 3 phase) power switches in the alpha beta transformation.

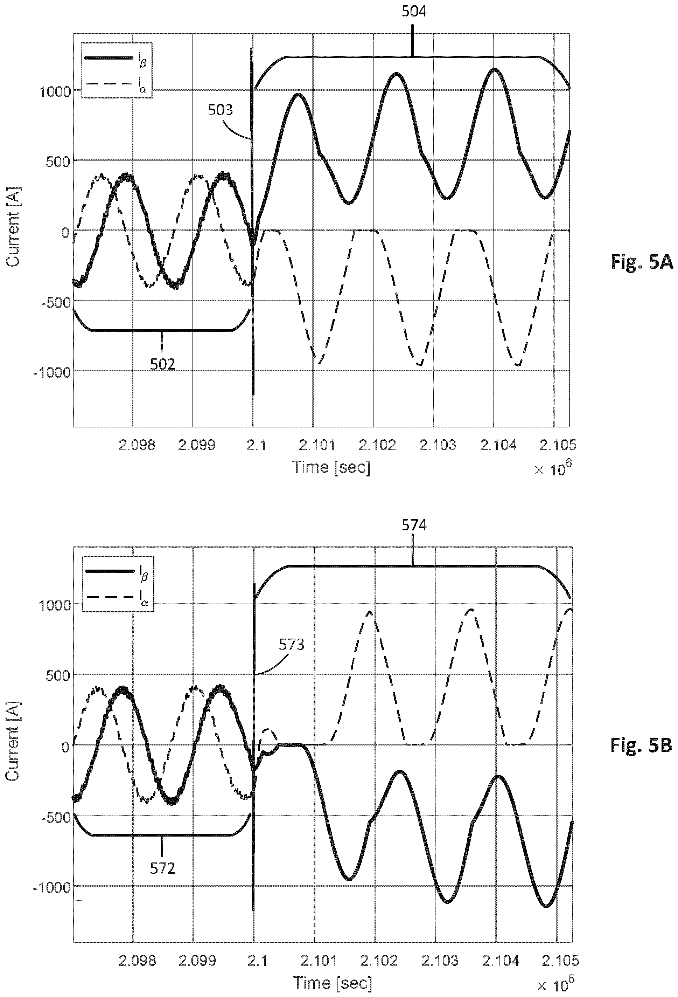

FIGs. 5A and 5B each illustrate a plot over time, before and after a short circuit fault in the respective upper and lower second phase (phase V) power switches, of both the alpha current (Iα) and the beta current (Iβ) calculated using the AC output current from the multiphase (e.g., 3 phase) power switches in the alpha beta transformation.

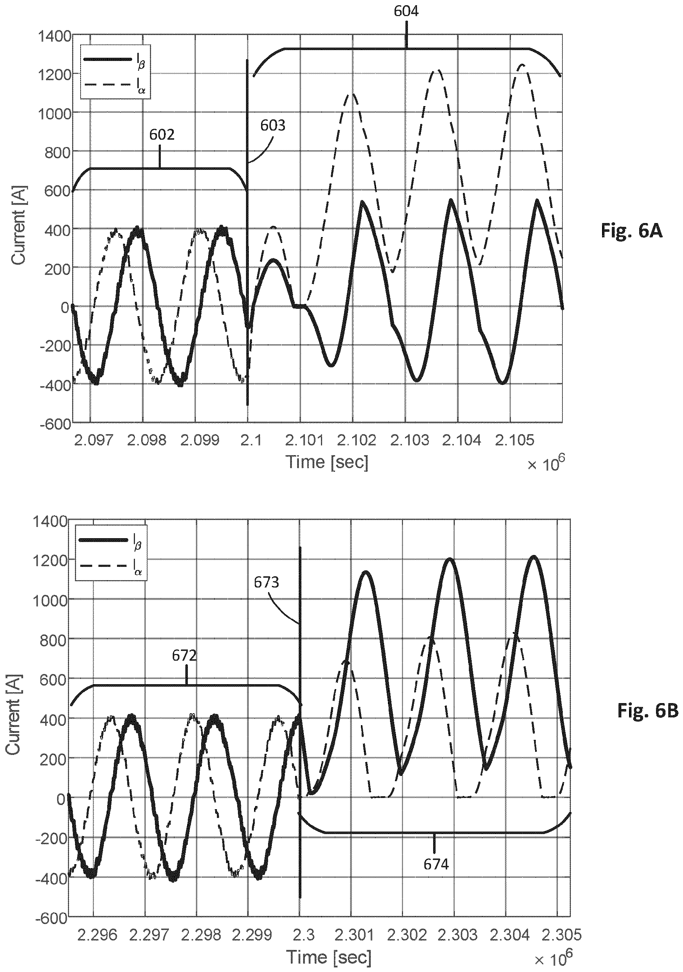

**FIGs. 6A** and **6B** each illustrate a plot over time, before and after a short circuit fault in the respective upper and lower third phase (phase W) power switches, of both the alpha current (Iα) and the beta current (Iβ) calculated using the AC output current from the multiphase (e.g., 3 phase) power switches in the alpha beta transformation.

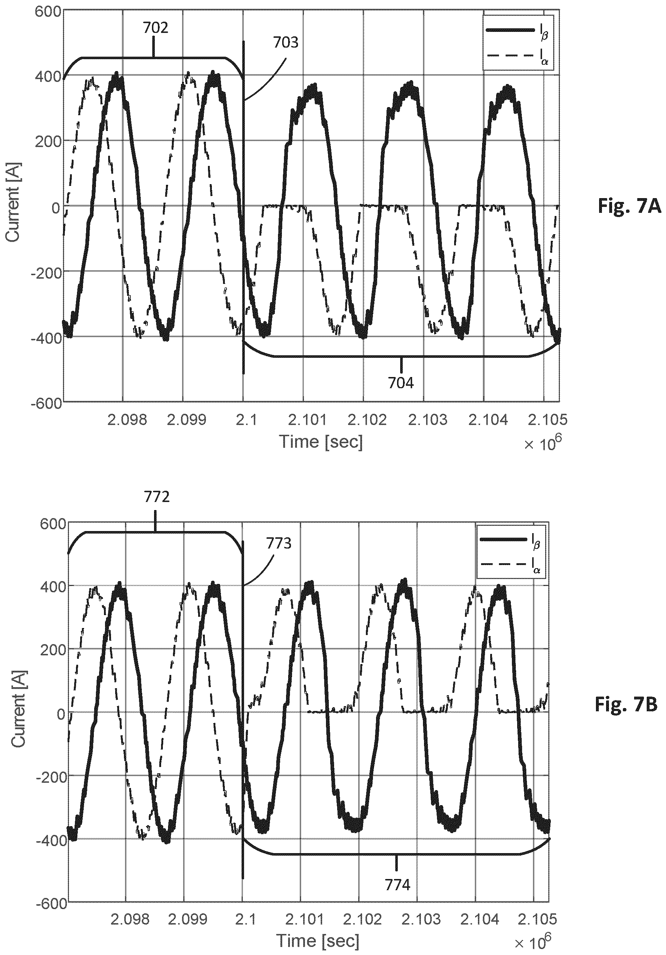

**FIGs. 7A** and **7B** each illustrate a plot over time, before and after an open circuit fault in the respective upper and lower first phase (phase U) power switches, of both the alpha current (Iα) and the beta current (Iβ) calculated using the AC output current of the multiphase (e.g., 3 phase) power switches in the alpha beta transformation.

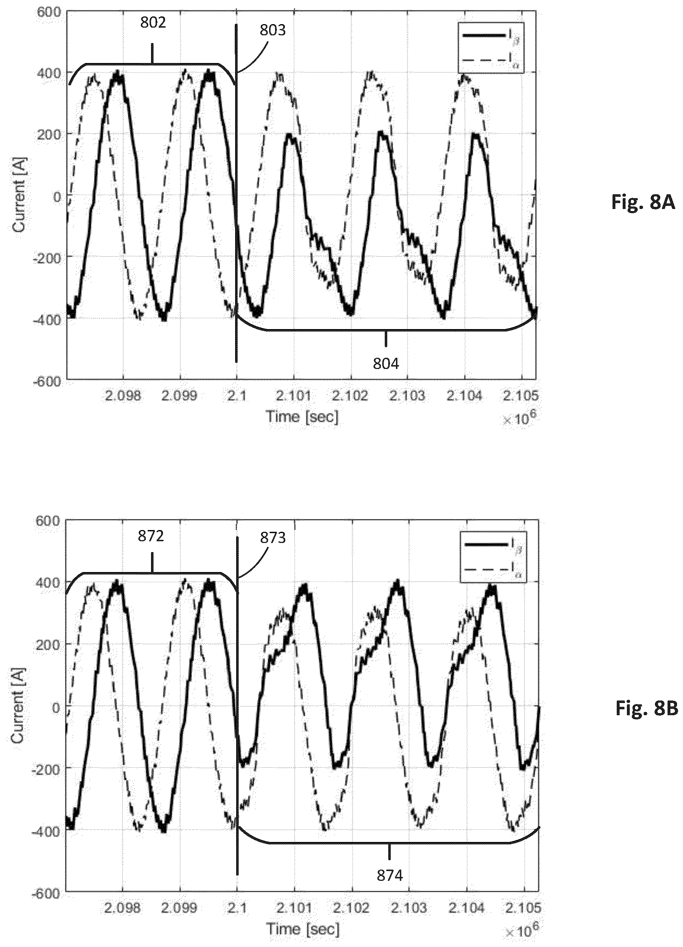

**FIGs. 8A** and **8B** each illustrate a plot over time, before and after an open circuit fault in the respective upper and lower second phase (phase V) power switches, of both the alpha current (Iα) and the beta current (Iβ) calculated using the AC output current of the multiphase (e.g., 3 phase) power switches in the alpha beta transformation.

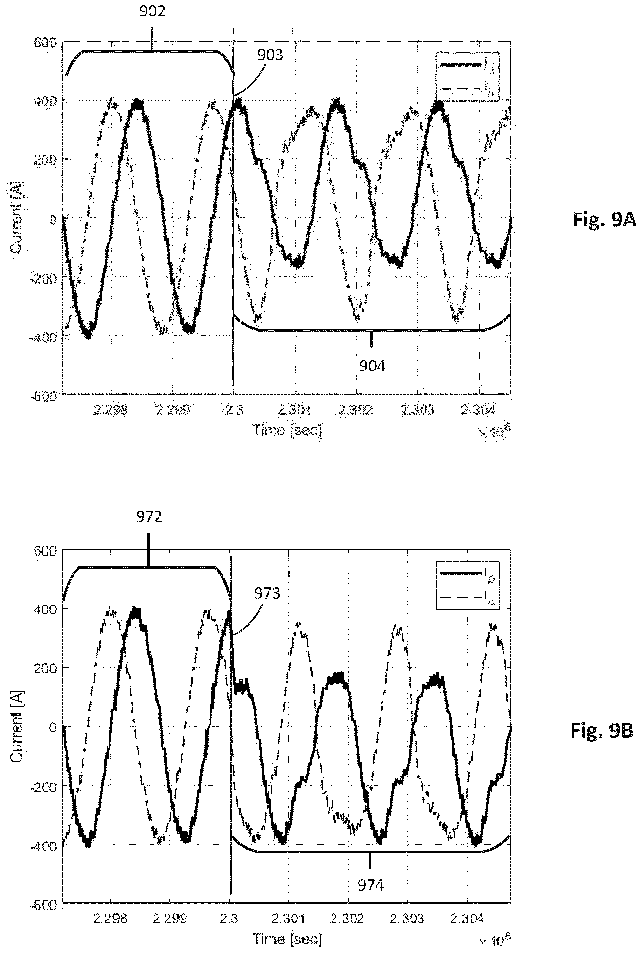

**FIGs. 9A** and **9B** each illustrate a plot over time, before and after an open circuit fault in the respective upper and lower third phase (phase W) power switches, of both the alpha current (Iα) and the beta current (Iβ) calculated using the AC output current of the multiphase (e.g., 3 phase) power switches in the alpha beta transformation.

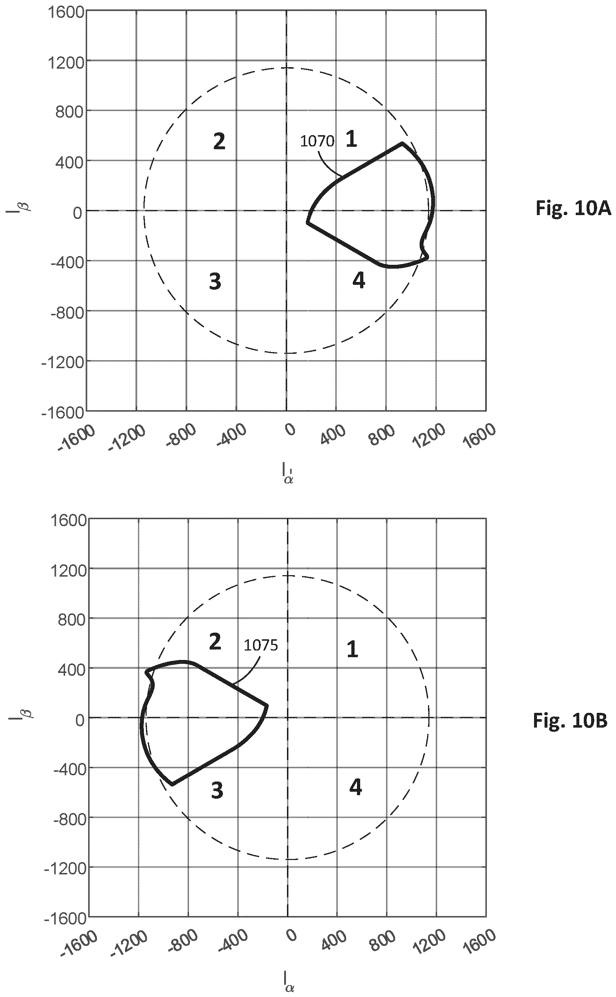

**FIGs. 10A** and **10B** each illustrate a plot in alpha-beta domain, in response to a short circuit fault in one of the respective upper and lower first phase (phase U) power switches, of the alpha current (Iα) vs. the beta current (Iβ) calculated using the AC output current of the multiphase (e.g., 3 phase) power switches in the alpha beta transform in a first (stationary/traditional) reference frame (1f) where θ equals 0 degrees (no rotation).

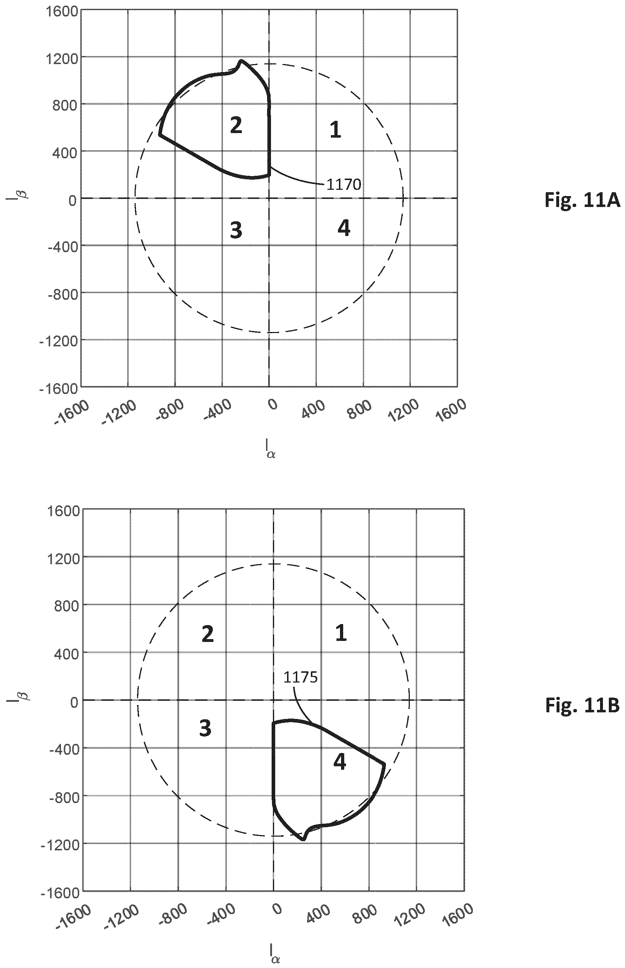

**FIGs. 11A** and **11B** each illustrate a plot in alpha-beta domain, in response to a short circuit fault in one of the respective upper and lower second phase (phase V) power switches, of the alpha current (Iα) vs. the beta current (Iβ) calculated using the AC output current of the multiphase (e.g., 3 phase) power switches in the alpha beta transform in the first (stationary/traditional) reference frame (1f) where θ equals 0 degrees (no rotation).

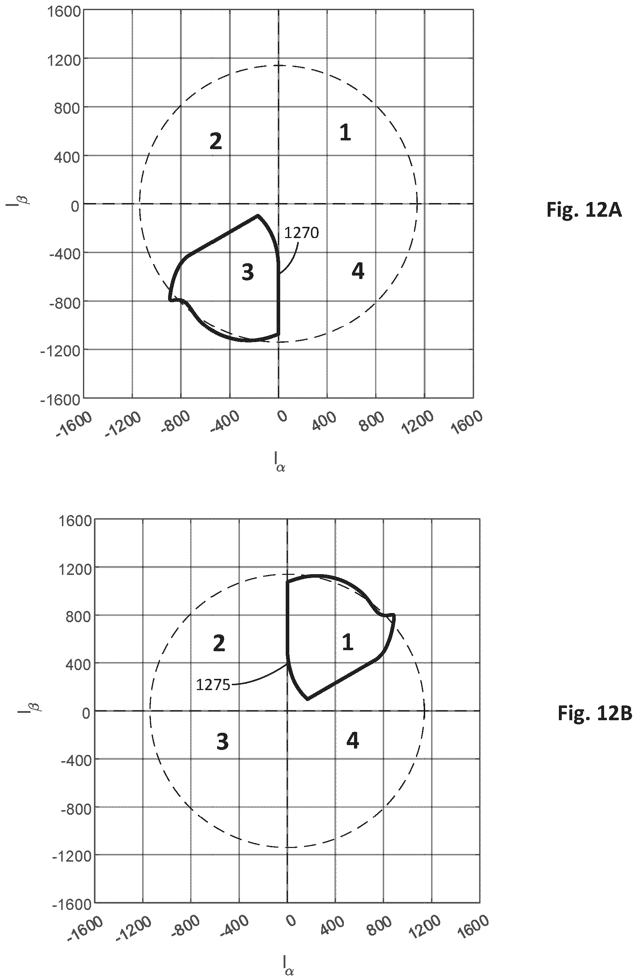

**FIGs. 12A** and **12B** each illustrate a plot in alpha-beta domain, in response to a short circuit in one of the respective upper and lower third phase (phase W) power switches, of the alpha current (Iα) vs. the beta current (Iβ) calculated using the AC output current of the multiphase (e.g., 3 phase) power switches the alpha beta transformation in the first (stationary/traditional) reference frame (1f) where θ equals 0 degrees (no rotation).

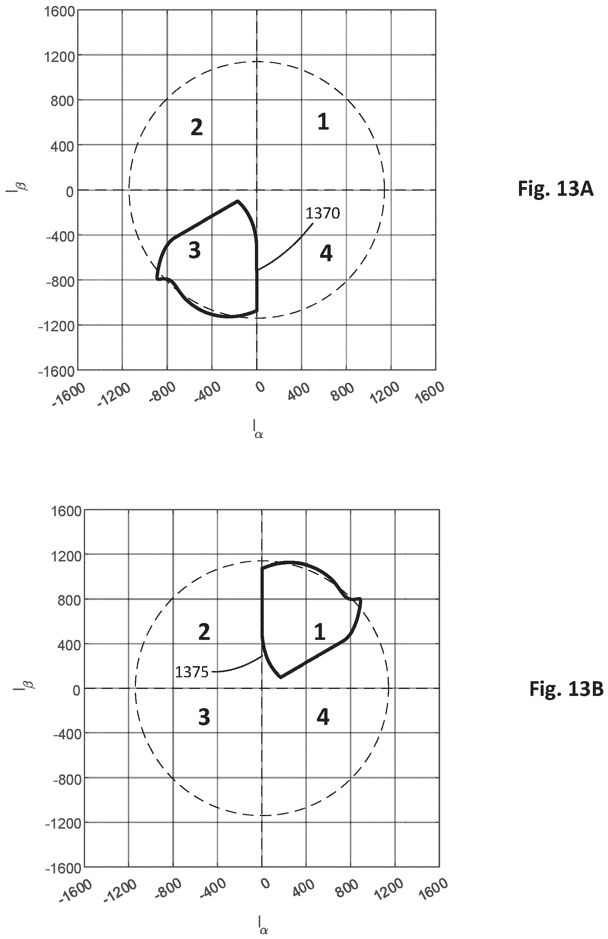

**FIGs. 13A** and **13B** each illustrate a plot in alpha-beta domain, in response to a short circuit in one of the respective upper and lower first phase (phase U) power switches, of the alpha current (Iα) vs. the beta current (Iβ) calculated using the AC output current of the multiphase (e.g., 3 phase) power switches in the alpha-beta transformation in a second reference frame (2f) where θ equals 120 degrees (the second reference frame (2f) is rotated 120 degrees from the first stationary reference frame 1(f)).

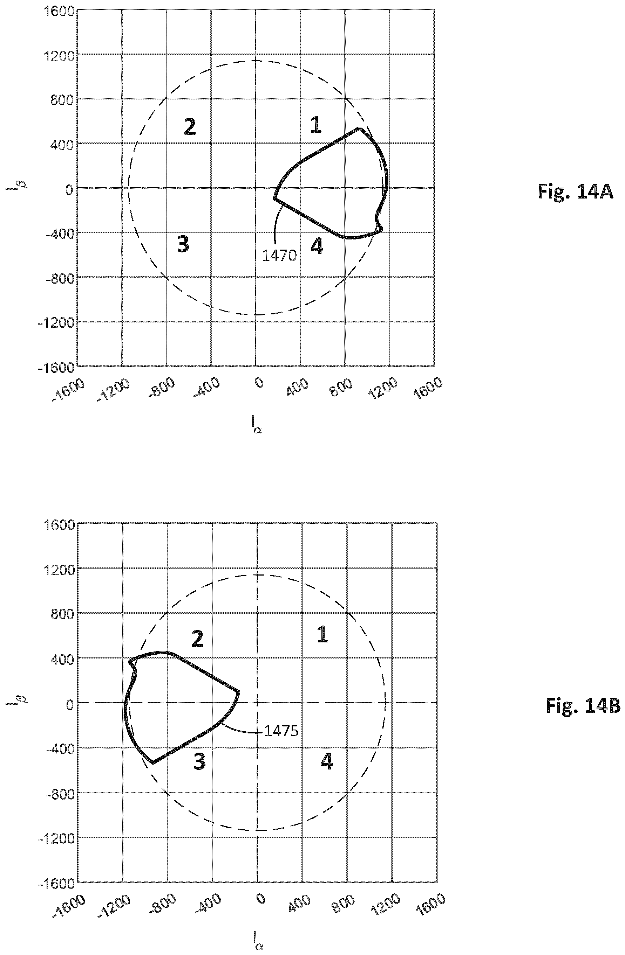

**FIGs. 14A** and **14B** each illustrate a plot in alpha-beta domain, in response to a short circuit in one of the respective upper and lower second phase (phase V) power switches, of the alpha current (Iα) vs. the beta current (Iβ) calculated using the AC output current of the multiphase (e.g., 3 phase) power switches in the alpha-beta transformation in a second reference frame (2f) where θ equals 120 degrees (the second reference frame (2f) is rotated 120 degrees from the first stationary reference frame 1(f)).

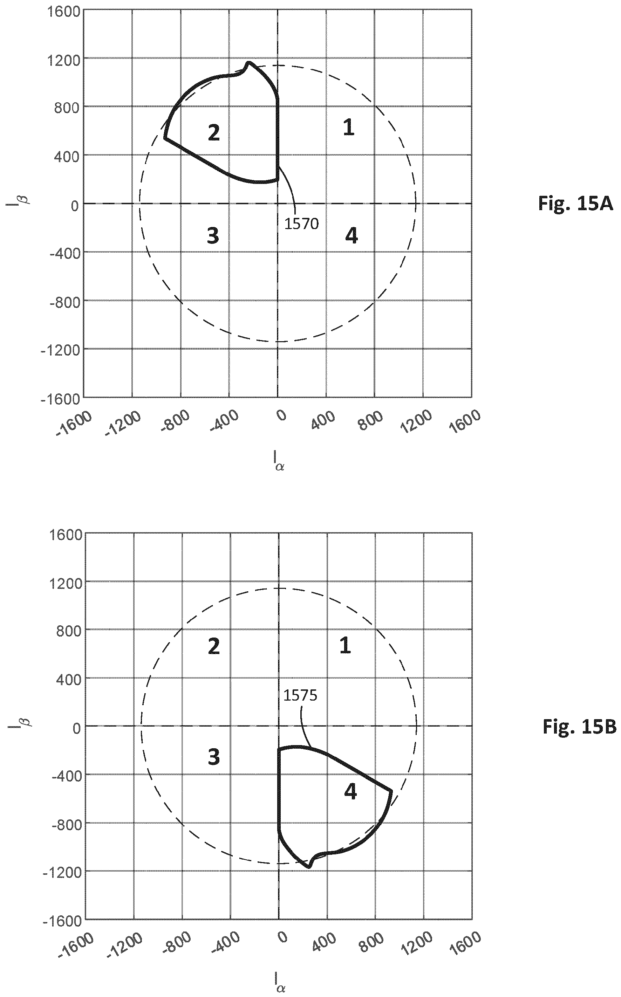

**FIGs. 15A** and **15B** each illustrate a plot in alpha-beta domain, in response to a short circuit in one of the respective upper and lower third phase (phase W) power switches, of the alpha current (Iα) vs. the beta current (Iβ) calculated using the AC output current of the multiphase (e.g., 3 phase) power switches in the alpha-beta transformation in a second reference frame (2f) where θ equals 120 degrees (the second reference frame (2f) is rotated 120 degrees from the first stationary reference frame 1(f)).

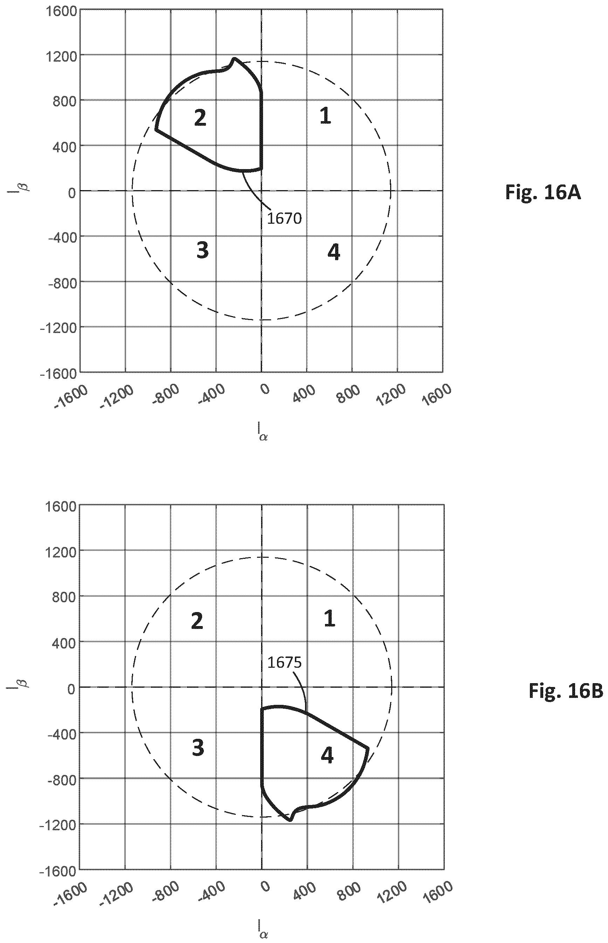

**FIGs. 16A** and **16B** each illustrate a plot in alpha-beta domain, in response to a short circuit in one of the respective upper and lower first phase (phase U) power switches, of the alpha current (Iα) vs. the beta current (Iβ) calculated using the AC output current of the multiphase (e.g., 3 phase) power switches in the alpha-beta transformation in a third reference frame (3f) where θ equals 240 degrees (the second reference frame (3f) is rotated 240 degrees from the first stationary reference frame 1(f)).

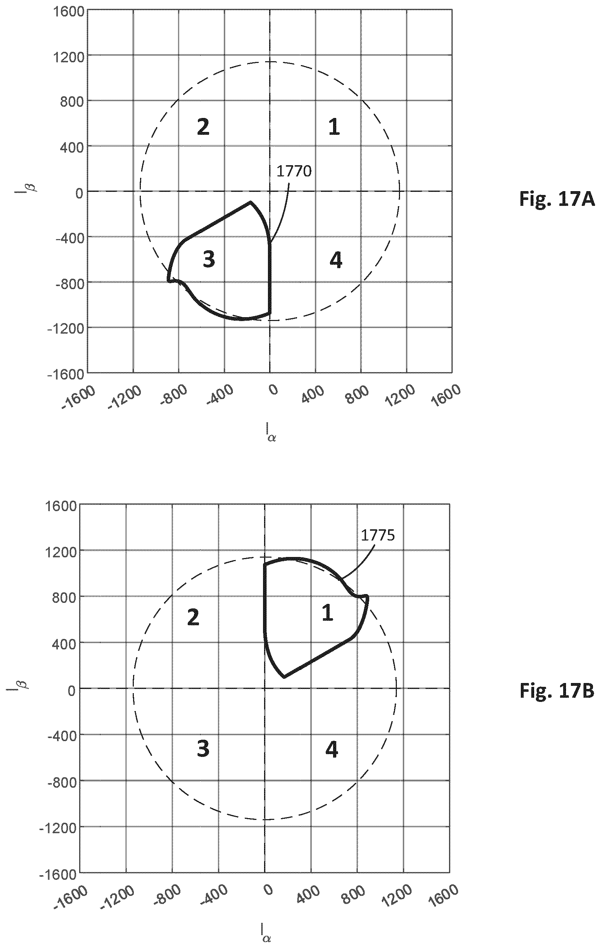

**FIGs. 17A** and **17B** each illustrate a plot in alpha-beta domain, in response to a short circuit in one of the respective upper and lower second phase (phase V) power switches, of the alpha current (I$\alpha$) vs. the beta current (I$\beta$) calculated using the AC output current of the multiphase (e.g., 3 phase) power switches in the alpha-beta transformation in a third reference frame (3f) where $\theta$ equals 240 degrees (the second reference frame (3f) is rotated 240 degrees from the first stationary reference frame 1(f)).

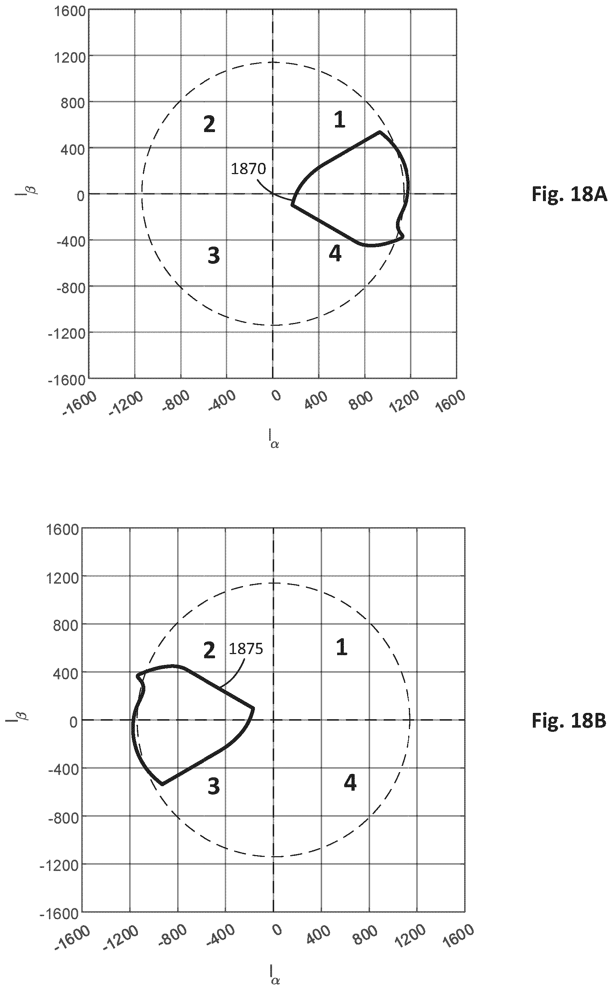

**FIGs. 18A** and **18B** each illustrate a plot in alpha-beta domain, in response to a short circuit in one of the respective upper and lower third phase (phase W) power switches, of the alpha current (I$\alpha$) vs. the beta current (I$\beta$) calculated using the AC output current of the multiphase (e.g., 3 phase) power switches in the alpha-beta transformation in a third reference frame (3f) where $\theta$ equals 240 degrees (the second reference frame (3f) is rotated 240 degrees from the first stationary reference frame 1(f)).

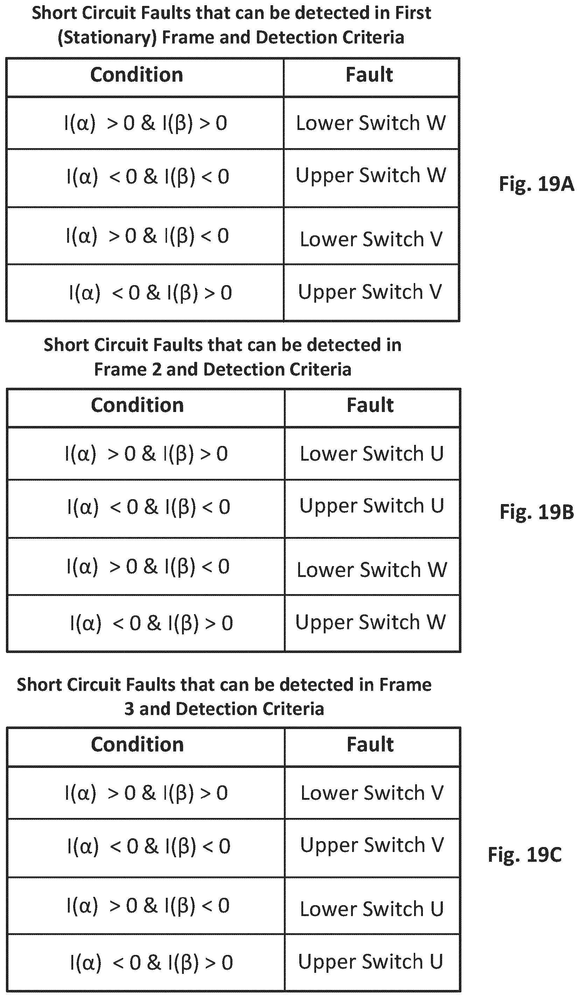

**FIG. 19A** is a table showing the short circuit fault criteria for respective power switches in the first (stationary) reference frame ($\theta$ = 0 degrees). **FIG. 19B** is a table showing the short circuit fault criteria for respective power switches in the second reference frame ($\theta$ = 120 degrees). **FIG. 19C** is a table showing the short circuit fault criteria for respective power switches in the third reference frame ($\theta$ = 240 degrees).

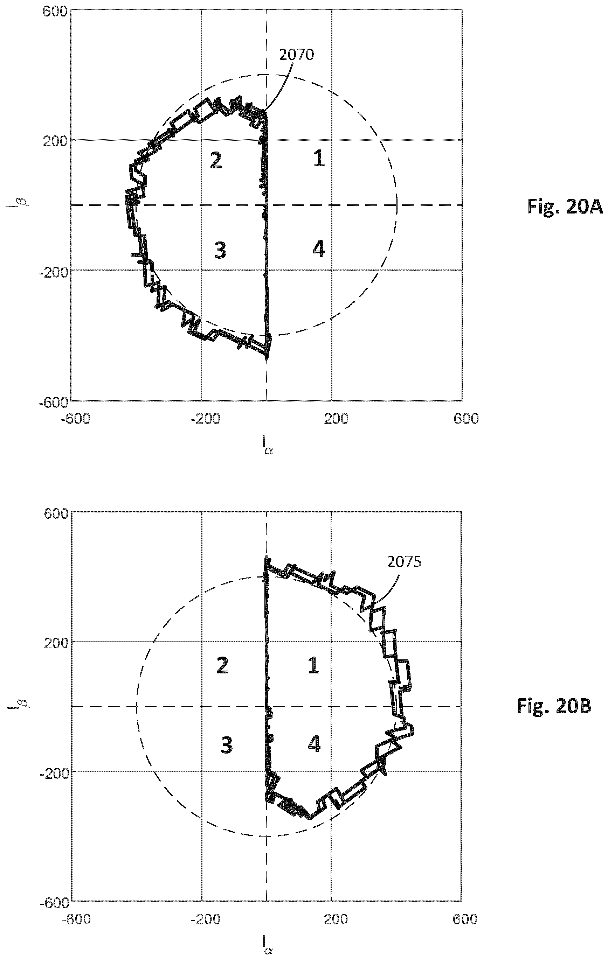

**FIGs. 20A** and **20B** each illustrate a plot in alpha-beta domain, in response to an open circuit fault in one of the respective upper and lower first phase (phase U) power switches, of the alpha current (I$\alpha$) vs. the beta current (I$\beta$) calculated using the AC output current of the multiphase (e.g., 3 phase) power switches in the alpha beta transform in a first (stationary/traditional) reference frame (1f) where $\theta$ equals 0 degrees (no rotation).

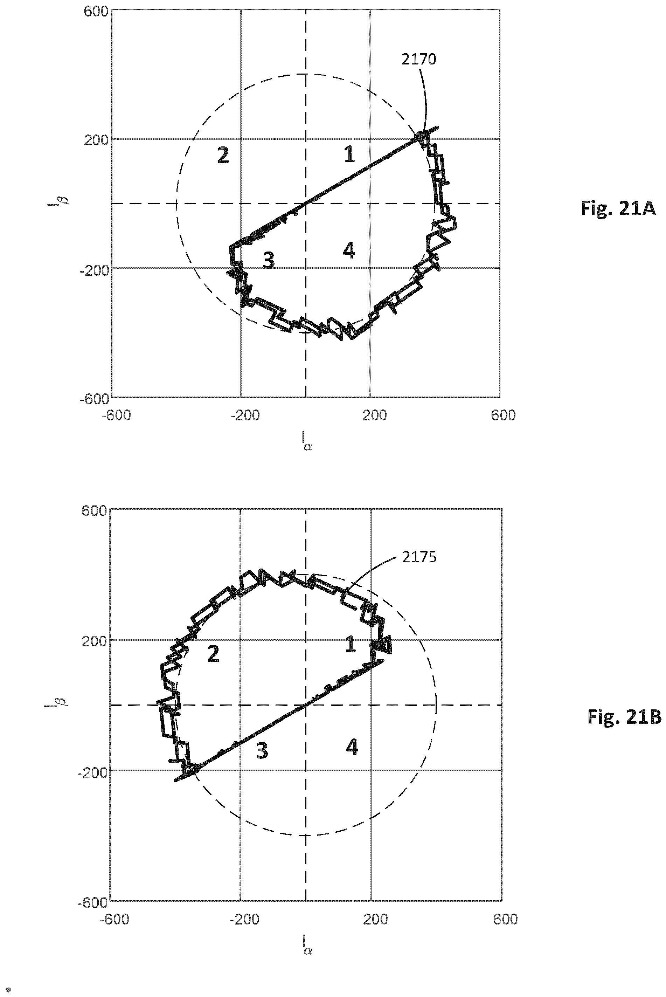

**FIGs. 21A** and **21B** each illustrate plot in alpha-beta domain, in response to an open circuit fault in one of the respective upper and lower second phase (phase V) power switches, of the alpha current (I$\alpha$) vs. the beta current (I$\beta$) calculated using the AC output current of the multiphase (e.g., 3 phase) power switches in the alpha beta transform in the first (stationary/traditional) reference frame (1f) where $\theta$ equals 0 degrees (no rotation).

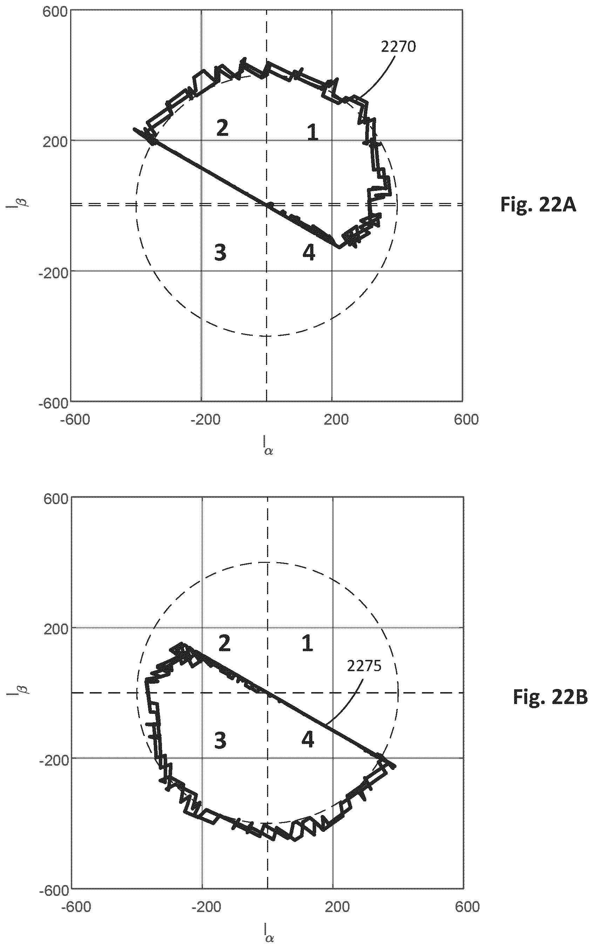

**FIGs. 22A** and **22B** each illustrate a plot in alpha-beta domain, in response to an open circuit in one of the respective upper and lower third phase (phase W) power switches, of the alpha current (I$\alpha$) vs. the beta current (I$\beta$) calculated using the AC output current of the multiphase (e.g., 3 phase) power switches in the alpha beta transformation in the first (stationary/traditional) reference frame (1f) where $\theta$ equals 0 degrees (no rotation).

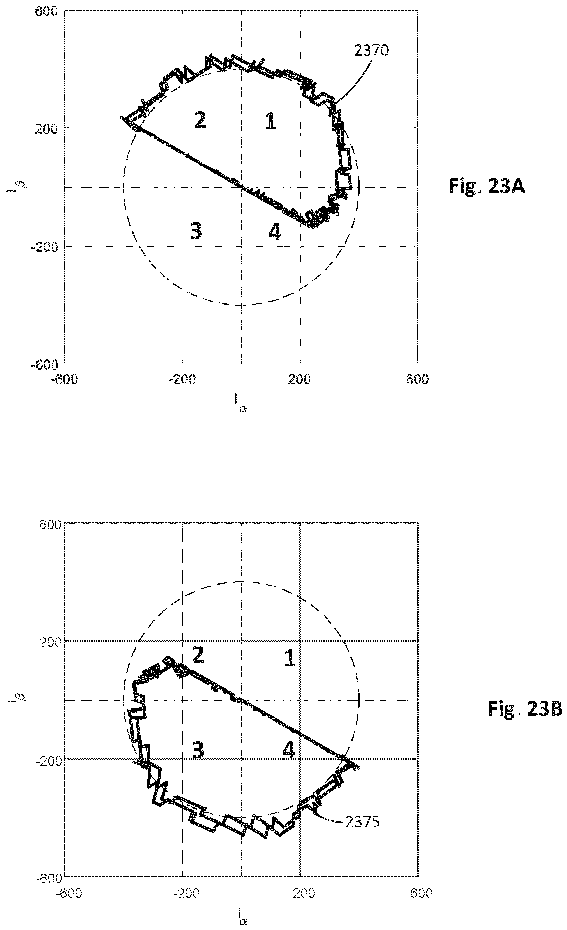

**FIGs. 23A** and **23B** each illustrate a plot in alpha-beta domain, in response to an open circuit in one of the respective upper and lower first phase (phase U) power switches, of the alpha current (I$\alpha$) vs. the beta current (I$\beta$) calculated using the AC output current of the multiphase (e.g., 3 phase) power switches in the alpha-beta transformation in a second reference frame (2f) where $\theta$ equals 120 degrees (the second reference frame (2f) is rotated 120 degrees from the first stationary reference frame 1(f)).

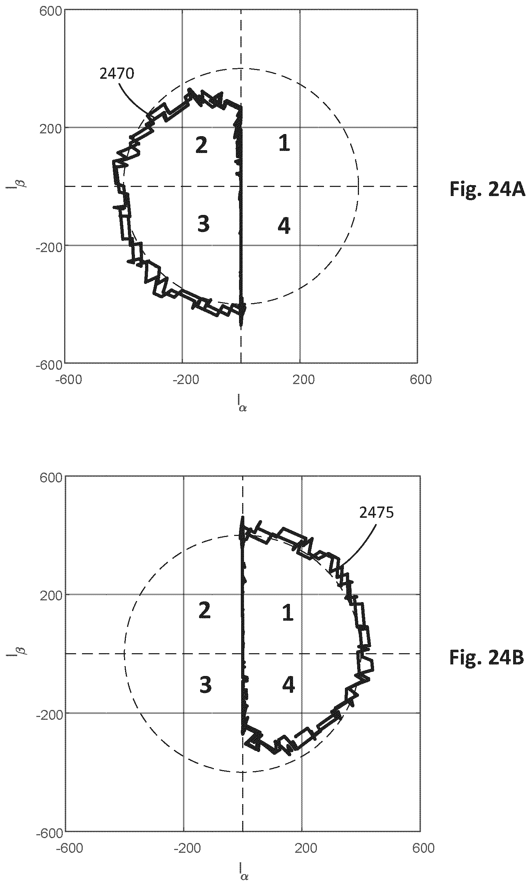

**FIGs. 24A** and **24B** each illustrate a plot in alpha-beta domain, in response to an open circuit in one of the respective upper and lower second phase (phase V) power switches, of the alpha current (I$\alpha$) vs. the beta current (I$\beta$) calculated using the AC output current of the multiphase (e.g., 3 phase) power switches in the alpha-beta transformation in a second reference frame (2f) where $\theta$ equals 120 degrees (the second reference frame (2f) is rotated 120 degrees from the first stationary reference frame 1(f)).

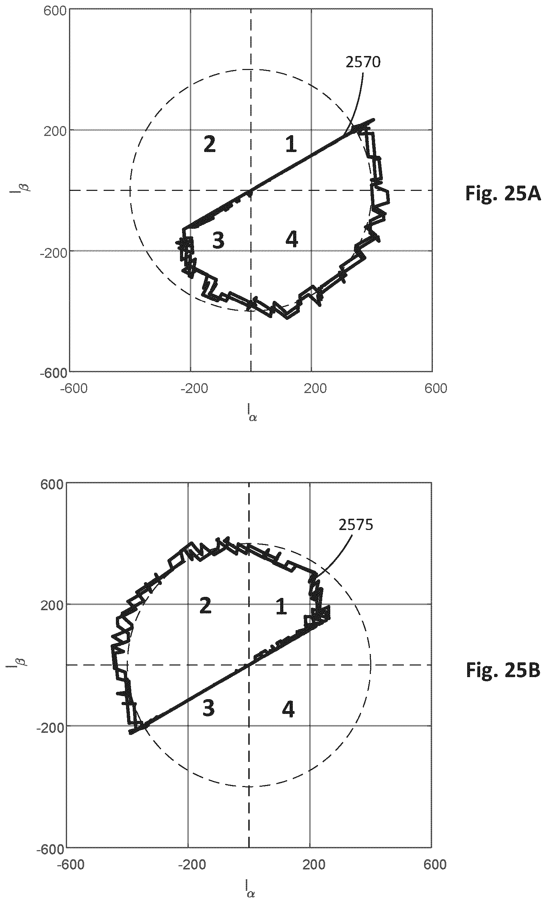

**FIGs. 25A** and **25B** each illustrate a plot in alpha-beta domain, in response to an open circuit in one of the respective upper and lower third phase (phase W) power switches, of the alpha current (I$\alpha$) vs. the beta current (I$\beta$) calculated using the AC output current of the multiphase (e.g., 3 phase) power switches in the alpha-beta transformation in a second reference frame (2f) where $\theta$ equals 120 degrees (the second reference frame (2f) is rotated 120 degrees from the first stationary reference frame 1(f)).

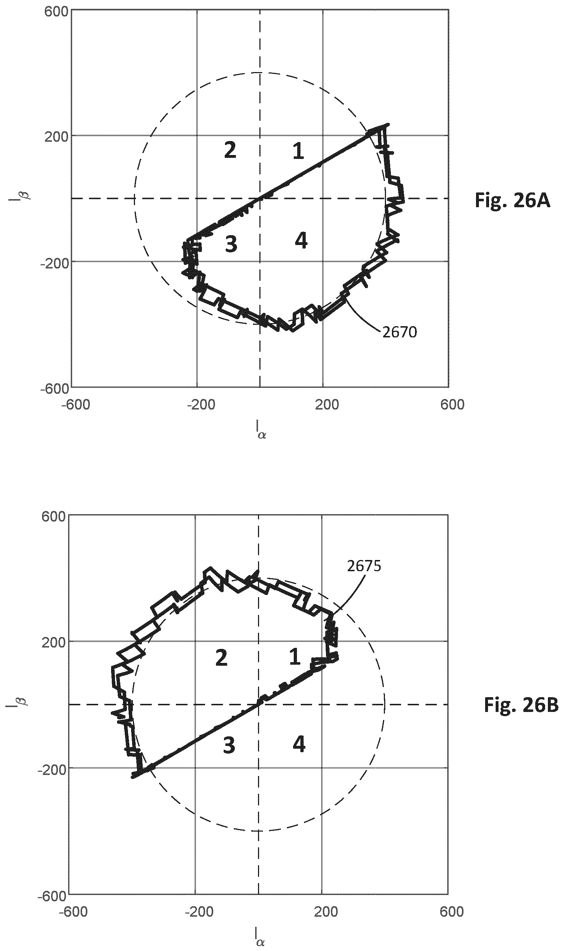

**FIGs. 26A** and **26B** each illustrate a plot in alpha-beta domain, in response to an open circuit in one of the respective upper and lower first phase (phase U) power switches, of the alpha current (I$\alpha$) vs. the beta current (I$\beta$) calculated using the AC output current of the multiphase (e.g., 3 phase) power switches in the alpha-beta transformation in a third reference frame (3f) where $\theta$ equals 240 degrees (the second reference frame (3f) is rotated 240 degrees from the first stationary reference frame 1(f)).

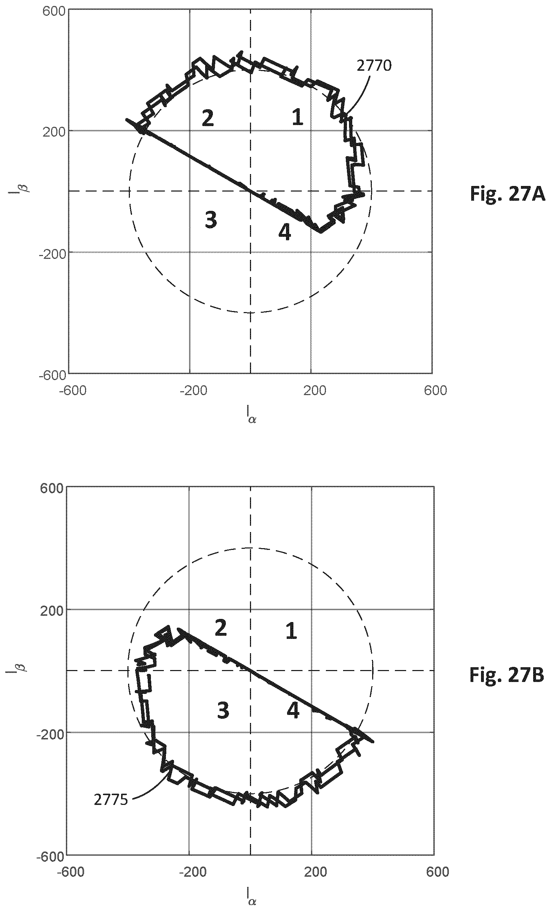

**FIGs. 27A** and **27B** each illustrate a plot in alpha-beta domain, in response to an open circuit in one of the respective upper and lower second phase (phase V) power switches, of the alpha current (I$\alpha$) vs. the beta current (I$\beta$) calculated

using the AC output current of the multiphase (e.g., 3 phase) power switches in the alpha-beta transformation in a third reference frame (3f) where θ equals 240 degrees (the second reference frame (3f) is rotated 240 degrees from the first stationary reference frame 1(f)).

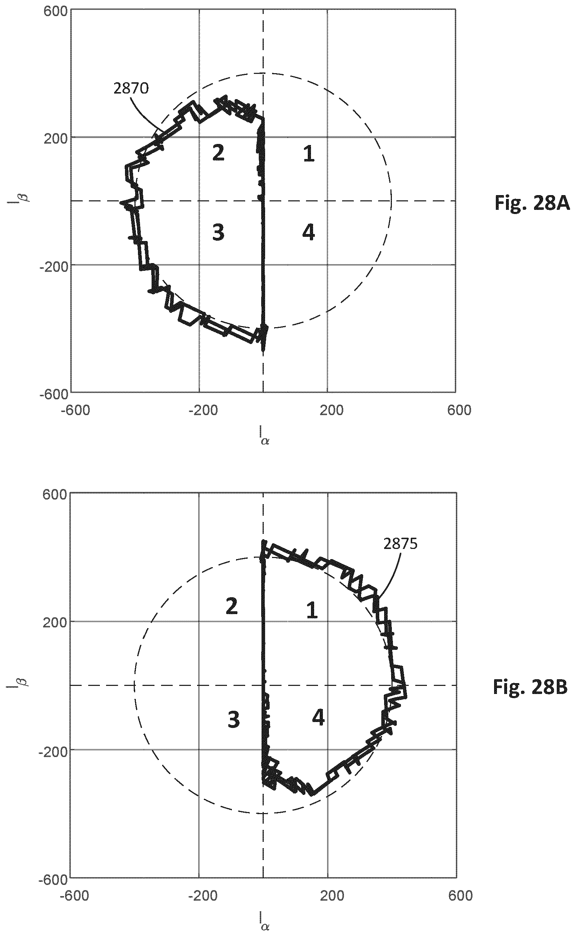

**FIGs. 28A** and **28B** illustrate a plot in alpha-beta domain, in response to an open circuit in one of the respective upper and lower third phase (phase W) power switches, of the alpha current ($I\alpha$) vs. the beta current ($I\beta$) calculated using the AC output current of the multiphase (e.g., 3 phase) power switches in the alpha-beta transformation in a third reference frame (3f) where θ equals 240 degrees (the second reference frame (3f) is rotated 240 degrees from the first stationary reference frame 1(f)).

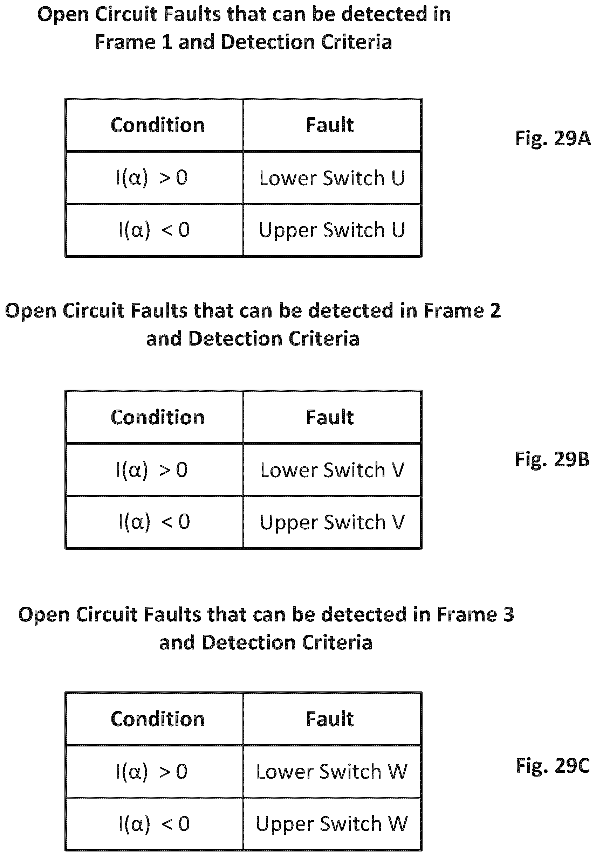

**FIG. 29A** is a table showing the open circuit fault criteria for respective upper and lower first phase (phase U) power switches in the first (stationary) reference frame (θ = 0 degrees). **FIG. 29B** is a table showing the open circuit fault criteria for respective upper and lower second phase (phase V) power switches in the second reference frame (θ = 120 degrees). **FIG. 29C** is a table showing the open circuit fault criteria for respective upper and lower third phase (phase W) power switches in the third reference frame (θ = 240 degrees).

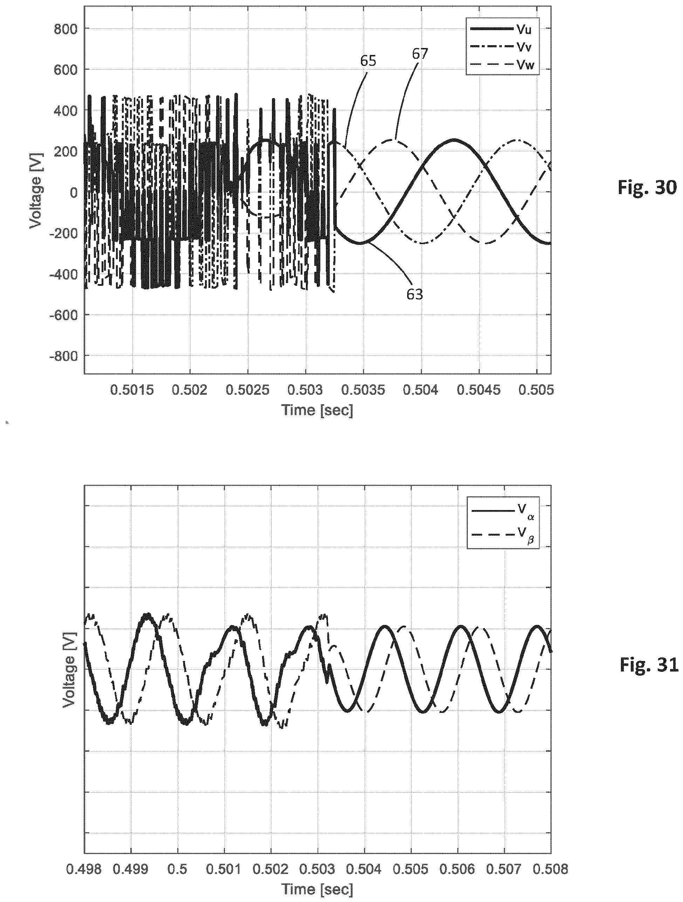

**FIG. 30** illustrates the voltage output of a multiphase (3 phase) inverter/converter circuit over time for when Pulse Width Modulation (PWM) is enabled and then disabled.

**FIG. 31** illustrates the alpha voltage ($V\alpha$) and the beta voltage ($V\beta$) over time calculated using the voltage output of the multiphase (3 phase) inverter/converter circuit of **FIG. 30** in the alpha beta transformation in the first (traditional/stationary) time frame.

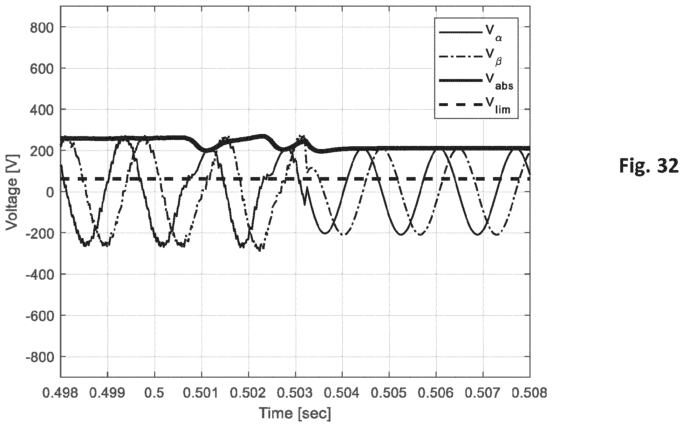

**FIG. 32** illustrates the alpha voltage ($V\alpha$), the beta voltage ($V\beta$), the absolute voltage (Vabs), and the voltage output limit (Vlim) of the inverter/converter circuitry plotted over time.

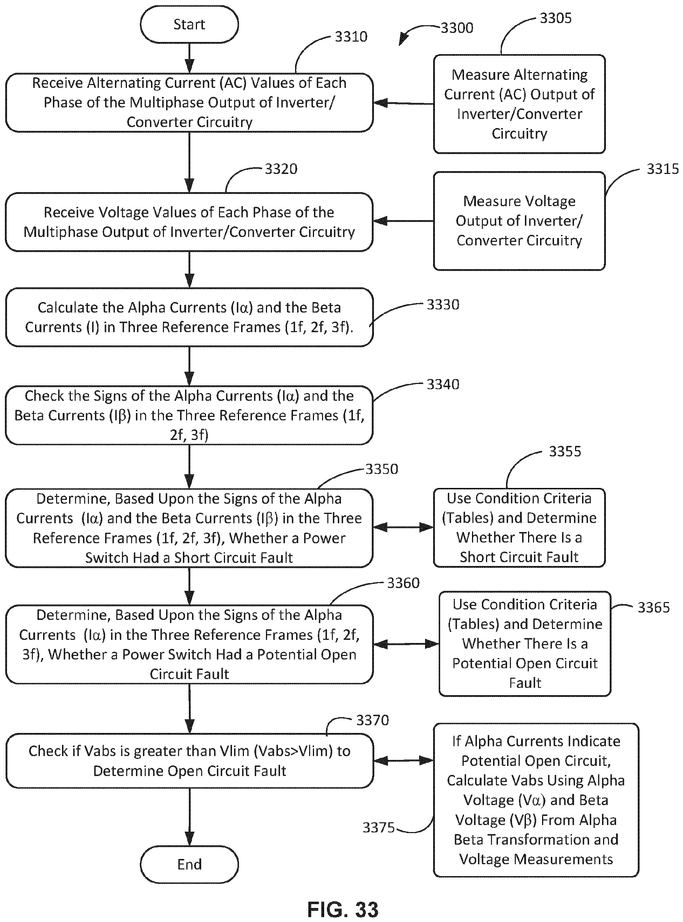

**FIG. 33** illustrates a flow chart of an example method of detecting different types of power switch failures in an inverter/converter circuit that uses multiple power switches and, in an approach, identifies the specific power switch that failed.

DETAILED DESCRIPTION

The following description is made for illustrating the general principles of the invention and is not meant to limit the inventive concepts claimed herein. In the following detailed description, numerous details are set forth in order to provide an understanding of methods, techniques, systems, and computer program products of detecting power switch (e.g., power transistor switch) failures or faults, including open circuit and short circuit faults, including in one or more embodiments detecting the type of fault and/or identifying the specific power switch that fails, however, it will be understood by those skilled in the art that different and numerous embodiments of the device, their methods of operation, and systems and methods to detect power switch failures may be practiced without those specific details. The claims and invention should not be limited to the arrangements, structures, embodiments, configurations, assemblies, subassemblies, mechanisms, features, functions, circuitry, processes, methods, techniques, aspects, or details specifically described and shown herein. Further, particular arrangements, structures, embodiments, configurations, assemblies, subassemblies, mechanisms, features, functions, circuitry, processes, methods, techniques, aspects, and details described herein can be used in combination with other described arrangements, structures, embodiments, configurations, assemblies, subassemblies, mechanisms, features, functions, circuitry, processes, methods, techniques, aspects, and details in each of the various possible combinations and permutations.

Unless otherwise specifically defined herein, all terms are to be given their broadest possible interpretation including meanings implied from the specification as well as meanings understood by those skilled in the art and/or as defined in dictionaries, treatises, etc. It should also be noted that, as used in the specification and the appended claims, the singular forms "a," "an" and "the" include plural referents unless otherwise specified. In addition, the terms "comprises" or "comprising" does not exclude the presence of other elements, features, or steps. Furthermore, although individually listed, a plurality of means, elements, or method steps may be implemented by, e.g., a single unit, element, or piece. Further, although individual features may be included in different embodiments, these features may advantageously be combined, and their inclusion individually in different embodiments does not imply that a combination of features is not feasible and/or advantageous.

Electrical power converters and/or motor controllers are often used in converting and/or monitoring electrical and thermal behavior of power delivered, for example, to electric motors that are used in a wide variety of applications. Electrical power converters and/or motor controllers in one or more embodiments convert direct current (DC) power to alternating current (AC) power and supply the AC power to the electric motor typically to rotate a shaft and produce mechanical power. In many cases power supplies and/or motor controllers convert DC power, including high voltage DC (HVDC) power, to AC power, including high voltage AC (HVAC) power, and supply the AC power, including the HVAC power, to one or more electric motors or electric motor modules. In addition to other electronic circuitry, for example, gate driver circuitry and/or control circuitry, power converters and/or motor controllers often include an inverter power stage which is circuitry that receives the DC power, e.g., HVDC power, and converts the DC power to the AC power, e.g., HVAC power.

In one or more embodiments the power inverter section of the power supply and/or motor controller includes one or more power switches, more specifically one or more power transistor switches. The power switches can include Insulated Gate Bipolar Transistors (IGBTs), Field Effect Transistors (FETs), Junction Field Effect Transistors (JFETs), and Metal-Oxide Semiconductor Field Effect Transistors (MOSFETs). It is contemplated that the present disclosure would have application to other power switches used in inverter circuitry to convert DC power into AC power. Generally, two power switches, referred to as paired power switches, are used to produce a cycle of AC power where each power switch produces half of the cycle and together they produce a full AC cycle. In one or more embodiments the two power switches working together to produce a full cycle of AC power are incorporated into a single module, also referred to as a power module.

FIG. **1** illustrates power inverter section **10** of a power supply and/or electric motor controller **5.** The power inverter section **10** includes one or more power switches **15,** and in the embodiment of **FIG. 1** six power switches **20, 25, 30, 35, 40, 45.** The power inverter section **10** receives DC input power and produces AC output power to power, for example, one or more electric motors (not shown). In the embodiment of **FIG. 1,** inverter section **10** receives DC input power, preferably HVDC input power, and converts the DC power input to AC output power, preferably multiphase AC output power, more specifically three-phase AC output power. In one or more embodiments, the inverter section **10** of **FIG. 1** produces and/or generates multiphase HVAC output power, preferably three-phase HVAC power output from the supplied HVDC. The HVDC supplied to the inverter section **10** in one or more approaches is greater than 200V, more preferably greater than 320V DC, although even higher DC voltage inputs, for example up to 1.2 kV are contemplated. In one or more embodiments, the DC input voltage can be between 200 and 1.2 kV, more preferably between 400 and 800 volts DC. The inverter section **10** in one or more arrangements outputs greater than 200 VAC, more preferably greater than 320 VAC, although higher AC voltage outputs are contemplated, for example up to 1.2 kV of alternating current (AC). In one of more embodiments, the inverter section **10** outputs between 200 VAC and 1.2 kVAC, more preferably between 200 VAC and 800 VAC.

In the inverter section **10** of **FIG. 1** the power switches **15** are paired to form a phase of AC output power, where in **FIG. 1** two power switches **20, 25,** referred to as upper switch **20** and lower switch **25,** are paired to produce a first phase (e.g., phase U) of AC output power; the two power switches **30, 35,** referred to as upper switch **30** and lower switch **35,** are paired to produce a second phase (e.g., phase V) of AC output power; and the two power switches **40, 45,** referred to as upper switch **40** and lower switch **45,** are paired to produce a third phase (e.g., phase W) of AC output power. Preferably the second phase (phase V) is shifted 120 degrees from the first phase (phase U), and the third phase (phase W) is shifted 240 degrees from the first phase (phase U) and is shifted 120 degrees from the second phase (phase V). The two paired power switches producing each phase of AC power can be packaged together in a module. Each of the power switches are triggered by gate signals **16.** In response to the gate signals **16** the power switches **15** operate between open and closed conditions. The gate signals **16** are typically provided by a gate driver circuit not shown.

While the inverter section **10** of **FIG. 1** is described as having three phase multiphase AC output power where the second phase (phase V) of AC output power is shifted 120 degrees from the first phase (phase U) of AC output power and the third phase (phase W) of AC output power is shifted 240 degrees from the first phase (phase U) of AC power output (i.e., each phase is shifted 120 degrees from the other two phases) it is contemplated that more or less phases of AC power output can be produced using more or less power switches and the different phases of AC power output can be phase shifted by different amounts. For example, twelve power switches could be used in an inverter/converter section to produce three phases of AC output power or to produce six phases of AC output power, for example, where each phase can be shifted 60 degrees from the adjacent phase of AC output power.

As explained above, power converters and/or motor controllers can be used in a wide variety of applications. One application for such power converters and/or motor controllers having a power inverter section **10** configured as **FIG. 1** is to power electric motors. These power converters, motor controllers, and electric motors can be used for example in electric vehicles including electric vehicles in the aerospace industry. For example, such power converters and/or motor controllers can be used to power electric motors for aircraft, including manned aircraft where redundancy and reliability is important. An example of such power converters and/or motor controllers having an inverter section (stage or circuitry) to which this disclosure would have application is described in United States Patent No. 11,711,003 which is incorporated herein by reference in its entirety. In can be appreciated that while **FIG. 1** has been used to illustrate an example power inverter section of circuitry that uses multiple power switches and reference has been made to United States Patent No. 11,711,003, the disclosure would have application to other inverter configurations and power switch configurations.

In one or more applications, it can be advantageous to detect power switch faults, including detecting and/or determining the type of power switch fault (e.g., open circuit and/or short circuit faults), and/or identifying the specific power switch that failed out of a collection of or multiple power switches and the type of power switch fault. In one or more embodiments, alpha-beta transformations are calculated and/or determined using the current and/or voltage output by the power switches, and the signals (whether they remain positive, remain negative, and/or are both positive and negative) of the alpha current ($I\alpha$) and/or the beta current ($I\beta$) are used to detect multiple categories of faults. In an approach, alpha-beta transformations are calculated and/or determined using the current output of each phase of the inverter/converter circuitry and the signs of the alpha current ($I\alpha$) and beta current ($I\beta$) (whether the alpha current ($I\alpha$) and/or beta current ($I\beta$) remain positive or negative) are used to detect a power switch short circuit fault, and in a further approach to detect, determine and/or identify the particular power switch out of the multiple power switches that failed. In a further approach, alpha-beta transformations are calculated and/or determined using the current output of each phase of the inverter/converter circuitry and the sign of the alpha current ($I\alpha$) (whether the alpha current ($I\alpha$) remains positive or negative) is used to detect a potential power switch open circuit fault, and in a further approach to detect, determine and/or identify the particular power switch out of the multiple power switches that potentially failed.

In a further embodiment, an alpha-beta transformation using the voltage output of the inverter/converter circuitry is used to calculate and/or determine the alpha voltage ($V\alpha$) and the beta voltage ($V\beta$) which are used to determine and/or confirm an open circuit fault or failure in a power switch. In an embodiment, the absolute voltage (Vabs) is calculated using the alpha voltage ($V\alpha$) and the beta voltage ($V\beta$) and the absolute voltage Vabs is compared to the voltage limit (Vlim) (e.g., the maximum output of the inverter circuitry) of the power converter and/or motor controller to confirm the open circuit fault, where in an approach if Vabs is greater than Vlim and the alpha current ($I\alpha$), calculated using the current produced, generated, and/or output by the inverter/converter circuitry, remains positive or remains negative (e.g., does not switch between positive and negative), then the open circuit fault or failure is confirmed.

In a further embodiment, the alpha-beta transformations are calculated, using the current output of each phase of the inverter/converter circuitry that uses multiple power switches, in multiple reference frames where each reference frame is rotated with respect to the original/traditional alpha-beta reference frame. In one or more embodiments, the number of reference frames is determined by and/or equal to the number of phases of AC output power generated by the inverter/converter circuitry, and in an arrangement the rotation in degrees between adjacent reference frames is determined by the inverter/converter configuration and/or the motor configuration. For example, for an inverter/converter circuit generating three phases of multiphase AC output power, the number of reference frames is three and each reference frame is rotated 120 degrees (360/3).

In one or more embodiments, alpha-beta transformations in multiple reference frames rotated with respect to each other are calculated and/or determined using the current and/or voltage output of the power switches and the signals (whether they remain positive, remain negative, and/or are both (switch between) positive and negative) of the alpha currents ($I\alpha$) and/or the beta currents ($I\beta$) in each reference frame are used to detect multiple categories of faults. In an approach, alpha-beta transformations in multiple reference frames rotated with respect to each other are calculated and/or determined using the current output of each phase of the inverter/converter circuitry and the signs of the alpha current ($I\alpha$) and beta current ($I\beta$) (whether the alpha current ($I\alpha$) and/or beta current ($I\beta$) remain positive or negative) in each reference frame are used to detect a power switch short circuit fault, and in a further approach to detect, determine and/or identify the particular power switch out of the multiple power switches that failed. In yet a further approach, alpha-beta transformations in multiple reference frames rotated with respect to each other are calculated and/or determined using the current output of each phase of the inverter/converter circuitry and the signs of the alpha current ($I\alpha$) (whether the alpha current ($I\alpha$) remains positive or negative) in each reference frame are used to detect a potential power switch open circuit fault, and in a further approach to detect, determine and/or identify the particular power switch out of the multiple power switches that potentially failed. In a further approach, the signs of the beta currents (I) can be used to differentiate between a potential open circuit fault and a short circuit fault. In a further approach, the absolute voltage (Vabs) of the alpha voltage ($V\alpha$) and the beta voltage ($V\beta$) being greater than the voltage limit (Vlim) of the inverter/converter circuitry (max voltage of the inverter/-converter circuitry) can be used as described in this disclosure to confirm the open circuit fault or failure.

There are current sensors **52, 54, 56** for measuring the current output of each phase of AC output power generated by the power switches **15** in the inverter circuitry **10** of **FIG. 1**. That is, current sensor **52** measures the current of the first phase (phase U) **53** generated by paired power switches **20, 25** in line **22**, current sensor **54** measures the current of the second phase (phase V) **55** generated by paired power switches **30, 35** in line **32**, and current sensor **56** measures the current of the third phase (phase W) **57** generated by paired power switches **40, 45** in line **42**. In addition, the inverter section **10** preferably includes voltage sensors **62, 64, 66** to measure the voltage output power generated by the power switches **15**. That is, voltage sensor **62** measures the voltage of the first phase (phase U) of AC output power generated by paired power switches **20, 25** in line **22**, voltage sensor **64** measures the voltage of the second phase (phase V) of AC output power generated by paired power switches **30, 35** in line **32**, and voltage sensor **56** measures the voltage of the third phase (phase W) of AC output power generated by paired power switches **40, 45** in line **42**.

Current sensors **52, 54, 56** and voltage sensors **62, 64, 66** can be located anywhere within power supply and/or motor controller and downstream of the power switches **15,** and in one of more embodiments the current sensors and/or voltage sensors can be located outside the motor controller housing and/or circuitry. The current sensors and/or voltage sensors in an embodiment are placed upon or used in connection with a controller board within the power supply and/or motor controller housing. In one or more embodiments the current sensors and/or voltage sensors are associated with and/or communicate with microprocessor resources to make the calculations and perform the operations as discussed in this disclosure. It can be appreciated that if more or less phases of AC output power are generated by the inverter circuitry more or less current and/or voltage sensors can be used and that, if desired, optional redundant current measurements and/or voltage measurements can be taken using additional current and/or voltage sensors. The present disclosure discusses and explains the use of the current and voltage measurements of each line **22, 32, 42** to determine if there is a power switch fault, what type of fault (open circuit and/or short), and/or identify the specific power switch **15** that failed out of the multiple power switches **15.**

**FIG.** 2 illustrates the three phases of alternating current for respective first phase (phase U), second phase (phase V) and third phase (phase W) output by first paired power switches **20, 25,** second paired power switches **30, 35,** and third paired power switches **40, 45** as measured by respective current sensors **52, 54,** and **56.** The first portion **202** of **FIG. 2** on the left illustrates the current measurements **53, 55, 57** of the respective first, second, and third phases (e.g., phases U, V, W) of the first, second, and third paired power switches when the power switches **15** are all operating properly (e.g., there are no faults). The second portion **204** of **FIG. 2** on the right illustrates the current measurements **53, 55,** and **57** of current sensors **52, 54, 56** where there has been a short circuit fault in power switch **25.** In **FIG. 2** the short circuit of power switch **25** occurs at 2.1 seconds and is illustrated by demarcation line **206.**

In one or more embodiments an alpha-beta transformation ($\alpha\beta\gamma$) is employed using the current measurements for each multiphase (e.g., phases U, V, W) AC output. Alpha-beta transformation, sometimes referred to as Clarke transformation, is described for example in E. Clarke, Circuit Analysis of AC Power Systems, New York, Wiley, 1943, Vols. I, II, the entirety of which is incorporated by reference. That is, for each phase of the three phase AC output power, the respective current measurements **53, 55, 57** of respective first (U) phase, second (V) phase, and third (W) phase are used in an alpha-beta transformation. The alpha-beta transformation, also referred to as the Clarke transformation after Edith Clarke, is a mathematical transformation used to simplify analysis of three phase circuits. In this regard, the alpha-beta transformation of the three phase currents (first phase U, second phase V, and third phase W) is as follows:

$$I_\alpha = \frac{2}{3}I_u - \frac{1}{3}I_v - \frac{1}{3}I_w$$

$$I_\beta = \frac{1}{\sqrt{3}}I_v - \frac{1}{\sqrt{3}}I_w$$

where Iu is the current **53** of first phase U as measured by current sensor **52,** Iv is the current **55** of second phase V as measured by current sensor **54,** and Iw is the current **57** of third phase W as measured by current sensor **56.** In other words, the alpha current (I$\alpha$) is equal to 2/3 of the first phase U current (e.g., **53** current measurement) minus 1/3 the second phase V current (e.g., **55** current measurement) minus 1/3 the third phase W current (e.g., **57** current measurement) and the beta current (I$\beta$) is equal to (1 over (square root of 3 times the second phase V current (e.g., **55** current measurement)) minus (1 over (square root of 3 times the third phase W current (e.g., **57** current measurement)).

As part of the technique to detect the type of power switch fault (open circuit or short circuit) and identify the faulty power switch, after the alpha-beta transformations are calculated using the current measurements, the signs for the alpha current (I$\alpha$) and the beta current (I$\beta$) (whether the alpha current (I$\alpha$) and/or the beta current (I$\beta$) remains positive, remains negative, or switches between negative and positive) are used to determine the type of fault and/or identity the specific power switch that failed out of the multiple power switches. The rationale for using the signs of the alpha current (I$\alpha$) and the beta current (I$\beta$) is further explained below.

**FIG. 3** illustrates an alpha current-beta current plot **370** for a power switch **15** that is properly operating (e.g., there is no open circuit or short circuit). As can be seen in **FIG. 3** a properly operating power switch **15** has a circle for the alpha current v. beta current plot **370** where the plot intersects all four quadrants **1-4** of the circle shown in **FIG. 3.** That is, as the power output of properly functioning power modules (e.g., paired power switches producing a full cycle of AC output power) undergo a full cycle of AC output power the alpha current (I$\alpha$) and the beta current (I$\beta$) changes between both negative and positive, and does not stay or remain positive and does not stay or remain positive.

**FIGs. 4A - 6B** each illustrate a plot over time, before and after a short circuit fault in one of the power switches **15,** of both the alpha current (I$\alpha$) and beta current (I$\beta$) calculated using the alternating current (AC) output of the first, second, and third paired power switches **15** in the alpha beta transformation in the traditional or stationary reference frame as stated above.

FIGs. 4A and 4B each illustrate a plot over time, before and after a short circuit fault in the respective upper and lower first phase U power switches 20, 25, of both the alpha current (Iα) and beta current (Iβ) using the alternating current (AC) output of the first, second, and third paired power switches 15 in the alpha beta transformation. More specifically FIG. 4A illustrates a plot over time, before and after a short circuit fault in upper first phase U power switch 20, of both the alpha current (Iα) and beta current (Iβ) using the alternating current (AC) output of the first, second, and third paired power switches 15 in the alpha beta transformation. The first portion 402 of FIG. 4A on the left illustrates both the alpha current (Iα) and beta current (Iβ) using the current measurements 53, 55, 57 of the respective first, second, and third phases (e.g., phases U, V, W) of the first, second, and third paired power switches 15 in the alpha beta transformation when the power switches 15 are all operating properly (e.g., there are no faults). The second portion 404 of FIG. 4A on the right illustrates both the alpha current (Iα) and beta current (Iβ) using the current measurements 53, 55, and 57 of current sensors 52, 54, 56 in the alpha beta transformation where there has been a short circuit fault in upper first phase U power switch 20.

More specifically, FIG. 4B illustrates a plot over time, before and after a short circuit fault in lower first phase U power switch 25, of both the alpha current (Iα) and beta current (Iβ) using the alternating current (AC) output of the first, second, and third paired power switches 15 in the alpha beta transformation. The first portion 472 of FIG. 4B on the left illustrates both the alpha current (Iα) and beta current (Iβ) using the current measurements 53, 55, 57 of the respective first, second, and third phases (e.g., phases U, V, W) of the first, second, and third paired power switches 15 in the alpha beta transformation when the power switches 15 are all operating properly (e.g., there are no faults). The second portion 474 of FIG. 4B on the right illustrates both the alpha current (Iα) and beta current (Iβ) using the current measurements 53, 55, and 57 of current sensors 52, 54, 56 in the alpha beta transform where there has been a short circuit fault in lower first phase U power switch 25. In FIGs. 4A and 4B the short circuit of paired power switches 20, 25 occurs at 2.1 seconds and is illustrated by demarcation line 403, 473, respectively.

FIGs. 5A and 5B illustrate a plot over time, before and after a short circuit fault in the respective upper and lower second phase V power switch 30, 35, of both the alpha current (Iα) and the beta current (Iβ) using the alternating current (AC) power output of the first, second, and third paired power switches 15 in the alpha beta transformation. More specifically FIG. 5A illustrates a plot over time, before and after a short circuit fault in upper second phase V power switch 30, of both the alpha current (Iα) and beta current (Iβ) using the alternating current (AC) power output of the first, second, and third paired power switches 15 in the alpha beta transformation. The first portion 502 of FIG. 5A on the left illustrates both the alpha current (Iα) and beta current (Iβ) using the current measurements 53, 55, 57 of the respective first, second, and third phases (e.g., phases U, V, W) of the first, second, and third paired power switches 15 in the alpha beta transformation when those power switches 15 are all operating properly (e.g., there are no faults). The second portion 504 of FIG. 5A on the right illustrates both the alpha current (Iα) and beta current (Iβ) using the current measurements 53, 55, and 57 of current sensors 52, 54, 56 in the alpha beta transform where there has been a short circuit fault in upper second phase V power switch 30.

More specifically FIG. 5B illustrates a plot over time, before and after a short circuit fault in lower second phase V power switch 35, of both the alpha current (Iα) and beta current (Iβ) using the alternating current (AC) power output of the first phase (Phase U), second phase (Phase V) and third phase (Phase W) power switches 15 in the alpha beta transformation. The first portion 572 of FIG. 4B on the left illustrates both the alpha current (Iα) and beta current (Iβ) using the current measurements 53, 55, 57 of the respective first, second, and third phases (e.g., phases U, V, W) of the first, second, and third paired power switches 15 in the alpha-beta transformation when those power switches 15 are all operating properly (e.g., there are no faults). The second portion 574 of FIG. 5B on the right illustrates the alpha current (Iα) and beta current (Iβ) using the current measurements 53, 55, and 57 of current sensors 52, 54, 56 in the alpha beta transform where there has been a short circuit fault in lower second phase V power switch 35. In FIGs. 5A and 5B the short circuit of paired power switches 30, 35 occurs at 2.1 seconds and is illustrated by demarcation line 503, 573 respectively.

FIGs. 6A and 6B illustrate a plot over time, before and after a short circuit fault in the respective upper and lower third phase W power switch 40, 45, of an both the alpha current (Iα) and the beta current (Iβ) using the alternating current (AC) power output of the first, second, and third paired power switches 15 in the alpha beta transformation. More specifically FIG. 6A illustrates a plot over time, before and after a short circuit fault in upper third phase W power switch 40, of both the alpha current (Iα) and beta current (Iβ) using the alternating current (AC) power output of first, second and third paired power switches 15 in the alpha beta transformation. The first portion 602 of FIG. 6A on the left illustrates both the alpha current (Iα) and the beta current (Iβ) using the current measurements 53, 55, 57 of the respective first, second, and third phases (e.g., phases U, V, W) of the first, second, and third paired power switches 15 in the alpha beta transform when those power switches 15 are all operating properly (e.g., there are no faults). The second portion 604 of FIG. 6A on the right illustrates both the alpha current (Iα) and the beta current (Iβ) using the current measurements 53, 55, and 57 of current sensors 52, 54, 56 in the alpha beta transform where there has been a short circuit fault in upper third phase W power switch 40.

More specifically FIG. 6B illustrates a plot over time, before and after a short fault in lower third phase W power switch 45, of both the alpha current (Iα) and beta current (Iβ) using the alternating current (AC) power output of the first phase (Phase U), second phase (Phase V) and third phase (Phase W) power switches 15 in the alpha beta transform. The first portion **672 of FIG. 6B** on the left illustrates both the alpha current (Iα) and beta current (Iβ) using the current measurements **53, 55, 57** of the respective first, second, and third phases (e.g., phases U, V, W) of the first, second, and third paired power switches **15** in the alpha beta transform when those power switches **15** are all operating properly (e.g., there are no faults). The second portion **674** of FIG. 6B on the right illustrates both the alpha current (Iα) and beta current (Iβ) using the current measurements **53, 55,** and **57** of current sensors **52, 54, 56** in the alpha beta transform where there has been a short circuit fault in lower third phase W power switch **45**. In **FIG. 6A** the short circuit of power switch **40** occurs at 2.1 seconds while in **FIG. 6B** the short circuit of power switch **45** occurs at 2.3 seconds and is illustrated by demarcation line **603, 673** respectively.

**FIGs. 7A** - **9B** illustrate a plot over time, before and after an open circuit fault in one of the power switches **15,** of both the alpha current (Iα) and beta current (Iβ) calculated using the alternating current (AC) output of first, second, and third paired power switches **15** in the alpha beta transformation in the traditional or stationary reference frame as stated above.

**FIGs. 7A** and **7B** illustrate a plot over time, before and after an open circuit fault in the respective upper and lower first phase U power switch **20, 25,** of both the alpha current (Iα) and the beta current (Iβ) using the alternating current (AC) power output of the first paired, second paired, and third paired power switches **15** in the alpha beta transformation. More specifically **FIG. 7A** illustrates a plot over time, before and after an open circuit fault in upper first phase U power switch **20,** of both the alpha current (Iα) and beta current (Iβ) using the alternating current (AC) power output of first, second and third paired power switches **15** in the alpha beta transformation. The first portion **702** of **FIG. 7A** on the left illustrates both the alpha current (Iα) and the beta current (Iβ) using the current measurements **53, 55, 57** of the respective first, second, and third phases (e.g., phases U, V, W) of the first, second, and third paired power switches **15** in the alpha beta transformation when those power switches **15** are all operating properly (e.g., there are no faults). The second portion **704** of **FIG. 7A** on the right illustrates both the alpha current (Iα) and the beta current (Iβ) using the current measurements **53, 55,** and **57** of current sensors **52, 54, 56** in the alpha beta transformation where there has been an open circuit fault in upper first phase U power switch **20.**

More specifically **FIG. 7B** illustrates a plot over time, before and after a short fault in lower first phase U power switch **25,** of both the alpha current (Iα) and beta current (Iβ) using the alternating current (AC) power output of the first phase (Phase U), second phase (Phase V) and third phase (Phase W) power switches 15 in the alpha beta transformation. The first portion 77**2** of **FIG. 7B** on the left illustrates both the alpha current (Iα) and beta current (Iβ) using the current measurements **53, 55, 57** of the respective first, second, and third phases (e.g., phases U, V, W) of the first, second, and third paired power switches **15** in the alpha beta transformation when those power switches **15** are all operating properly (e.g., there are no faults). The second portion **774** of **FIG. 7B** on the right illustrates both the alpha current (Iα) and beta current (Iβ) using the current measurements **53, 55,** and **57** of current sensors **52, 54, 56** in the alpha beta transformation where there has been a short circuit fault in lower first phase U power switch **25.** In **FIGs. 7A** and **7B** the open circuit failure of paired upper and lower first phase U power switches **20, 25** occurs at 2.1 seconds and is illustrated by demarcation line **703, 773** respectively.

**FIGs. 8A** and **8B** illustrate a plot, over time before and after an open circuit fault in the respective upper and lower second phase V power switches **30, 35,** of both the alpha current (Iα) and the beta current (Iβ) using the alternating current (AC) power output of the first, second, and third paired power switches **15** in the alpha beta transformation. More specifically **FIG. 8A** illustrates a plot over time, before and after an open circuit fault in upper second phase V power switch **30,** of both the alpha current (Iα) and beta current (Iβ) using the alternating current (AC) power output of the first, second, and third paired power switches **15** in the alpha beta transformation. The first portion **802** of **FIG. 8A** on the left illustrates both the alpha current (Iα) and beta current (Iβ) using the current measurements **53, 55, 57** of the respective first, second, and third phases (e.g., phases U, V, W) of the first, second, and third paired power switches **15** in the alpha beta transform when those power switches **15** are all operating properly (e.g., there are no faults). The second portion **804** of **FIG. 8A** on the right illustrates both the alpha current (Iα) and beta current (Iβ) using the current measurements **53, 55,** and **57** of current sensors **52, 54, 56** in the alpha beta transform where there has been an open circuit fault in upper second phase V power switch **30.**

More specifically **FIG. 8B** illustrates a plot over time, before and after an open circuit fault in lower second phase V power switch **35,** of both the alpha current (Iα) and beta current (Iβ) using the alternating current (AC) power output of the first phase (Phase U), second phase (Phase V) and third phase (Phase W) power switches 1**5** in the alpha beta transformation. The first portion **872** of **FIG. 8B** on the left illustrates both the alpha current (Iα) and beta current (Iβ) using the current measurements **53, 55, 57** of the respective first, second, and third phases (e.g., phases U, V, W) of the first, second, and third paired power switches **15** in the alpha-beta transform when those power switches **15** are all operating properly (e.g., there are no faults). The second portion **874** of **FIG. 8B** on the right illustrates the alpha current (Iα) and beta current (Iβ) using the current measurements **53, 55,** and **57** of current sensors **52, 54, 56** in the alpha beta transform where there has been an open circuit fault in lower second phase V power switch **35.** In **FIGs. 8A** and **8B** the open circuit failure of paired upper and lower second phase V power switches **30, 35** occurs at 2.1 seconds and is illustrated by demarcation line **803, 873** respectively.

**FIGs. 9A** and **9B** illustrate a plot over time, before and after an open circuit fault in the respective upper and lower third phase W power switches **40, 45,** of both the alpha current (Iα) and the beta current (Iβ) using the alternating current (AC) power output of the first, second, and third paired power switches **15** in the alpha beta transformation. More specifically **FIG. 9A** illustrates a plot over time, before and after an open circuit fault in upper third phase W power switch **40,** of both the alpha current (Iα) and beta current (Iβ) using the alternating current (AC) power output of the first, second, and third paired power switches **15** in the alpha beta transformation. The first portion **902** of **FIG. 9A** on the left illustrates both the alpha current (Iα) and beta current (Iβ) using the current measurements **53, 55, 57** of the respective first, second, and third phases (e.g., phases U, V, W) of the first, second, and third paired power switches **15** in the alpha beta transform when those power switches **15** are all operating properly (e.g., there are no faults). The second portion **904** of **FIG. 5A** on the right illustrates both the alpha current (Iα) and beta current (Iβ) using the current measurements **53, 55,** and **57** of current sensors **52, 54, 56** in the alpha beta transform where there has been an open circuit fault in upper third phase W power switch **40.**

More specifically **FIG. 9B** illustrates a plot over time, before and after an open circuit fault in lower third phase W power switch **45,** of both the alpha current (Iα) and beta current (Iβ) using the alternating current (AC) power output of the first phase (Phase U), second phase (Phase V) and third phase (Phase W) power switches **15** in the alpha beta transformation. The first portion **972** of **FIG. 9B** on the left illustrates both the alpha current (Iα) and beta current (Iβ) using the current measurements **53, 55, 57** of the respective first, second, and third phases (e.g., phases U, V, W) of the first, second, and third paired power switches **15** in the alpha-beta transform when those power switches **15** are all operating properly (e.g., there are no faults). The second portion **974** of **FIG. 9B** on the right illustrates the alpha current (Iα) and beta current (Iβ) using the current measurements **53, 55,** and **57** of current sensors **52, 54, 56** in the alpha beta transform where there has been an open circuit fault in lower third phase W power switch **45.** In **FIGs. 9A** and **9B** the open circuit failure of paired upper and lower third phase W power switches **40, 45** occurs at 2.3 seconds and is illustrated by demarcation line **903, 973** respectively.

In one or more embodiments, the alpha beta transformation of the current of each phase of the multiphase AC output power is performed in three different reference frames (1f, 2f, 3f) and the signs of the alpha currents (Iα) and beta currents (Iβ) are checked in all three different reference frames (1f, 2f, 3f) to determine whether they remain positive, remain negative, or change between positive and negative. Based upon the different combinations of outcomes by using alpha currents (Iα) and beta currents (Iβ) in three different reference frames (1f, 2f, 3f), the signs (whether they remain positive, remain negative, or switch between positive and negative) of the alpha currents (Iα) and beta currents (Iβ) can be used to detect a specific category of fault (e.g., an open circuit or short circuit fault) as well as detecting and identifying the specific power switch among a plurality of power switches that failed.

In an embodiment, the alpha-beta transformation is performed in three different reference frames where the first reference frame (1f) is the traditional alpha-beta transformation reference frame where there is no rotation, the second alpha-beta transformation reference frame (2f) is rotated 120 degrees in a first direction (e.g., clockwise) from the first reference frame (1f) and the third alpha-beta transformation reference frame (3f) is rotated 240 degrees in the first direction (e.g., clockwise) from the first reference frame (1f). In this regard, the three reference frames are 120 degrees from an adjacent reference frame (e.g., the reference frames are rotated 360/# of phases (3)). In one or more approaches the following three alpha beta transformation equations (Equations Nos. 1, 2, and 3) are used to perform calculations using the AC power output of the multiphase power switches (e.g., the current measurements **53, 55,** and **57**) of the first, second, and third phases (phases U, V, and W) where alpha beta transformations of the three phase currents are calculated and/or determined in three reference frames:

**TRADITIONAL REFERENCE FRAME (NO ROTATION)**

$$\begin{cases} I_\alpha = \frac{2}{3}I_u - \frac{1}{3}I_v - \frac{1}{3}I_w \\ I_\beta = \frac{1}{\sqrt{3}}I_v - \frac{1}{\sqrt{3}}I_w \end{cases} \rightarrow \textbf{Equation No. 1}$$

**TRADITIONAL REFERENCE FRAME +120 DEGREES ROTATION**

$$\begin{cases} I_\alpha = -\frac{1}{3}I_u + \frac{2}{3}I_v - \frac{1}{3}I_w \\ I_\beta = -\frac{1}{\sqrt{3}}I_u + \frac{1}{\sqrt{3}}I_w \end{cases} \rightarrow \textbf{Equation No. 2}$$

**TRADITIONAL REFERENCE FRAME +240 DEGREES ROTATION**

$$\begin{cases} I_\alpha = -\frac{1}{3}I_u - \frac{1}{3}I_v + \frac{2}{3}I_w \\ I_\beta = \frac{1}{\sqrt{3}}I_u - \frac{1}{\sqrt{3}}I_v \end{cases} \rightarrow \textbf{Equation No. 3}$$

where 1f designates the first traditional reference frame with no rotation, 2f designates the second reference frame with 120 degrees rotation in a first direction (clockwise), and 3f designates the third time frame with 240 degrees rotation in the first direction (clockwise). The signs (whether positive, negative, or both positive and negative) of the alpha current ($I\alpha$) and the beta current ($I\beta$) are checked in all three reference frames (1f, 2f, and 3f) and the outcomes are used to determine if one of the power switches is defective (e.g., has an open circuit or short circuit fault), the type of failure or fault (open circuit or short circuit fault), and the identity of the switch that failed.

Turning back to **FIG. 3** which shows an alpha current ($I\alpha$) vs beta current ($I\beta$) plot **370** for a power switch **15** that is properly operating (e.g., there is no open circuit or short circuit), the plot **370** forms a circle that intersects all four quadrants **1-4**. In this regard, alpha current ($I\alpha$) changes from positive to negative (and vice versa) as does the beta current ($I\beta$) change from positive to negative (and vice versa). However, an alpha current ($I\alpha$) vs. beta current ($I\beta$) plot of a power switch having a short circuit does not form a circle, but rather forms a triangular shaped figure (e.g., a pizza slice shape).

**FIGs. 10A-18B** illustrate a plot of alpha current ($I\alpha$) vs beta current ($I\beta$) calculated using the alternating current (AC) output of the first, second, and third (phases U, V, W) paired power switches **15** in the alpha beta transformation in three different reference frames (1f, 2f, 3f) where the first reference frame (1f) is the traditional alpha beta transform where there is no rotation (e.g., uses equation No. 1 above), the second reference frame (2f) is rotated 120 degrees from the first time frame (e.g., uses equation No. 2 above), and the third reference frame (3f) is rotated 240 degrees from the first reference frame (e.g., uses equation No. 3 above) where one of the power switches **15** has a short circuit. That is, each reference frame is rotated 120 degrees from each adjacent reference frame. As can be illustrated in **FIGs. 10A-18A** the plots of the alpha current ($I\alpha$) vs. beta current ($I\beta$) in the different reference frames where a power switch has failed as a result of a short circuit remain in one of the four quadrants 1-4 and do not overlap, cross over into and/or dissect multiple quadrants. As illustrated in the plots of **FIGs. 10A-18A** for a specific power switch short circuit failure, the plot illustrates that for a particular reference frame the alpha current ($I\alpha$) remains positive or remains negative instead of changing between positive and negative and the beta current ($I\beta$) remains positive or remains positive instead of changing positive and negative. This distinction between the alpha current ($I\alpha$) and beta current ($I\beta$) of properly operating power switch and a shorted power switch in the multiple reference frames (in the example **FIG. 1** having 3 phase inverter/converter circuit **10** three (3) reference frames are used) is utilized to detect and/or identify the power switch out of multiple switches that have a short circuit fault.

**FIGs. 10A - 12B** each illustrate a plot of alpha current ($I\alpha$) vs beta current ($I\beta$) calculated using the alternating current (AC) output of the first, second, and third paired power switches **15** in the alpha beta transformation in a first (traditional) reference frame (1f) with no rotation (e.g., using equation No. 1 above) where there is a short circuit fault in one of the power switches **15**.

**FIGs. 10A** and **10B** each illustrate a plot of the alpha current ($I\alpha$) vs. beta current ($I\beta$) using the alternating current (AC) output of the first, second, and third paired power switches **15** in the alpha beta transformation in a first (e.g., traditional) reference frame (1f) having no rotation where there is a short circuit in one of the respective upper and lower first phase U power switches **20, 25**. More specifically **FIG. 10A** illustrates a plot **1070,** after a short circuit fault in upper first phase U power switch **20,** of the alpha current ($I\alpha$) vs the beta current ($I\beta$) using the alternating current (AC) output of the first, second, and third paired power switches **15** in the alpha beta transformation in the first (e.g., traditional) reference frame (1f) having no rotation. As can be seen in **FIG. 10A** the plot **1070** traces a triangular or pizza slice shape where the beta current ($I\beta$) changes both positive and negative while the alpha current ($I\alpha$) remains positive. That is, the alpha current ($I\alpha$) vs the beta current ($I\beta$) plot **1070** of the shorted upper first phase U power switch **20** overlaps, crosses over into, and/or dissects two quadrants (quadrants **1** and **4**) of **FIG. 10A**. More specifically **FIG. 10B** illustrates a plot **1075,** after a short circuit fault in lower first phase U power switch **25,** of the alpha current ($I\alpha$) vs beta current ($I\beta$) using the alternating current (AC) output of the first, second, and third paired power switches **15** in the alpha beta transformation in the first (e.g., traditional) reference frame (1f) having no rotation. As can be seen in **FIG. 10B** the plot **1075** traces a triangular or pizza slice shape where the beta current (Iβ) changes both positive and negative while the alpha current (Iα) remains negative. That is, the alpha current (Iα) vs the beta current (Iβ) plot **1075** of the shorted lower first phase U power switch **25** overlaps, crosses over into, and/or dissect two quadrants (quadrants **2** and **3**) of **FIG. 10B**.

**FIGs. 11A** and **11B** each illustrate a plot of the alpha current (Iα) vs. beta current (Iβ) using the alternating current (AC) output of the first, second, and third paired power switches **15** in the alpha beta transformation in a first (e.g., traditional) reference frame (1f) having no rotation where there is a short circuit in one of the respective upper and lower second phase V power switches **30, 35**. More specifically **FIG. 11A** illustrates a plot **1170,** after a short circuit fault in upper second phase V power switch **30,** of the alpha current (Iα) vs the beta current (Iβ) using the alternating current (AC) output of the first, second, and third paired power switches **15** in the alpha beta transformation in the first (e.g., traditional) reference frame (1f) having no rotation. As can be seen in **FIG. 11A** the plot **1170** traces a triangular or pizza slice shape where the beta current (Iβ) remains positive and the alpha current (Iα) remains negative. That is, the alpha current (Iα) vs the beta current (Iβ) plot **1170** of the shorted upper second phase V power switch **30** remains in a single quadrant (quadrant **2**) and does not overlap, cross over into, and/or dissect multiple quadrants of **FIG. 11A**. More specifically **FIG. 11B** illustrates a plot **1175,** after a short circuit fault in lower second phase V power switch **35,** of the alpha current (Iα) vs beta current (Iβ) using the alternating current (AC) output of the first, second, and third paired power switches **15** in the alpha beta transformation in the first (e.g., traditional) reference frame (1f) having no rotation. As can be seen in **FIG. 11B** the plot **1175** traces a triangular or pizza slice shape where the beta current (Iβ) remains negative while the alpha current (Iα) remains positive. That is, the alpha current (Iα) vs the beta current (Iβ) plot **1175** of the shorted lower second phase V power switch **35** remains in a single quadrant (quadrant 4) and does not overlap, cross over into, and/or dissect multiple quadrants of **FIG. 11B**.

**FIGs. 12A** and **12B** each illustrate a plot of the alpha current (Iα) vs. beta current (Iβ) using the alternating current (AC) output of the first, second, and third paired power switches **15** in the alpha beta transformation in the first (e.g., traditional) reference frame (1f) having no rotation where there is a short circuit in one of the respective upper and lower third phase W power switches **40, 45**. More specifically **FIG. 12A** illustrates a plot **1270,** after a short circuit fault in upper third phase W power switch **40,** of the alpha current (Iα) vs the beta current (Iβ) using the alternating current (AC) output of the first, second, and third paired power switches **15** in the alpha beta transformation in the first (e.g., traditional) reference frame (1f) having no rotation. As can be seen in **FIG. 12A** the plot **1270** traces a triangular or pizza slice shape where the beta current (Iβ) remains negative and the alpha current (Iα) remains negative. That is, the alpha current (Iα) vs the beta current (Iβ) plot **1270** of the shorted upper third phase W power switch **40** remains in a single quadrant (quadrant **3**) and does not overlap, cross over into, and/or dissect multiple quadrants of **FIG. 12A**. More specifically **FIG. 12B** illustrates a plot **1275,** after a short circuit fault in lower third phase W power switch **45,** of the alpha current (Iα) vs beta current (Iβ) using the alternating current (AC) output of the first, second, and third paired power switches **15** in the alpha beta transformation in the first (e.g., traditional) reference frame (1f) having no rotation. As can be seen in **FIG. 12B** the plot **1275** traces a triangular or pizza slice shape where the beta current (Iβ) remains positive while the alpha current (Iα) remains positive. That is, the alpha current (Iα) vs the beta current (Iβ) plot **1275** of the shorted lower third phase W power switch **45** remains in a single quadrant (quadrant **1**) and does not overlap, cross over into, and/or dissect multiple quadrants of **FIG. 12B**.

**FIGs. 13A - 15B** each illustrate a plot of alpha current (Iα) vs beta current (Iβ) calculated using the alternating current (AC) output of the first, second, and third paired power switches **15** in the alpha beta transformation in a second reference frame (2f) rotated 120 degrees from the first reference frame (e.g., using Equation No. 2 from above) where there is a short circuit fault in one of the power switches **15**.

**FIGs. 13A** and **13B** each illustrate a plot of the alpha current (Iα) vs. beta current (Iβ) using the alternating current (AC) output of the first, second, and third paired power switches **15** in the alpha beta transformation in a second reference frame (2f) rotated 120 degrees where there is a short circuit in one of the respective upper and lower first phase U power switches **20, 25**. More specifically **FIG. 13A** illustrates a plot **1370,** after a short circuit fault in upper first phase U power switch **20,** of the alpha current (Iα) vs the beta current (Iβ) using the alternating current (AC) output of the first, second, and third paired power switches **15** in the alpha beta transformation in a second frame (2f) rotated 120 degrees. As can be seen in **FIG. 13A** the plot **1370** traces a triangular or pizza slice shape where the beta current (Iβ) remains negative and the alpha current (Iα) remains negative. That is, the alpha current (Iα) vs the beta current (Iβ) plot **1370** of the shorted upper first phase U power switch **20** remains in a single quadrant (quadrant 3) and does not overlap, cross over into, and/or dissect multiple quadrants of **FIG. 13A**. More specifically **FIG. 13B** illustrates a plot **1375,** after a short fault in lower first phase U power switch **25,** of the alpha current (Iα) vs beta current (Iβ) using the alternating current (AC) output of the first, second, and third paired power switches **15** in the alpha beta transformation in the second reference frame (2f) rotated 120 degrees. As can be seen in **FIG. 13B** the plot **1375** traces a triangular or pizza slice shape where the beta current (Iβ) remains positive and the alpha current (Iα) remains positive. That is, the alpha current (Iα) vs the beta current (Iβ) plot **1375** of the shorted lower first phase U power switch **25** remains in a single quadrant (quadrant **1**) and does not overlap, cross over into, and/or dissect multiple quadrants of **FIG. 13B**.

**FIGs. 14A** and **14B** each illustrate a plot of the alpha current (Iα) vs. beta current (Iβ) using the alternating current (AC) output of the first, second, and third paired power switches **15** in the alpha beta transformation in a second reference frame (2f) rotated 120 degrees where there is a short circuit in one of the respective upper and lower second phase V power switches **30, 35.** More specifically **FIG. 14A** illustrates a plot **1470,** after a short circuit fault in upper second phase V power switch **30,** of the alpha current (Iα) vs the beta current (Iβ) using the alternating current (AC) output of the first, second, and third paired power switches **15** in the alpha beta transformation in the second reference frame (2f) rotated 120 degrees. As can be seen in **FIG. 14A** the plot **1470** traces a triangular or pizza slice shape where the beta current (Iβ) changes both positive and negative while the alpha current (Iα) remains positive. That is, the alpha current (Iα) vs the beta current (Iβ) plot **1470** of the shorted upper second phase V power switch **30** does not remain in a single quadrant but rather overlaps, cross over into, and/or dissects two quadrants (quadrants **1** and **4)** of **FIG. 14A.** More specifically **FIG. 14B** illustrates a plot **1475,** after a short circuit fault in lower second phase V power switch **35,** of the alpha current (Iα) vs beta current (Iβ) using the alternating current (AC) output of the first, second, and third paired power switches **15** in the alpha beta transformation in the second reference frame (2f) rotated 120 degrees. As can be seen in **FIG. 14B** the plot **1475** traces a triangular or pizza slice shape where the beta current (Iβ) changes both positive and negative while the alpha current (Iα) remains negative. That is, the alpha current (Iα) vs the beta current (Iβ) plot **1475** of the shorted lower second phase V power switch **35** does not remain in a single quadrant but overlaps, cross over into, and/or dissects two quadrants (quadrants **2** and **3**) of **FIG. 14B.**

**FIGs. 15A** and **15B** each illustrate a plot of the alpha current (Iα) vs. beta current (Iβ) using the alternating current (AC) output of the first, second, and third paired power switches **15** in the alpha beta transformation in the second reference frame (2f) rotated 120 degrees where there is a short circuit in one of the respective upper and lower third phase W power switches **40, 45.** More specifically **FIG. 15A** illustrates a plot **1570,** after a short circuit fault in upper third phase W power switch **40,** of the alpha current (Iα) vs the beta current (Iβ) using the alternating current (AC) output of the first, second, and third paired power switches **15** in the alpha beta transformation in the second reference frame (2f) rotated 120 degrees. As can be seen in **FIG. 15A** the plot **1570** traces a triangular or pizza slice shape where the beta current (Iβ) remains positive and the alpha current (Iα) remains negative. That is, the alpha current (Iα) vs the beta current (Iβ) plot **1570** of the shorted upper third phase W power switch **40** remains in a single quadrant (quadrant **2**) and does not overlap, cross over into, and/or dissect multiple quadrants of **FIG. 15A.** More specifically **FIG. 15B** illustrates a plot **1575,** after a short circuit fault in lower third phase W power switch **45,** of the alpha current (Iα) vs beta current (Iβ) using the alternating current (AC) output of the first, second, and third paired power switches **15** in the alpha beta transformation in second reference frame (2f) rotated 120 degrees. As can be seen in **FIG. 15B** the plot **1575** traces a triangular or pizza slice shape where the beta current (Iβ) remains negative while the alpha current (Iα) remains positive. That is, the alpha current (Iα) vs the beta current (Iβ) plot **1575** of the shorted lower third phase W power switch **45** remains in a single quadrant (quadrant **4**) and does not overlap, cross over into, and/or dissect multiple quadrants of **FIG. 15B.**

**FIGs. 16A - 18B** each illustrate a plot of alpha current (Iα) vs beta current (Iβ) calculated using the alternating current (AC) output of the first, second, and third paired power switches **15** in the alpha beta transformation in a third reference frame (3f) rotated 120 degrees from the first reference frame (e.g., using Equation No. 3 above) where there is a short circuit fault in one of the power switches **15.**

**FIGs. 16A** and **16B** each illustrate a plot of the alpha current (Iα) vs. beta current (Iβ) using the alternating current (AC) output of the first, second, and third paired power switches **15** in the alpha beta transformation in the third reference frame (3f) rotated 240 degrees where there is a short circuit in one of the respective upper and lower first phase U power switches **20, 25.** More specifically **FIG. 16A** illustrates a plot **1670,** after a short circuit fault in upper first phase U power switch **20,** of the alpha current (Iα) vs the beta current (Iβ) using the alternating current (AC) output of the first, second, and third paired power switches **15** in the alpha beta transformation in a third reference frame (3f) rotated 240 degrees. As can be seen in **FIG. 16A** the plot **1670** traces a triangular or pizza slice shape where the beta current (Iβ) remains positive and the alpha current (Iα) remains negative. That is, the alpha current (Iα) vs the beta current (Iβ) plot **1670** of the shorted upper first phase U power switch **20** remains in a single quadrant (quadrant **2**) and does not overlap, cross over into, and/or dissect multiple quadrants of **FIG. 16A.** More specifically **FIG. 16B** illustrates a plot **1675,** after a short circuit fault in lower first phase U power switch **25,** of the alpha current (Iα) vs beta current (Iβ) using the alternating current (AC) output of the first, second, and third paired power switches **15** in the alpha beta transformation in the third reference frame (3f) rotated 240 degrees. As can be seen in **FIG. 16B** the plot **1675** traces a triangular or pizza slice shape where the beta current (Iβ) remains negative and the alpha current (Iα) remains positive. That is, the alpha current (Iα) vs the beta current (Iβ) plot **1675** of the shorted lower first phase U power switch **25** remains in a single quadrant (quadrant **4**) and does not overlap, cross over into, and/or dissect multiple quadrants of **FIG. 16B.**

**FIGs. 17A** and **17B** each illustrate a plot of the alpha current (Iα) vs. beta current (Iβ) using the alternating current (AC) output of the first, second, and third paired power switches **15** in the alpha beta transformation in the third reference frame (3f) rotated 240 degrees where there is a short circuit in one of the respective upper and lower second phase V power switches **30, 35.** More specifically **FIG. 17A** illustrates a plot **1770,** after a short circuit fault in upper second phase V power switch **30,** of the alpha current (Iα) vs the beta current (Iβ) using the alternating current (AC) output of the first, second, and third paired power switches **15** in the alpha beta transformation in the third reference frame (3f) rotated 240 degrees. As can be seen in **FIG. 17A** the plot **1770** traces a triangular or pizza slice shape where the beta current (Iβ) remains negative and the alpha current (Iα) remains negative. That is, the alpha current (Iα) vs the beta current (Iβ) plot **1770** of the shorted upper second phase V power switch **30** remains in a single quadrant (quadrant **3**) and does not overlap, cross over into, and/or dissect multiple quadrants of **FIG. 17A**. More specifically **FIG. 17B** illustrates a plot **1775,** after a short circuit fault in lower second phase V power switch **35,** of the alpha current (Iα) vs beta current (Iβ) using the alternating current (AC) output of the first, second, and third paired power switches **15** in the alpha beta transformation in the third reference frame (3f) rotated 240 degrees. As can be seen in **FIG. 17B** the plot **1775** traces a triangular or pizza slice shape where the beta current (Iβ) remains positive and the alpha current (Iα) remains positive. That is, the alpha current (Iα) vs the beta current (Iβ) plot **1775** of the shorted lower second phase V power switch **35** remains in a single quadrant (quadrant **1**) and does not overlap, cross over into, and/or dissect multiple quadrants of **FIG. 17B**.

**FIGs. 18A** and **18B** each illustrate a plot of the alpha current (Iα) vs. beta current (Iβ) using the alternating current (AC) output of the first, second, and third paired power switches **15** in the alpha beta transformation in the third reference frame (3f) rotated 240 degrees where there is a short circuit in one of the respective upper and lower third phase W power switches **40, 45**. More specifically **FIG. 18A** illustrates a plot **1870,** after a short circuit fault in upper third phase W power switch **40,** of the alpha current (Iα) vs the beta current (Iβ) using the alternating current (AC) output of the first, second, and third paired power switches **15** in the alpha beta transformation in the third reference frame (3f) rotated 240 degrees. As can be seen in **FIG. 18A** the plot **1870** traces a triangular or pizza slice shape where the beta current (Iβ) changes both positive and negative while and the alpha current (Iα) remains positive. That is, the alpha current (Iα) vs the beta current (Iβ) plot **1870** of the shorted upper third phase W power switch **40** does not remain in a single quadrant but rather overlaps, cross over into, and/or dissects two quadrants (**1** and **4**) of **FIG. 18A**. More specifically **FIG. 18B** illustrates a plot **1875,** after a short circuit fault in lower third phase W power switch **45,** of the alpha current (Iα) vs beta current (Iβ) using the alternating current (AC) output of the first, second, and third paired power switches **15** in the alpha beta transformation in third reference frame (3f) rotated 240 degrees. As can be seen in **FIG. 18B** the plot **1875** traces a triangular or pizza slice shape where the beta current (Iβ) changes both positive and negative while the alpha current (Iα) remains negative. That is, the alpha current (Iα) vs the beta current (Iβ) plot **1875** of the shorted lower third phase W power switch **45** does not remain in a single quadrant but rather overlaps, cross over into, and/or dissects two quadrants (quadrants **2** and **3**) of **FIG. 18B**.

As can be seen by **FIGS. 10A-18B** short circuit faults of power switches used to produce multiphase AC output power, including three phase AC output power, can be determined by looking at the signs (positive, negative, or both positive and negative) of the alpha current (Iα) vs beta current (Iβ) in the three different reference frames, e.g., a first traditional alpha-beta transformation reference frame (1f) with no rotation (using the multiphase currents in e.g., Equation No. 1), a second alpha-beta transformation reference frame (2f) rotated 120 degrees in a first direction (using the multiphase currents in e.g., Equation No. 2) and a third alpha-beta transformation reference frame (3f) rotated 240 degrees in a first direction (using the multiphase currents in e.g., Equation No. 3). Short circuits of upper and lower second phase V power switches **30, 35** and short circuits of upper and lower third phase W power switches **40, 45** can be detected in the first (traditional) reference frame (1f) with no rotation (using e.g., Equation No. 1). This short circuit fault criteria in the first reference frame (1f) is summarized in Table 1 below and in **FIG. 19A:**

Table 1:

| Condition | Fault |
|---|---|
| $I_{\alpha} > 0$ & $I_{\beta} > 0$ | Lower Switch W |
| $I_{\alpha} < 0$ & $I_{\beta} < 0$ | Upper Switch W |
| $I_{\alpha} > 0$ & $I_{\beta} < 0$ | Lower Switch V |
| $I_{\alpha} < 0$ & $I_{\beta} > 0$ | Upper Switch V |

Short circuits of upper and lower first phase U power switches **20, 25** and short circuits of upper and lower third phase W power switches **40, 45** can be detected in the second reference frame (2f) rotated 120 degrees in a first direction (e.g., clockwise) from the first reference frame (1f) using Equation No. 2. This short circuit fault criteria in the second reference frame (2f) is summarized in Table 2 below and in **FIG. 19B:**

Table 2:

| Condition | Fault |
|---|---|
| $I_{\alpha} > 0$ & $I_{\beta} > 0$ | Lower Switch U |
| $I_{\alpha} < 0$ & $I_{\beta} < 0$ | Upper Switch U |

(continued)

| Condition | Fault |
|---|---|
| $I_\alpha > 0$ & $I_\beta < 0$ | Lower Switch W |
| $I_\alpha < 0$ & $I_\beta > 0$ | Upper Switch W |

Short circuits of upper and lower first phase U power switches **20, 25** and short circuits of upper and lower second phase V power switches **30, 35** can be detected in the third reference frame rotated 240 degrees in a first direction (e.g., clockwise) from the first reference frame (1f) using Equation No. 3. This short circuit criteria in the third reference frame (3f) is summarized in Table 3 below and in **FIG. 19C:**

Table 3:

| Condition | Fault |
|---|---|
| $I_\alpha > 0$ & $I_\beta > 0$ | Lower Switch V |
| $I_\alpha < 0$ & $I_\beta < 0$ | Upper Switch V |
| $I_\alpha > 0$ & $I_\beta < 0$ | Lower Switch U |
| $I_\alpha < 0$ & $I_\beta > 0$ | Upper Switch U |

As can be seen by Tables 1-3 and **FIGs. 19A-19C** (and **FIGs. 10A-18B**), an upper first phase U power switch (e.g., switch **20**) short circuit fault would be demonstrated (as seen in Tables 2-3) by the alpha current (I$\alpha$) using the second frame (2f) alpha beta transformation (e.g., Equation No. 2) being less than zero (remaining negative) and the beta current (I$\beta$) using the second frame (2f) alpha beta transformation (e.g., Equation No. 2) being less than zero (remaining negative) and/or the alpha current (I$\alpha$) using the third frame (3f) alpha beta transformation (e.g., Equation No. 3) being less than zero (remaining negative) and the beta current (I$\beta$) using the third frame (3f) alpha beta transformation (e.g., Equation No. 3) being greater than zero (remaining positive). Similarly, as can be seen by Tables 1-3 and **FIGs. 19A-19C** (and **FIGs. 10A-18B**), a lower first phase U power switch (e.g., switch **25**) short circuit fault would be demonstrated (as seen in Tables 2-3) by the alpha current (I$\alpha$) using the second frame (2f) alpha beta transformation (e.g., Equation No. 2) being greater than zero (remaining positive) and the beta current (I$\beta$) using the second frame (2f) alpha beta transformation (e.g., Equation No. 2) being greater than zero (remaining negative) and/or the alpha current (I$\alpha$) using the third frame (3f) alpha beta transformation (e.g., Equation No. 3) being greater than zero (remaining positive) and the beta current (I$\beta$) using the third frame (3f) alpha beta transformation (e.g., Equation No. 3) being less than zero (remaining negative). In this manner, the short circuits in upper and lower paired power switches **30, 35, 40, 45** can be determined using Tables 1-3 and **FIGs. 19A-19C** (and **FIGs. 10A-18B**).

The above discussion of Tables 1-3 and **FIGs. 10A-19C** illustrate and explain how short circuits can be detected in the power switches, and how the specific power switch that has the short circuit can be detected in a multiphase inverter/converter circuit using multiple power switches, e.g., six power switches. Tables 4-6 and **FIGs. 20A-29C** will be discussed and used to explain how open circuit faults can be detected in the power switches, and how the specific power switch that has the open circuit fault can be detected in a multiphase inverter/converter circuit using multiple power switches, e.g., six power switches.

**FIGs 20A-28B** each illustrate a plot of alpha current (I$\alpha$) vs beta current (I$\beta$) calculated using the alternating current (AC) output of the first, second, and third paired power switches **15** in the alpha beta transformation in three different reference frames where the first reference frame (1f) is the traditional alpha beta transformation where there is no rotation (using e.g., Equation No. 1 above), the second alpha-beta transformation reference frame (2f) is rotated 120 degrees in a first direction (e.g., clockwise) from the first reference frame (1f) (using e.g., Equation No. 2 above), and the third alpha-beta transformation reference frame (3f) is rotated 240 degrees in a first direction (e.g., clockwise) from the first alpha-beta transformation reference frame (1f) (using e.g., Equation No. 3 above) where one of the power switches **15** has an open circuit fault.

As can be illustrated in **FIGs. 20A-28A** the plots of the alpha current (I$\alpha$) vs. beta current (I$\beta$), in the reference frame relative to the power switch that has failed as a result of an open circuit, remain in two of the four quadrants 1-4 and do not overlap, cross over into and/or dissect into three quadrants and more specifically, that in certain plots the alpha current (I$\alpha$) stays positive (**FIGs. 20B, 24B, 28B**) or the alpha current (I$\alpha$) stays negative (**FIGs. 20A, 24A, 28A**), that is the plot is confined to either both quadrants 1 and 4 or both quadrants 2 and 3. As illustrated in the plots of **FIGs. 10A-18A** for a specific power switch short circuit failure, the plot illustrates that for a particular reference frame the alpha current (I$\alpha$) remains positive or remains negative instead of changing between positive and negative. This distinction between the alpha current (Iα) of a properly operating power switch and an open circuit power switch fault in the multiple reference frames (in the example **FIG. 1** having 3 phase inverter/converter circuit **10** three (3) reference frames are used) is utilized to detect and/or identify the power switch out of multiple switches that have, or potentially have, an open circuit fault.

FIGs. 20A - 22B each illustrate a plot of alpha current (Iα) vs beta current (Iβ) calculated using the alternating current (AC) output of the first, second, and third paired (phases U, V, W) power switches **15** in the alpha beta transformation in a first (traditional) reference frame (1f) with no rotation (e.g., using Equation No. 1 above) where there is an open circuit fault in one of the power switches **15**.

FIGs. 20A and 20B each illustrate a plot of the alpha current (Iα) vs. beta current (Iβ) using the alternating current (AC) output of the first, second, and third paired power switches **15** in the alpha beta transformation in a first (e.g., traditional) reference frame (1f) having no rotation where there is an open circuit in one of the respective upper and lower first phase U power switches **20, 25**. More specifically **FIG. 20A** illustrates a plot **2070,** after an open circuit fault in upper first phase U power switch **20,** of the alpha current (Iα) vs the beta current (Iβ) using the alternating current (AC) output of the first, second, and third paired power switches **15** in the alpha beta transformation in the first (e.g., traditional) reference frame (1f) having no rotation (using e.g., Equation No. 1). As can be seen in **FIG. 20A** the plot **2070** traces a semicircle shape where the beta current (Iβ) changes both positive and negative while the alpha current (Iα) remains negative. That is, the alpha current (Iα) vs the beta current (Iβ) plot **2070** of the upper first phase U power switch **20** having an open circuit fault overlaps, crosses over into, and/or dissects two quadrants (quadrants **2** and **3**) of **FIG. 20A.** More specifically **FIG. 20B** illustrates a plot **2075,** after an open circuit fault in lower first phase U power switch **25,** of the alpha current (Iα) vs beta current (Iβ) using the alternating current (AC) output of the first, second, and third paired power switches **15** in the alpha beta transformation in the first (e.g., traditional) reference frame (1f) having no rotation (using e.g., Equation No. 1). As can be seen in **FIG. 20B** the plot **2075** traces a semicircle shape where the beta current (Iβ) changes both positive and negative while the alpha current (Iα) remains positive. That is, the alpha current (Iα) vs the beta current (Iβ) plot **2075** of the lower first phase U power switch **25** having an open circuit fault overlaps, crosses over into, and/or two quadrants (quadrants **1** and **4**) of **FIG. 20B.**

FIGs. 21A and 21B each illustrate a plot of the alpha current (Iα) vs. beta current (Iβ) using the alternating current (AC) output of the first, second, and third paired power switches **15** in the alpha beta transformation in a first (e.g., traditional) reference frame (1f) having no rotation where there is an open circuit in one of the respective upper and lower second phase V power switches **30, 35**. More specifically **FIG. 21A** illustrates a plot **2170,** after an open circuit fault in upper second phase V power switch **30,** of the alpha current (Iα) vs the beta current (Iβ) using the alternating current (AC) output of the first, second, and third paired power switches **15** in the alpha beta transformation in the first (e.g., traditional) reference frame (1f) having no rotation (using e.g., Equation No. 1). As can be seen in **FIG. 21A** the plot **2170** traces a semicircular shape where the beta current (Iβ) changes positive and negative while the alpha current (Iα) also changes positive and negative. That is, the alpha current (Iα) vs the beta current (Iβ) plot **2170** of the upper second phase V power switch **30** having an open circuit fault overlaps, crosses over into, and/or dissects three quadrants (quadrants **1, 3** and **4**) of **FIG. 21A.** More specifically **FIG. 21B** illustrates a plot **2175,** after an open circuit fault in lower second phase V power switch **35,** of the alpha current (Iα) vs beta current (Iβ) using the alternating current (AC) output of the first, second, and third paired power switches **15** in the alpha beta transformation in the first (e.g., traditional) reference frame (1f) having no rotation (using e.g., Equation No. 1). As can be seen in **FIG. 21B** the plot **2175** traces a semicircular shape where the beta current (Iβ) changes positive and negative while the alpha current (Iα) also changes positive and negative. That is, the alpha current (Iα) vs the beta current (Iβ) plot **2175** of the lower second phase V power switch **35** having an open circuit fault overlaps, crosses over into, and/or dissects three quadrants (quadrants **1, 2** and **3**) of **FIG. 21B.**

FIGs. 22A and 22B each illustrate a plot of the alpha current (Iα) vs. beta current (Iβ) using the alternating current (AC) output of the first, second, and third paired power switches **15** in the alpha beta transformation in the first (e.g., traditional) reference frame (1f) having no rotation where there is an open circuit in one of the respective upper and lower third phase W power switches **40, 45**. More specifically **FIG. 22A** illustrates a plot **2270,** after an open circuit fault in upper third phase W power switch **40,** of the alpha current (Iα) vs the beta current (Iβ) using the alternating current (AC) output of the first, second, and third paired power switches **15** in the alpha beta transformation in the first (e.g., traditional) reference frame having no rotation (using e.g., Equation No. 1). As can be seen in **FIG. 22A** the plot **2270** traces a semicircular shape where the beta current (Iβ) changes positive and negative and the alpha current (Iα) changes positive and negative. That is, the alpha current (Iα) vs the beta current (Iβ) plot **2270** of the upper third phase W power switch **40** having an open circuit fault overlaps, crosses over into, and dissects three quadrants (quadrants **1, 2** and **4**) of **FIG. 22A.** More specifically **FIG. 22B** illustrates a plot **2275,** after an open circuit fault in lower third phase W power switch **45,** of the alpha current (Iα) vs beta current (Iβ) using the alternating current (AC) output of the first, second, and third paired power switches **15** in the alpha beta transformation in the first (e.g., traditional) reference frame (1f) having no rotation (using e.g., Equation No. 1). As can be seen in **FIG. 22B** the plot **2275** traces a semicircular shape where the beta current (Iβ) changes positive and negative while the alpha current (Iα) also changes positive and negative. That is, the alpha current (Iα) vs the beta current (Iβ) plot **2275** of the lower third phase W power switch **45** with an open circuit fault overlaps, crosses over into, and/or dissects three quadrants (quadrants **2, 3** and **4**) **of FIG. 22B.**

**FIGs. 23A - 25B** each illustrate a plot of alpha current (Iα) vs beta current (Iβ) calculated using the alternating current (AC) output of the first, second, and third paired power switches **15** in the alpha beta transformation in a second reference frame (2f) rotated 120 degrees from the first reference frame (e.g., using Equation No. 2 from above) where there is an open circuit fault in one of the power switches **15.**

**FIGs. 23A** and **23B** each illustrate a plot of the alpha current (Iα) vs. beta current (Iβ) using the alternating current (AC) output of the first, second, and third paired power switches **15** in the alpha beta transformation in a second reference frame (2f) rotated 120 degrees where there is an open circuit in one of the respective upper and lower first phase U power switches **20, 25.** More specifically **FIG. 23A** illustrates a plot **2370,** after an open circuit fault in upper first phase U power switch **20,** of the alpha current (Iα) vs the beta current (Iβ) using the alternating current (AC) output of the first, second, and third paired power switches **15** in the alpha beta transformation in a second frame (2f) rotated 120 degrees (using e.g., Equation No. 2). As can be seen in **FIG. 23A** the plot **2370** traces a semicircular shape where the beta current (Iβ) changes positive and negative while the alpha current (Iα) also changes positive and negative. That is, the alpha current (Iα) vs the beta current (Iβ) plot **2370** of the upper first phase U power switch **20** having an open circuit overlaps, crosses over into, and/or dissects three quadrants (quadrant **1, 2** and **4**) of **FIG. 23A.** More specifically **FIG. 23B** illustrates a plot **2375,** after an open circuit fault in lower first phase U power switch **25,** of the alpha current (Iα) vs beta current (Iβ) using the alternating current (AC) output of the first, second, and third paired power switches **15** in the alpha beta transformation in the second reference frame (2f) rotated 120 degrees (using e.g., Equation No. 2). As can be seen in **FIG. 23B** the plot **2375** traces a semicircular shape where the beta current (Iβ) changes positive and negative while the alpha current (Iα) also changes positive and negative. That is, the alpha current (Iα) vs the beta current (Iβ) plot **2375** of the lower first phase U power switch **25** having an open circuit fault overlaps, crosses over into, and/or dissects three quadrants (quadrants **2, 3** and **4**) of **FIG. 23B.**

**FIGs. 24A** and **24B** each illustrate a plot of the alpha current (Iα) vs. beta current (Iβ) using the alternating current (AC) output of the first, second, and third paired power switches **15** in the alpha beta transformation in a second reference frame (2f) rotated 120 degrees where there is an open circuit in one of the respective upper and lower second phase V power switches **30, 35.** More specifically **FIG. 24A** illustrates a plot **2470,** after an open circuit fault in upper second phase V power switch **30,** of the alpha current (Iα) vs the beta current (Iβ) using the alternating current (AC) output of the first, second, and third paired power switches **15** in the alpha beta transformation in the second reference frame (2f) rotated 120 degrees (using e.g., Equation No. 2). As can be seen in **FIG. 24A** the plot **2470** traces a semicircular shape where the beta current (Iβ) changes both positive and negative while the alpha current (Iα) remains negative. That is, the alpha current (Iα) vs the beta current (Iβ) plot **2470** of the upper second phase V power switch **30** having an open circuit fault overlaps, crosses over into, and/or dissects two quadrants (quadrants **2** and **3**) of **FIG. 24A.** More specifically **FIG. 24B** illustrates a plot **2475,** after an open circuit fault in lower second phase V power switch **35,** of the alpha current (Iα) vs beta current (Iβ) using the alternating current (AC) output of the first, second, and third paired power switches **15** in the alpha beta transformation in the second reference frame (2f) rotated 120 degrees (using e.g., Equation No. 2). As can be seen in **FIG. 24B** the plot **2475** traces a semicircular shape where the beta current (Iβ) changes both positive and negative while the alpha current (Iα) remains positive. That is, the alpha current (Iα) vs the beta current (Iβ) plot **2475** of the lower second phase V power switch **35** having an open circuit fault overlaps, crosses over into, and/or dissects two quadrants (quadrants **1** and **4**) **of FIG. 24B.**

**FIGs. 25A** and **25B** each illustrate a plot of the alpha current (Iα) vs. beta current (Iβ) using the alternating current (AC) output of the first, second, and third paired power switches **15** in the alpha beta transformation in the second reference frame (2f) rotated 120 degrees where there is an open circuit in one of the respective upper and lower third phase W power switches **40, 45.** More specifically **FIG. 25A** illustrates a plot **2570,** after an open circuit fault in upper third phase W power switch **40,** of the alpha current (Iα) vs the beta current (Iβ) using the alternating current (AC) output of the first, second, and third paired power switches **15** in the alpha beta transformation in the second reference frame (2f) rotated 120 degrees (using e.g., Equation No. 2). As can be seen in **FIG. 25A** the plot **2570** traces a semicircular shape where the beta current (Iβ) changes positive and negative while the alpha current (Iα) also changes positive and negative. That is, the alpha current (Iα) vs the beta current (Iβ) plot **2570** of the upper third phase W power switch **40** having an open circuit fault overlaps, crosses over into, and/or dissects three quadrants (quadrants **1, 3,** and **4**) of **FIG. 25A.** More specifically **FIG. 25B** illustrates a plot **2575,** after an open circuit fault in lower third phase W power switch **45,** of the alpha current (Iα) vs beta current (Iβ) using the alternating current (AC) output of the first, second, and third paired power switches **15** in the alpha beta transformation in second reference frame (2f) rotated 120 degrees (using e.g., Equation No. 2). As can be seen in **FIG. 25B** the plot **2575** traces a semicircular shape where the beta current (Iβ) changes positive and negative while the alpha current (Iα) also changes positive and negative. That is, the alpha current (Iα) vs the beta current (Iβ) plot **2575** of the lower third phase W power switch **45** having an open circuit fault overlaps, crosses over into, and/or dissects three quadrants (quadrants **1, 2** and **3**) of **FIG. 25B.**

**FIGs. 26A - 28B** each illustrate a plot of alpha current (Iα) vs beta current (Iβ) calculated using the alternating current (AC) output of the first, second, and third paired power switches **15** in the alpha beta transformation in a third reference frame (3f) rotated 240 degrees from the first reference frame (e.g., using Equation No. 3 above) where there is an open circuit fault in one of the power switches **15**.

**FIGs. 26A** and **26B** each illustrate a plot of the alpha current (Iα) vs. beta current (Iβ) using the alternating current (AC) output of the first, second, and third paired power switches **15** in the alpha beta transformation in the third reference frame (3f) rotated 240 degrees where there is an open circuit in one of the respective upper and lower first phase U power switches **20, 25**. More specifically **FIG. 26A** illustrates a plot **2670,** after an open circuit fault in upper first phase U power switch **20,** of the alpha current (Iα) vs the beta current (Iβ) using the alternating current (AC) output of the first, second, and third paired power switches **15** in the alpha beta transformation in a third reference frame (3f) rotated 240 degrees (using e.g., Equation No. 3). As can be seen in **FIG. 26A** the plot **2670** traces a semicircular shape where the beta current (Iβ) changes positive and negative while the alpha current (Iα) also changes positive and negative. That is, the alpha current (Iα) vs the beta current (Iβ) plot **2670** of the upper first phase U power switch **20** having an open circuit fault overlaps, crosses over into, and/or dissects three quadrants (quadrants **1, 3** and **4**) of **FIG. 26A.** More specifically **FIG. 26B** illustrates a plot **2675,** after an open circuit fault in lower first phase U power switch **25,** of the alpha current (Iα) vs beta current (Iβ) using the alternating current (AC) output of the first, second, and third paired power switches **15** in the alpha beta transformation in the third reference frame (3f) rotated 240 degrees (using e.g., Equation No. 3). As can be seen in **FIG. 26B** the plot **2675** traces a semicircular shape where the beta current (Iβ) changes positive and negative while the alpha current (Iα) also changes positive and negative. That is, the alpha current (Iα) vs the beta current (Iβ) plot **2675** of the lower first phase U power switch **25** having an open circuit fault overlaps, crosses over into, and/or dissects three quadrants (quadrants **1, 2** and **3**) of **FIG. 26B.**

**FIGs. 27A** and **27B** each illustrate a plot of the alpha current (Iα) vs. beta current (Iβ) using the alternating current (AC) output of the first, second, and third paired power switches **15** in the alpha beta transformation in the third reference frame (3f) rotated 240 degrees where there is an open circuit in one of the respective upper and lower second phase V power switches **30, 35.** More specifically **FIG. 27A** illustrates a plot **2770,** after an open circuit fault in upper second phase V power switch **30,** of the alpha current (Iα) vs the beta current (Iβ) using the alternating current (AC) output of the first, second, and third paired power switches **15** in the alpha beta transformation in the third reference frame (3f) rotated 240 degrees (using e.g., Equation No. 3). As can be seen in **FIG. 27A** the plot **2770** traces a semicircular shape where the beta current (Iβ) changes positive and negative while the alpha current (Iα) also changes positive and negative. That is, the alpha current (Iα) vs the beta current (Iβ) plot **2770** of the upper second phase V power switch **30** having an open circuit fault overlaps, crosses over into, and/or dissects into three quadrants (quadrants **1, 2** and **4**) of **FIG. 27A.** More specifically **FIG. 27B** illustrates a plot **2775,** after an open circuit fault in lower second phase V power switch **35,** of the alpha current (Iα) vs beta current (Iβ) using the alternating current (AC) output of the first, second, and third paired power switches **15** in the alpha beta transformation in the third reference frame (3f) rotated 240 degrees (using e.g., Equation No. 3). As can be seen in **FIG. 27B** the plot **2775** traces a semicircular shape where the beta current (Iβ) changes positive and negative while the alpha current (Iα) also changes positive and negative. That is, the alpha current (Iα) vs the beta current (Iβ) plot **2775** of the lower second phase V power switch **35** having an open circuit fault overlaps, crosses over into, and/or dissects three quadrants (quadrants **2, 3** and **4**) of **FIG. 27B.**

**FIGs. 28A** and **28B** each illustrate a plot of the alpha current (Iα) vs. beta current (Iβ) using the alternating current (AC) output of the first, second, and third paired power switches **15** in the alpha beta transformation in the third reference frame (3f) rotated 240 degrees where there is an open circuit in one of the respective upper and lower third phase W power switches **40, 45.** More specifically **FIG. 28A** illustrates a plot **2870,** after an open circuit fault in upper third phase W power switch **40,** of the alpha current (Iα) vs the beta current (Iβ) using the alternating current (AC) output of the first, second, and third paired power switches **15** in the alpha beta transformation in the third reference frame (3f) rotated 240 degrees (using e.g., Equation No. 3). As can be seen in **FIG. 28A** the plot **2870** traces a semicircular shape where the beta current (Iβ) changes both positive and negative while the alpha current (Iα) remains negative. That is, the alpha current (Iα) vs the beta current (Iβ) plot **2870** of the upper third phase W power switch **40** having an open circuit fault overlaps, crosses over into, and/or dissects two quadrants (**2** and **3**) of **FIG. 28A.** More specifically **FIG. 28B** illustrates a plot **2875,** after an open circuit fault in lower third phase W power switch **45,** of the alpha current (Iα) vs beta current (Iβ) using the alternating current (AC) output of the first, second, and third paired power switches **15** in the alpha beta transformation in third reference frame (3f) rotated 240 degrees (using e.g., Equation No. 3). As can be seen in **FIG. 28B** the plot **2875** traces a semicircular shape where the beta current (Iβ) changes both positive and negative while the alpha current (Iα) remains positive. That is, the alpha current (Iα) vs the beta current (Iβ) plot **2875** of the lower third phase W power switch **45** having an open circuit fault overlaps, crosses over into, and/or dissects two quadrants (quadrants **1** and **4**) of **FIG. 28B.**

As can be seen by **FIGs. 20A-28B** open circuit faults of power switches used to produce multiphase AC output power, including three phase AC output power, can be determined by looking at the signs (positive, negative, or both positive and negative) of the alpha current (Iα) vs. beta current (Iβ) in the three different reference frames, e.g., a first traditional alpha-beta transformation reference frame (1f) with no rotation (using the multiphase currents in e.g., Equation No. 1), a second alpha-beta transformation reference frame (2f) rotated 120 degrees (using the multiphase currents in e.g., Equation No. 2) and a third alpha-beta transformation reference frame (3f) rotated 240 degrees (using the multiphase currents in e.g., Equation No. 3). Open circuits of upper and lower first phase U power switches **20, 25** can be detected in the first (traditional) reference frame (1f) with no rotation (using e.g., Equation No. 1). This open circuit fault criteria for the first reference frame (1f) is summarized in Table 4 below and in **FIG. 29A**:

Table 4:

| Condition | Fault |
|---|---|
| $I_\alpha > 0$ | Lower Switch U |
| $I_\alpha < 0$ | Upper Switch U |

Open circuits of upper and lower phase V power switches **30, 35** can be detected in the second reference frame (2f) rotated 120 degrees from the first reference frame (1f) using Equation No. 2. This open circuit fault criteria for the second reference frame (2f) is summarized in Table 5 below and in **FIG. 29B**:

Table 5:

| Condition | Fault |
|---|---|
| $I_\alpha > 0$ | Lower Switch V |
| $I_\alpha < 0$ | Upper Switch V |

Open circuits of upper and lower third phase W power switches **40, 45** can be detected in the third reference frame (3f) rotated 240 degrees from the first reference frame (1f) using Equation No. 3. This open circuit fault criteria for the third reference frame (3f) is summarized in Table 6 below and in **FIG. 29C**:

Table 6:

| Condition | Fault |
|---|---|
| $I_\alpha > 0$ | Lower Switch W |
| $I_\alpha < 0$ | Upper Switch W |

As can be seen by Table 4 and **FIG. 29A** (and **FIGs. 20A-22B**), an upper first phase U power switch (e.g., switch **20**) open circuit fault would be demonstrated by the alpha current ($I\alpha$) calculated using the first frame (1f) alpha beta transformation (e.g., Equation No. 1) being less than zero (remaining negative) and a lower first phase U power switch (e.g., switch **25**) open circuit fault would be demonstrated by the alpha current ($I\alpha$) calculated using the first frame (1f) alpha beta transformation (e.g., Equation No. 1) being greater than zero (remaining positive). As can be seen by Table 5 and **FIG. 29B** (and **FIGs. 23A-25B**), an upper second phase V power switch (e.g., switch **30**) open circuit fault would be demonstrated by the alpha current ($I\alpha$) calculated using the second frame (2f) alpha beta transformation (e.g., Equation No. 2) being less than zero (remaining negative positive) and a lower second phase V power switch (e.g., switch **35**) open circuit fault would be demonstrated by the alpha current ($I\alpha$) calculated using the second frame (2f) alpha beta transformation (e.g., Equation No. 2) being greater than zero (remaining positive). As can be seen by Table 6 and **FIG. 29C** (and **FIGs. 26A-28B**), an upper third phase W power switch (e.g., switch **40**) open circuit fault would be demonstrated by the alpha current ($I\alpha$) calculated using the third frame (3f) alpha beta transformation (e.g., Equation No. 3) being less than zero (remaining negative) and a lower third phase W power switch (e.g., switch **45**) open circuit fault would be demonstrated by the alpha current ($I\alpha$) calculated using the third frame (1f) alpha beta transformation (e.g., Equation No. 3) being greater than zero (remaining positive). In this manner, the open circuits in upper and lower paired power switches **20, 25, 30, 35, 30, 45** can be determined using Tables 4-6 and **FIGs. 29A-29C** (and **FIGs. 20A-28B**).

To detect whether there is an open circuit fault in any of the power switches in the inverter/converter circuitry (e.g., power switches **20, 25, 30, 35, 40, 45** in inverter/convert circuitry 10), one approach includes in addition to checking the alpha current ($I\alpha$) in three different reference frames, checking whether the absolute value of the voltage ($V_{abs}$) (using the value of the alpha voltage ($V\alpha$) and the beta voltage ($V\beta$)) is higher than the maximum voltage Vlim that the inverter can deliver (e.g., is Vabs > Vlim). Tracking whether (Vabs) > (Vlim) in an embodiment is a check against noise in the system creating false readings. Vlim is the minimum voltage threshold that is found via simulation or experiments by running open short switch fault scenarios at different operating points (speed v. torque) to define the minimum voltage level in each fault scenario. Vlim is found to be proportional to the motor speed ($\omega$) by a factor *k*. i.Vlim=$k*\omega$ → **Equation No. 4**

where factor k is a proportional gain that will depend on the inverter and motor configuration, as well as on the system configuration (Volts/RPM) and motor speed ($\omega$) is in revolutions per minute (RPM).

Vabs is calculated using the alpha beta transformation in the first traditional/stationary time frame. In this regard alpha voltage (Vα) and the beta voltage (Vβ) use the following equations:

$$\begin{cases} V_\alpha = \frac{2}{3}V_u - \frac{1}{3}V_v - \frac{1}{3}V_w \\ V_\beta = \frac{1}{\sqrt{3}}V_v - \frac{1}{\sqrt{3}}V_w \end{cases} \rightarrow \textbf{Equation No. 5}$$

The alpha voltage (Vα) and the beta Voltage (Vβ) are calculated using the voltage output of the three phases (phases U, V, W) of the inverter/converter circuit (e.g., inverter/converter circuitry **10**).

The inverter/converter circuit **10** shown in **FIG. 1** shows voltage sensor **62** which measures the voltage output Vu **63** of the first phase U, voltage sensor **64** which measures the voltage output Vv **65** of the second phase V, and voltage sensor **66** which measures the voltage output Vw **67** of the third phase W. **FIG. 30** shows the voltage output of inverter circuitry **10** for each AC power phase output, including Vu **63**, Vv **65**, and Vw **67,** over time. These voltage measurements Vu **63**, Vv **65**, and Vw **67** are used in Equation Nos. 4 and 5 to calculate the alpha voltage (Vα) and the beta Voltage (Vβ). **FIG. 31** shows a plot of the alpha voltage (Vα) and the beta voltage (Vβ) calculated using the voltages Vu **63**, Vv **65,** and Vw **67** in the alpha beta transformation Equation No. 5. The alpha voltage (Vα) and the beta Voltage (Vβ) are used to calculate the Vabs using the following equation:

$$V_{abs} = \sqrt{V_\alpha{}^2 + V_\beta{}^2} \rightarrow \textbf{Equation No. 6}$$

Where Vabs is equal to the square root of both the alpha voltage squared (Vα)² plus the beta voltage squared (Vβ)².

If the Vabs is greater than the maximum voltage (Vlim) produced by the inverter/converter circuitry (Vabs > Vlim) and one of the alpha current (Iα) conditions for an open circuit fault are met, then there is an open circuit fault. **FIG. 32** shows a diagram of the alpha voltage (Vα), the beta Voltage (Vβ), the absolute voltage (Vabs) based upon the alpha voltage (Vα) and the beta Voltage (Vβ) and the Voltage limit (Vlim) of the inverter/converter circuitry over time. As can be seen in **FIG. 32** the absolute voltage (Vabs) based upon the alpha voltage (Vα) and the beta voltage (Vβ) is greater than the voltage limit (Vlim) that the inverter circuitry is capable of producing.

As can be appreciated the current measurements **53** (Iu), **55** (Iv), **57** (Iw) can be used to calculate the alpha current (Iα) and the beta current (Iβ) calculations using the alpha-beta transformation equations Nos. 1, 2, 3, and the respective current sensors **52, 54, 56** can be located within the power converter and/or motor controller (e.g., within a housing where the inverter/converter circuitry is located) or in a location outside the motor controller housing (e.g., a remote location). In addition, the alpha-beta transformation calculations using the current measurements to obtain the alpha current (Iα) and the beta current (Iβ) can be performed within the power converter and/or motor controller (e.g., within a housing where the inverter/converter circuitry is located) or in a location outside the power converter and/or motor controller housing. For example, the alpha-beta transformation calculations can be performed using a processing element in connection with memory containing the alpha-beta transformation equations (e.g., equations Nos. 1-3). The processing element and memory can be located within the power converter and/or motor controller (e.g., within a housing where the inverter/converter circuitry is located) or in a location outside the housing of the power converter and/or motor controller, and in an approach the processing element and memory can be located on a controller board in the power converter and/or motor controller.

As can be appreciated the voltage measurements **63** (Vu), **65** (Vv), **67** (Vw) can be used to calculate the alpha voltage (Vα) and the beta voltage (Vβ) calculations using the alpha-beta transformation equations Nos. 5, 6, and the respective voltage sensors **62, 64, 66** can be located within the power converter and/or motor controller (e.g., within a housing where the inverter/converter circuitry is located) or in a location outside the housing of the power converter and/or motor controller. In addition, the alpha-beta transformation calculations using the voltage measurements to obtain the alpha voltage (Vα) and the beta voltage (Vβ) can be performed within the power converter and/or motor controller (e.g., within a housing where the inverter/converter circuitry is located) or in a location outside the housing of the power converter and/or motor controller. For example, the alpha-beta transformation calculations can be performed using a processing element in connection with memory containing the alpha-beta transformation equations (e.g., equations Nos. 5, 6). The processing element and memory can be located within the power converter and/or motor controller (e.g., within a housing where the inverter/converter circuitry is located) or in a location outside the housing of the power converter and/or motor controller, and in an approach the processing element and memory can be located on a controller board in the power supply and/or motor controller.

The disclosure provides a system, method, and computing program product that can be implemented in a number of different embodiments. In this regard, a method and/or technique is provided in the flow chart of **FIG. 33** for detecting a type of fault in a power switch where multiple power switches are utilized to convert DC voltage to AC voltage, and which in an embodiment further determines the type of fault (e.g., an open circuit fault or a short circuit fault) and in an approach further identifies the specific power switch out of the multiple switches that failed. **FIG. 33** outlines an exemplary flowchart in accordance with various embodiments illustrating and describing a method **3300** of detecting a fault in a power switch among multiple power switches configured to change DC voltage to AC voltage, preferably multiphase AC output power including three (3) phase multiphase AC output power, and in an approach identifying the specific switch out of the multiple power switches that failed. While the method **3300** is described for the sake of convenience and not with an intent of limiting the disclosure as comprising a series and/or a number of steps, it is to be understood that the process **3300** does not need to be performed as a series of steps and/or the steps do not need to be performed in the order shown and described with respect to **FIG. 33,** but the process **3300** can be integrated and/or one or more steps can be performed together, simultaneously, or the steps can be performed in the order disclosed or in an alternate order.

In process **3300, at 3310** alternating current (AC) values (e.g., measurements) of each phase of a multiphase output of inverter/converter circuitry using multiple power switches is received. In an approach, current measurements are taken at **3305** of the AC output power of each phase of inverter/converter circuity (e.g., inverter/converter circuitry **10**) that uses multiple power switches (e.g., power switches **15**), preferably each phase of AC output power of three phase (e.g., phases U, V, W) inverter/converter circuitry that uses for example six power switches where in an approach two paired power switches are used to produce each phase of AC output power. The current measurements taken at **3305** are sent to and received by circuitry configured to receive the current measurements of the respective phases of AC output power generated and output by the inverter/converter circuitry implemented using multiple power switches.

At **3320** voltage values (e.g., measurements) of each phase of a multiphase output of inverter/converter circuitry using multiple power switches is received. In an approach, voltage measurements are made at **3315** of the AC output power of each phase of inverter/converter circuity (e.g., inverter/converter circuitry **10**) that uses multiple power switches (e.g., power switches **15**), preferably each phase of AC output power of three phase (e.g., phases U, V, W) inverter/-converter circuitry that uses for example six power switches where in an approach two paired power switches are used to produce each phase of AC output power. The voltage measurements taken at **3315** are sent to and received by circuitry configured to receive the voltage measurements of the respective phases of AC output power generated and output by the inverter/converter circuitry implemented using multiple power switches.

At **3330** the current measurements are used to perform alpha-beta transformation calculations in three different reference frames (1f, 2f, 3f). Preferably the three different reference frames include a first traditional alpha beta transformation reference frame (1f) with no rotation (e.g., at zero degrees of rotation), a second alpha beta transformation reference frame (2f) rotated 120 degrees in a first (e.g., clockwise) direction from the first reference frame (1f), and a third alpha-beta transformation reference frame (3f) rotated 240 degrees in the first (e.g., clockwise) direction from the first reference frame (1f). In one or more approaches, the current measurements of the multiphase AC output, e.g., the three phases of AC output (phase U, V, W), are used in equations Nos. 1-3 to calculate and/or determine the alpha current and beta current in the three different reference frames (1f, 2f, 3f). In one or more approaches the alpha-beta transformation calculations in the three reference frames are performed in circuitry used to control the inverter/converter circuitry, e.g., on a controller board, that includes a processor or processing element where the alpha-beta transformation equations, e.g., equations 1-3, are stored in memory associated with and/or located on the controller board.

At **3340** the alpha currents ($I\alpha$) and the beta currents ($I\beta$) calculated in the three different reference frames are checked, including checking and/or determining whether the alpha currents ($I\alpha$) and beta currents ($I\beta$) remain positive, remain negative, and/or change between positive and negative over one or more cycles of AC power output. That is, in one or more embodiments, at **3340,** the signs of the alpha currents and the beta currents are checked in all three reference frames to determine if they remain positive, remain negative, or change between positive and negative. In other words, it is checked at **3340** to see if the alpha currents and/or beta currents calculated in the three different reference frames (1f, 2f, 3f) change between positive and negative.

In one or more embodiments, at **3340** the alpha currents ($I\alpha$) are calculated and checked in the first, second, and/or third reference frames (1f, 2f, 3f) to determine whether the alpha currents ($I\alpha$) remain positive over one or more cycles of AC output power, remain negative over one or more cycles of AC output power, or change between positive and negative over one or more cycles of AC output power. That is, at **3340** in an approach, the alpha current ($I\alpha$) in the first reference frame (1f) is calculated and checked (e.g., tracked) to determine whether the alpha current ($I\alpha$) in the first reference frame (1f) remains positive, remains negative, or changes between positive and negative; the alpha current ($I\alpha$) in the second reference frame (2f) is calculated and checked (e.g., tracked) to determine whether the alpha current ($I\alpha$) in the second reference frame (2f) remains positive, remains negative, or changes between positive and negative; and alpha current ($I\alpha$) in the third reference frame (3f) is calculated and checked (e.g., tracked) to determine whether the alpha current ($I\alpha$) in the third reference frame (3f) remains positive, remains negative, or changes between positive and negative.

In one or more embodiments, at **3340,** the beta currents ($I\beta$) are calculated and checked in the first, second, and/or third reference frames (1f, 2f, 3f) to determine whether the beta currents (Iβ) remain positive over one or more cycles of AC output power, remain negative over one or more cycles of AC output power, or change between positive and negative over one or more cycles of AC output power. That is, at **3340** in an approach, the beta current (Iβ) in the first reference frame (1f) is calculated and checked (e.g., tracked) to determine whether the beta current (Iβ) in the first reference frame (1f) remains positive, remains negative, or changes between positive and negative; the beta current (Iβ) in the second reference frame (2f) is calculated and checked (e.g., tracked) to determine whether the beta current (Iβ) in the second reference frame (2f) remains positive, remains negative, or changes between positive and negative; and beta current (Iβ) in the third reference frame (3f) is calculated and checked (e.g., tracked) to determine whether the beta current (Iβ) in the third reference frame (3f) remains positive, remains negative, or changes between positive and negative.

At **3350,** determine whether there is a short circuit fault based upon the signs of the alpha currents (Iα) and/or beta currents (Iβ) in anyone of the three reference frames (1f, 2f, 3f). In an approach, at **3350,** in response to anyone of the calculated alpha currents (Iα) and/or beta currents (Iβ) in anyone of the three reference frames (1f, 2f, 3f) remaining positive and/or remaining negative then, for example, the conditions specified in Tables 1-3, are used at **3555** to determine if there is a short circuit fault. That is, in an example embodiment, at **3350,** in response to the calculated alpha current (Iα) in the first reference frame (1f) remaining positive or remaining negative and the calculated beta current (Iβ) in the first reference frame (1f) remaining positive or remaining negative, then the conditions specified in Table 1 are checked and/or used to detect if there is a short circuit fault in either the upper and lower paired phase V power switches or upper and lower paired phase W power switches. That is, in an example embodiment, at **3350,** in response to the calculated alpha current (Iα) in the second reference frame (2f) remaining positive or remaining negative and the calculated beta current (Iβ) in the second reference frame (2f) remaining positive or remaining negative, then the conditions in Table 2 are checked and/or used to detect if there is a short circuit fault in either the upper and lower paired phase U power switches or upper and lower paired phase W power switches. That is, in an example embodiment, at **3350,** in response to the calculated alpha current (Iα) in the third reference frame (3f) remaining positive or remaining negative and the calculated beta current (Iβ) in the third reference frame (3f) remaining positive or remaining negative, then the conditions specified in Table 3 are checked and/or used to detect if there is a short circuit fault in either the upper and lower paired phase U power switches or upper and lower paired phase V power switches.

For example, if in the first reference frame (1f) Iα > 0 & Iβ > 0 and/or in the second reference frame (2f) Iα > 0 & Iβ < 0, then there is a short circuit in the lower Switch W (switch **45**). That is, if in the first reference frame (1f) Iα > 0 & Iβ > 0 then there is a short circuit fault in the lower Switch W (switch **45**) and as a verification the second reference frame (2f) can be checked to see if Iα > 0 & Iβ < 0, or vice versa, to confirm the short circuit in the lower Switch W (switch **45**). In another example, if in the second reference frame (2f) Iα > 0 & Iβ > 0 and/or in the third reference frame (3f) Iα > 0 & Iβ < 0, then there is a short circuit in the lower Switch U (switch **25**). That is, if in the second reference frame (2f) Iα > 0 & Iβ > 0 then there is a short circuit in the lower Switch U (switch **25**) and as a verification the third reference frame (3f) can be checked to see if Iα > 0 & Iβ < 0, or vice versa, to confirm there is a short circuit in the lower Switch U (switch **25**). In another approach, if in the first reference frame (1f) Iα > 0 & Iβ < 0 and/or in the third reference frame (3f) Iα > 0 & Iβ > 0, then there is a short circuit in the lower Switch V (switch **35**). That is, if in the first reference frame (1f) Iα > 0 & Iβ < 0 then there is a short circuit in the Lower Switch V (switch 35), and as a verification the third reference frame can be checked to see if (3f) Iα > 0 & Iβ > 0, or vice versa, to confirm there is a short circuit in the lower Switch V (switch **35**). The same calculations and reference to the condition criteria of Tables 1-3 would be used to determine if there are short circuits in the upper switches **20, 30, 40.**

At **3360,** determine whether there is a potential open circuit fault based upon the signs of the alpha currents (Iα) in anyone of the three reference frames (1f, 2f, 3f). In an approach, at **3360,** in response to anyone of the calculated alpha currents (Iα) in anyone of the three reference frames (1f, 2f, 3f) remaining positive and/or remaining negative then the conditions specified in tables, for example, tables 4-6, are used at **3365** to determine if there is a potential open circuit fault. That is, in an example embodiment, at **3360,** in response to the calculated alpha current (Iα) in the first reference frame (1f) remaining positive or remaining negative, then the conditions specified in Table 4 are checked and/or used to detect if there is a potential open circuit fault in either the upper and lower paired phase U power switches. That is, in an example embodiment, at **3360,** in response to the calculated alpha current (Iα) in the second reference frame (2f) remaining positive or remaining negative, then the conditions in Table 5 are checked and/or used to detect if there is a potential open circuit fault in either the upper and lower paired phase V power switches. That is, in an example embodiment, at **3360,** in response to the calculated alpha current (Iα) in the third reference frame (3f) remaining positive or remaining negative, then the conditions of Table 6 are checked and/or used to detect if there is a potential open circuit fault in either the upper and lower paired phase W power switches.

At **3370,** in an embodiment, it is determined whether the absolute voltage (Vabs) is greater than the Vlim (e.g., is Vabs>Vlim), where the absolute voltage (Vabs) is basically the voltage amplitude of the alpha voltage (Vα) and the beta voltage (Vβ) calculated using the voltage output of the inverter/converter circuit (the voltage measurements of each of the multiphase AC output power) and the Vlim is the minimum voltage that the inverter/converter circuitry can deliver (e.g., the minimum inverter/converter circuitry at a specific speed of the motor). That is, in an approach at **3370,** calculations are performed to determine if Vabs is greater than Vlim (Vabs>Vlim). In an example approach, at **3375,** Vabs is determined and/or calculated using the alpha voltage ($V\alpha$) and the beta voltage ($V\beta$) calculated using the received voltage output measurements of the inverter/converter circuitry in the alpha beta transformation equations 4 and 5. More specifically in an embodiment Vabs at **3375** is calculated using Equation No. 5 and the alpha voltage ($V\alpha$) (obtained/calculated from Equation No. 4) and the beta voltage ($V\beta$) (obtained/calculated from Equation No. 4). In an embodiment Vabs, is then compared to Vlim at **3370** to determine if Vabs is larger than Vlim, where Vlim is the maximum voltage produced by the inverter/converter circuitry. In an embodiment Vlim is the minimum voltage threshold that is found via simulation or experiments by running open and short switch fault scenarios at different operating points (speed v. torque) to define the minimum voltage level in each fault scenario. Vlim is found to be proportional to the motor speed ($\omega$) by a factor $k$ (Vlim=$k*\omega$), where factor k is a proportional gain that will depend on the inverter and motor configuration, as well as on the system configuration (Volts/RPM) and motor speed ($\omega$) is in revolutions per minute (RPM). If Vabs is greater than Vlim (Vabs>Vlim:Yes), then the open circuit fault as determined by the alpha currents and the lookup tables Nos. 4-6 is confirmed.

It will be understood that one or more blocks of the flowchart illustrations in **FIG. 33,** and combinations of blocks in the flowchart illustration, can be implemented by computer program instructions. These computer program instructions may be provided to a processor or other programmable data processing apparatus to produce a machine, such that the instructions which execute on the processor or other programmable data processing apparatus create means for implementing the functions specified in the flowchart block or blocks. These computer program instructions may also be stored in a computer-readable memory or storage medium that can direct a processor or other programmable data processing apparatus to function in a particular manner, such that the instructions stored in the computer-readable memory or storage medium produce an article of manufacture including instruction means which implement the functions specified in the flowchart block or blocks. A computer readable storage medium, as used herein, is not to be construed as being transitory signals per se, such as radio waves or other freely propagating electromagnetic waves, electromagnetic waves propagating through a waveguide or other transmission media (e.g., light pulses passing through a fiber-optic cable), or electrical signals transmitted through a wire. Accordingly, blocks of the flowchart illustration support combinations of means for performing the specified functions, combinations of steps for performing the specified functions, and program instruction means for performing the specified functions. It will also be understood that each block of the flowchart illustration, and combinations of blocks in the flowchart illustration, can be implemented by special purpose hardware-based computer systems which perform the specified functions or steps, or by combinations of special purpose hardware and computer instructions.

Disclosed is a method, technique, platform, system, and/or programming instructions for detecting a fault in a power switch in a circuit, preferably an inverter circuit, for converting direct current (DC) to multiphase alternating current (AC) output power where the circuit comprises a plurality of power switches, the method comprising: calculating alpha currents and beta currents in each of a multiple of different reference frames using respective alpha-beta transformations in each of the multiple of different reference frames; checking the signs of the alpha currents calculated in each of the multiple of different reference frames; checking the signs of the beta currents calculated in each of the multiple of different reference frames; and determining, based upon the signs of the alpha currents and the beta currents calculated in each of the multiple of different reference frames, whether a short circuit fault occurred in one of the plurality of power switches. The method, technique, platform, system, and/or programming instructions according to an approach further includes identifying, based upon the signs of the alpha currents and the beta currents calculated in each of the multiple different reference frames, the specific power switch out of the plurality of power switches that had the short circuit fault. In an embodiment the method, technique, platform, system, and/or programming instructions can further include: receiving current values of each multiphase AC output of the circuit; and using the alternating current values to calculate the alpha current and the beta current in each of the multiple different reference frames. In an arrangement of the method, technique, platform, system, and/or programming instructions the number of multiple different reference frames is equal to the number of phases of multiphase AC output power of the circuit. In a further configuration of the method, technique, platform, system, and/or programming instructions the number of phases of multiphase AC output power of the circuit is three (3) phases and the number of multiple different reference frames is three (3) reference frames. In a further embodiment, each of the multiple different reference frames is rotated with respect to an adjacent different reference frame, and optionally the three different reference frames are rotated in the same direction 120 degrees from each adjacent reference frame. In yet another embodiment, each of the multiple different reference frames are rotated 360 degrees divided by the number of phases of multiphase AC output power of the inverter circuit with respect to the adjacent different reference frame.

The method, technique, platform, system, and/or programming instructions can in an approach further include determining, based upon the signs of the alpha currents calculated in each of the multiple different reference frames, whether an open circuit fault or potential open circuit fault occurred in one of the plurality of power switches. In a further approach, the method, technique, platform, system, and/or programming instructions can further include confirming whether the open circuit fault or the potential open circuit fault occurred in one of the plurality of power switches. In one or more embodiments, confirming whether the open circuit fault or potential open circuit fault occurred in one of the plurality of power switches further includes: determining the absolute voltage using the alpha voltage and the beta voltage; and determining if the absolute voltage is greater than the minimum voltage (Vlim) output by the circuit. The minimum voltage (Vlim) in an embodiment is the minimum voltage threshold of the circuit by running open and short switch fault scenarios at different operating points (speed v. torque) to define the minimum voltage level in each fault scenario, where Vlim equals a factor k times motor speed $\omega$ in revolutions per minute (Vlim = $k*\omega$) where factor $k$ is a proportional gain that will depend upon the circuit and motor configuration, as well as on the system configuration (Volts/RPM) and $\omega$ is motor speed in revolutions per minute (RPM). The method, technique, platform, system, and/or programming instructions can further include identifying, based upon the signs of the alpha currents in each of the multiple different reference frames, the specific power switch out of the plurality of power switches that had the open circuit fault or the potential open circuit fault.

A method, technique, platform, system, and/or programming instructions for detecting a fault in a power switch in a circuit, preferably an inverter circuit) for converting direct current (DC) to multiphase alternating current (AC) output power, where the circuit comprises a plurality of power switches, can in one or more embodiments include: calculating alpha currents in each of a multiple of different reference frames using respective alpha-beta transformations in each of the multiple of different reference frames; checking the signs of the alpha currents calculated in each of the multiple of different reference frames; and determining based upon the signs of the alpha currents calculated in each of the multiple of different reference frames whether an open circuit fault or a potentially open circuit fault occurred in one of the plurality of power switches. The method, technique, platform, system, and/or programming instructions can according to an approach further include confirming whether the open circuit fault or the potential open circuit fault occurred in one of the plurality of power switches. Confirming whether the open circuit fault or the potential open circuit fault occurred in one of the plurality of power switches according to an embodiment further includes: determining the absolute voltage using the alpha voltage and the beta voltage; and determining if the absolute voltage is greater than the minimum voltage (Vlim) output by the circuit. In a further aspect, the method, technique, platform, system, and/or programming instructions can further include identifying, based upon the signs of the alpha currents calculated in each of the multiple different reference frames, the specific power switch out of the plurality of power switches that had the open circuit fault or the potential open circuit fault. The method, technique, platform, system, and/or programming instructions in a configuration can further include: receiving current values of each multiphase AC output power of the circuit; and using the alternating current values to calculate the alpha current and the beta current in each of the multiple different reference frames.

The method, technique, platform, system, and/or programming instructions can further include: calculating beta currents in each of the multiple of different reference frames using the respective alpha-beta transformations in each of the multiple of different reference frames; checking the signs of the beta currents calculated in each of the multiple of different reference frames; and determining, based upon the signs of the alpha currents and the beta currents calculated in each of the multiple of different reference frames, whether a short circuit fault occurred in one of the plurality of power switches. The method, technique, platform, system, and/or programming instructions in an embodiment can further include identifying, based upon the signs of the alpha currents and the beta currents in each of the multiple different reference frames, the specific power switch out of the plurality of power switches that had the short circuit fault.

A system for detecting a fault in a power switch in a circuit, preferably an inverter circuit, for converting direct current (DC) to multiphase alternating current (AC) output power where the circuit comprises a plurality of power switches is disclosed, the system in one or more embodiments is configured to: calculate at least one of alpha currents, beta currents, and combinations thereof in each of a multiple of different reference frames using respective alpha-beta transformations in each of the multiple of different reference frames; check the signs of the alpha currents, the beta currents, and the combinations thereof calculated in each of the multiple of different reference frames; and determine, based upon the signs of at least one of the alpha currents, the beta currents, and the combinations thereof calculated in each of the multiple of different reference frames, whether one of a short circuit fault or an open circuit fault occurred in one of the plurality of power switches.

The system in an embodiment is further configured to identify, based upon the signs of the at least one of the alpha currents, the beta currents, and the combinations thereof calculated in each of the multiple different reference frames, the specific power switch out of the plurality of power switches that had the short circuit fault or the open circuit fault. In one or more arrangements, the system is further configured to: receive current values of each multiphase AC output of the circuit; and using the alternating current values to calculate the at least one of the alpha currents, the beta current, and the combinations thereof in each of the multiple different reference frames.

In an approach, the system is further configured to determine, based upon the signs of the alpha currents and the beta currents calculated in each of the multiple different reference frames, whether a short circuit fault occurred in one of the plurality of power switches. In yet a further approach, the system is further configured to determine, based upon the signs of the alpha currents calculated in each of the multiple different reference frames, whether an open circuit fault or potential open circuit fault occurred in one of the plurality of power switches, and in a further embodiment is configured to confirm whether the open circuit fault or the potential open circuit fault occurred in one of the plurality of power switches. The system in an embodiment is further configured to identify, based upon the signs of the alpha currents in each of the multiple different reference frames, the specific power switch out of the plurality of power switches that had the open circuit fault or the potential open circuit fault. Configuring the system to confirm whether the open circuit fault or potential open circuit fault occurred in one of the plurality of power switches includes in an embodiment configuring the system to: determine the absolute voltage using the alpha voltage and the beta voltage; and determine if the absolute voltage is greater than the minimum voltage (Vlim) output by the circuit.

Those skilled in the art will recognize that the disclosed and illustrated system, technique, platform, and/or programming product has many applications, may be implemented in various manners and, as such is not to be limited by the foregoing embodiments and examples, but it is intended to cover modifications within the spirit and scope of the invention. For example, use of the disclosed systems, techniques, methods, platforms, and/or programming products can have application in and be implemented in aviation applications (e.g., airplanes, helicopters) and/or electric motor applications, including electric vehicles. In one or more embodiments, the systems, techniques, methods, platforms, and/or programming products can have application in and be implemented where multiphase, including three (3) phase, inverter/converter circuitry includes multiple power switches.

While fundamental features of the invention have been shown and described in exemplary embodiments, using for example three phase inverter/converter circuitry, it will be understood that omissions, substitutions, and changes in the form and details of the disclosed systems, techniques, methods, platforms, and/or programming products can be made by those skilled in the art without departing from the spirit of the invention. For example, the inverter/converter circuitry in **FIG. 1** is configured to produce three phases (phases U, V, W) of multiphase AC output power using three paired power switches (six (6) power switches), however the disclosure is not limited to three (3) phase multiphase inverter/converter circuits using multiple power switches and it is contemplated that the disclosed technique may have application to and be implemented in a multiphase circuit, for example in circuitry using power switches to produce dual phases, four phases, five phases, or six phases, or more. For example, the disclosure may be used to detect faults in power switches in inverter/converter circuitry using more than six (6) power switches and/or producing six phases (e.g., six (6) paired power switches) of AC output power where for example multiple reference frames of the alpha beta transformation are used where each of the references frames are rotated in a first direction (e.g., clockwise direction) from an adjacent reference frame. Any number of the features of the different embodiments described herein may be combined into a single embodiment and/or the locations of particular elements, for example, the current and/or voltage sensors, the location of the calculations performed, the use of the conditions specified in the condition tables, may be altered.

Computer readable program instructions for carrying out operations of the present disclosure may be assembler instructions, instruction-set-architecture (ISA) instructions, machine instructions, machine dependent instructions, microcode, firmware instructions, state-setting data, or either source code or object code written in any combination of one or more programming languages, including an object oriented programming language such as Smalltalk, C++ or the like, and conventional procedural programming languages, such as the "C" programming language or similar programming languages. The computer readable program instructions may execute entirely on the computer within the housing of the power converter and/or motor controller, partly on the computer within the housing of the power converter and/or motor controller, as a stand-alone software package, partly on the computer within the housing of the power converter and/or motor controller and partly on a remote computer or entirely on the remote computer or server. In the latter scenario, the remote computer may be connected to the computer within the housing of the power converter and/or motor controller through any type of network. In some embodiments, electronic circuitry including, for example, programmable logic circuitry, field-programmable gate arrays (FPGA), or programmable logic arrays (PLA) may execute the computer readable program instructions by utilizing state information of the computer readable program instructions to personalize the electronic circuitry, in order to perform aspects of the present disclosure.

Aspects of the present disclosure are described herein with reference to flowchart illustrations and/or block diagrams of methods, apparatus (systems), and computer program products according to embodiments of the disclosure. It will be understood that each block of the flowchart illustrations and/or block diagrams, and combinations of blocks in the flowchart illustrations and/or block diagrams, can be implemented by computer readable program instructions. The flowchart and block diagrams in the Figures illustrate the architecture, functionality, and operation of possible implementations of systems, methods, and computer program products according to various embodiments of the present disclosure. In this regard, each block in the flowchart or block diagrams may represent a module, segment, or portion of instructions, which comprises one or more executable instructions for implementing the specified logical function(s). In some alternative implementations, the functions noted in the block may occur out of the order noted in the figures. For example, two blocks shown in succession may be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts or carry out combinations of special purpose hardware and computer instructions.

These computer readable program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks. These computer readable program instructions may also be stored in a computer readable storage medium that can direct a computer, a programmable data processing apparatus, and/or other devices to function in a particular manner, such that the computer readable storage medium having instructions stored therein comprises an article of manufacture including instructions which implement aspects of the function/act specified in the flowchart and/or block diagram block or blocks.

The computer readable program instructions may also be loaded onto a computer, other programmable data processing apparatus, or other device to cause a series of operational steps to be performed on the computer, other programmable apparatus or other device to produce a computer implemented process, such that the instructions which execute on the computer, other programmable apparatus, or other device implement the functions/acts specified in the flowchart and/or block diagram block or blocks.

Moreover, a system according to various embodiments may include a processor and logic integrated with and/or executable by the processor, the logic being configured to perform one or more of the process steps recited herein. By integrated with, what is meant is that the processor has logic embedded therewith as hardware logic, such as an application specific integrated circuit (ASIC), a field programmable gate array (FPGA), etc. By executable by the processor, what is meant is that the logic is hardware logic; software logic such as firmware, part of an operating system, part of an application program; etc., or some combination of hardware and software logic that is accessible by the processor and configured to cause the processor to perform some functionality upon execution by the processor. Software logic may be stored on local and/or remote memory of any memory type, as known in the art. Any processor known in the art may be used, such as a software processor module and/or a hardware processor such as an ASIC, a FPGA, a central processing unit (CPU), an integrated circuit (IC), a graphics processing unit (GPU), etc.

The programs described herein are identified based upon the application for which they are implemented in a specific embodiment of the disclosure. However, it should be appreciated that any particular program nomenclature herein is used merely for convenience, and thus the disclosure should not be limited to use solely in any specific application identified and/or implied by such nomenclature. It will be clear that the various features of the foregoing systems and/or methodologies may be combined in any way, creating a plurality of combinations from the descriptions presented above.

With respect to the above description, it is to be realized that the dimensional relationship for the parts of the system includes variations in size, materials, shape, form, function and the manner of operation as would be known to one skilled in the art, and all equivalent relationships to those illustrated in the drawings and described in the specification are intended to be encompassed by the invention.

In the claims, the term "comprises/comprising" does not exclude the presence of other elements, features, or steps. Furthermore, although individually listed, a plurality of means, elements, or method steps may be implemented by, e.g., a single unit, element, or piece. Additionally, although individual features may be included in different claims, these may advantageously be combined, and their inclusion individually in different claims does not imply that a combination of features is not feasible and/or advantageous. In addition, singular references do not exclude a plurality. The terms "a", "an", "first", "second", etc., do not preclude a plurality. Reference signs or characters in the disclosure and/or claims are provided merely as a clarifying example and shall not be construed as limiting the scope of the claims in any way.

Alternate embodiments are possible that have features in addition to those described herein or may have less than all the features described. Functionality may also be, in whole or in part, distributed among multiple components, in manners now known or to become known. The discussion of any embodiment is meant only to be explanatory and is not intended to suggest that the scope of the disclosure, including the claims, is limited to these embodiments. In other words, while illustrative embodiments of the disclosure have been described in detail herein, it is to be understood that the inventive concepts may be otherwise variously embodied and employed, and that the appended claims are intended to be construed to include such variations, except as limited by the prior art.

The descriptions of the various embodiments of the present disclosure have been presented for purposes of illustration and description, but are not intended to be exhaustive or limited to the embodiments disclosed. The corresponding structures, materials, acts, and equivalents of all means or step plus function elements in the claims below are intended to include any structure, material, or act for performing the function in combination with other claimed elements as specifically claimed. Many modifications and variations will be apparent to those of ordinary skill in the art without departing from the scope and spirit of the described embodiments. The embodiments and examples were chosen and described in order to best explain the principles of the disclosure and the practical application, and to enable others of ordinary skill in the art to understand the disclosure for various embodiments with various modifications as are suited to the particular use contemplated.

The terminology used herein was chosen to best explain the principles of the embodiments, the practical application or technical improvement over technologies found in the marketplace, or to enable others of ordinary skill in the art to understand the embodiments disclosed herein.

**EP 4 625 797 A1**

**Claims**

1. A system for detecting a fault in a power switch in a circuit for converting direct current (DC) to multiphase alternating current (AC) output power where the circuit comprises a plurality of power switches, the system configured to:

   calculate at least one of alpha currents, beta currents, and combinations thereof in each of a multiple of different reference frames using respective alpha-beta transformations in each of the multiple of different reference frames;
   check the signs of the at least one of the alpha currents, the beta currents, and combinations thereof calculated in each of the multiple of different reference frames; and
   determine, based upon the signs of the at least one of the alpha currents, the beta currents, and combinations thereof calculated in each of the multiple of different reference frames, whether a fault occurred in one of the plurality of power switches.

2. The system of claim 1, the system further configured to:

   calculate both the alpha currents and the beta currents in each of the multiple of different reference frames using the respective alpha-beta transformations in each of the multiple of different reference frames; and
   check the signs of both the alpha currents and the beta currents calculated in each of the multiple of different reference frames; and
   determine, based upon the signs of both the alpha currents and the beta currents calculated in each of the multiple of different reference frames, whether one of a short circuit fault or a potential open circuit fault occurred in one of the plurality of power switches.

3. The system of claim 2, further configured to identify, based upon the signs of both the alpha currents and the beta currents calculated in each of the multiple of different reference frames, the specific power switch out of the plurality of power switches that had the short circuit fault or the potential open circuit fault.

4. The system of any one of claims 2-3, further configured to determine, based upon the signs of both the alpha currents and the beta currents calculated in each of the multiple of different reference frames, whether a short circuit fault occurred in one of the plurality of power switches.

5. The system of any one of claims 1-6 further comprising one or more current sensors configured to measure the alternating current values of each multiphase AC output of the circuit.

6. The system of any one of claims 1-5, further configured to:

   receive the alternating current values of each multiphase AC output of the circuit; and
   use the received alternating current values to calculate the alpha currents and the beta currents in each of the multiple of different reference frames.

7. The system of any one of claims 1-6, wherein the number of multiple different reference frames is equal to the number of phases of multiphase AC output power of the circuit.

8. The system of anyone of claims 1-7, wherein each of the multiple different reference frames is rotated with respect to an adjacent different reference frame.

9. The system of anyone of claims 1-8, wherein each of the multiple different reference frames are rotated 360 degrees divided by the number of phases of multiphase AC output power of the circuit with respect to the adjacent different reference frame.

10. The system of any one of claims 1-9, wherein the number of phases of multiphase AC output power of the circuit is three (3) phases and the number of multiple different reference frames is three (3) reference frames.

11. The system of claim 10, wherein the three different reference frames are rotated in the same direction 120 degrees from each adjacent reference frame.

12. The system of any one of claims 1-11, further configured to confirm whether the potential open circuit fault occurred in one of the plurality of power switches.

13. The system of claim 12, wherein configuring to confirm whether the potential open circuit fault occurred in one of the plurality of power switches comprises configuring the system to:

   determine the absolute voltage of the respective one of the plurality of power switches using the alpha voltage and the beta voltage of the respective one of the plurality of power switches; and
   determine if the absolute voltage of the respective one of the plurality of power switches is greater than the minimum voltage output by the circuit.

14. The system of any one of claims 1-13, further comprising one or more voltage sensors to measure the voltage of the multiphase AC power output of the circuit for converting direct current to the multiphase AC power output.

15. The system of any one of claims 1-14, further configured to identify, based upon the signs of the alpha currents in each of the multiple different reference frames, the specific power switch out of the plurality of power switches that had the potential open circuit fault.

**Fig. 1**

**Fig. 3**

**Fig. 2**

EP 4 625 797 A1

Fig. 4A

Fig. 4B

Fig. 5A

Fig. 5B

Fig. 6A

Fig. 6B

Fig. 7A

Fig. 7B

Fig. 8A

Fig. 8B

Fig. 9A

Fig. 9B

Fig. 10A

Fig. 10B

Fig. 11A

Fig. 11B

Fig. 12A

Fig. 12B

Fig. 13A

Fig. 13B

Fig. 14A

Fig. 14B

Fig. 15A

Fig. 15B

Fig. 16A

Fig. 16B

Fig. 17A

Fig. 17B

Fig. 18A

Fig. 18B

**Short Circuit Faults that can be detected in First (Stationary) Frame and Detection Criteria**

| Condition | Fault |
|---|---|
| I($\alpha$) > 0 & I($\beta$) > 0 | Lower Switch W |
| I($\alpha$) < 0 & I($\beta$) < 0 | Upper Switch W |
| I($\alpha$) > 0 & I($\beta$) < 0 | Lower Switch V |
| I($\alpha$) < 0 & I($\beta$) > 0 | Upper Switch V |

Fig. 19A

**Short Circuit Faults that can be detected in Frame 2 and Detection Criteria**

| Condition | Fault |
|---|---|
| I($\alpha$) > 0 & I($\beta$) > 0 | Lower Switch U |
| I($\alpha$) < 0 & I($\beta$) < 0 | Upper Switch U |
| I($\alpha$) > 0 & I($\beta$) < 0 | Lower Switch W |
| I($\alpha$) < 0 & I($\beta$) > 0 | Upper Switch W |

Fig. 19B

**Short Circuit Faults that can be detected in Frame 3 and Detection Criteria**

| Condition | Fault |
|---|---|
| I($\alpha$) > 0 & I($\beta$) > 0 | Lower Switch V |
| I($\alpha$) < 0 & I($\beta$) < 0 | Upper Switch V |
| I($\alpha$) > 0 & I($\beta$) < 0 | Lower Switch U |
| I($\alpha$) < 0 & I($\beta$) > 0 | Upper Switch U |

Fig. 19C

Fig. 20A

Fig. 20B

Fig. 21A

Fig. 21B

Fig. 22A

Fig. 22B

Fig. 23A

Fig. 23B

Fig. 24A

Fig. 24B

**Fig. 25A**

**Fig. 25B**

**Fig. 26A**

**Fig. 26B**

Fig. 27A

Fig. 27B

Fig. 28A

Fig. 28B

**Open Circuit Faults that can be detected in
Frame 1 and Detection Criteria**

| Condition | Fault |
|---|---|
| $I(\alpha) > 0$ | Lower Switch U |
| $I(\alpha) < 0$ | Upper Switch U |

**Fig. 29A**

**Open Circuit Faults that can be detected in Frame 2
and Detection Criteria**

| Condition | Fault |
|---|---|
| $I(\alpha) > 0$ | Lower Switch V |
| $I(\alpha) < 0$ | Upper Switch V |

**Fig. 29B**

**Open Circuit Faults that can be detected in Frame 3
and Detection Criteria**

| Condition | Fault |
|---|---|
| $I(\alpha) > 0$ | Lower Switch W |
| $I(\alpha) < 0$ | Upper Switch W |

**Fig. 29C**

Fig. 30

Fig. 31

Fig. 32

**FIG. 33**

Europäisches
Patentamt

European
Patent Office

Office européen
des brevets

# EUROPEAN SEARCH REPORT

**Application Number**

EP 25 16 5790

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/416688 A1 (ISHIKAWA YASUHIRO [JP] ET AL) 29 December 2022 (2022-12-29) * abstract * * paragraphs [0054], [0055], [0062] - [0065]; figures 1-5 * | 1-15 | INV. H02M1/32 H02M7/5387 |
| X | JP 2011 050214 A (NISSAN MOTOR) 10 March 2011 (2011-03-10) * abstract * * paragraphs [0029] - [0032]; figures 1, 4 * | 1-15 | |
| X | RASYADAN AMIR ET AL: "Modeling of Time Domain Analysis for Single and Double Open-Circuit Inverter Switch Faults in Three-Phase Induction Motor Drives", 2018 INTERNATIONAL CONFERENCE ON COMPUTATIONAL APPROACH IN SMART SYSTEMS DESIGN AND APPLICATIONS (ICASSDA), IEEE, 15 August 2018 (2018-08-15), pages 1-7, XP033410804, DOI: 10.1109/ICASSDA.2018.8477626 [retrieved on 2018-09-28] * abstract; figure 5 * | 1-15 | |

-/--

**TECHNICAL FIELDS SEARCHED (IPC)**

H02M

The present search report has been drawn up for all claims

| Place of search | Date of completion of the search | Examiner |
|---|---|---|
| The Hague | 10 July 2025 | Van der Meer, Paul |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

**Application Number**

EP 25 16 5790

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KIM SANG-HUN ET AL: "Switch Open-Fault Detection for a Three-Phase Hybrid Active Neutral-Point-Clamped Rectifier", ELECTRONICS, vol. 9, no. 9, 3 September 2020 (2020-09-03), pages 1-21, XP093294237, Basel, Switzerland ISSN: 2079-9292, DOI: 10.3390/electronics9091437 Retrieved from the Internet: URL:https://www.mdpi.com/2079-9292/9/9/1437/pdf> * abstract; figures 6-11 * ----- | 1-15 | |
| X | KWON BONG HYUN ET AL: "Fault Diagnosis of Open-Switch Failure in a Grid-Connected Three-Level Si/SiC Hybrid ANPC Inverter", ELECTRONICS, vol. 9, no. 3, 1 March 2020 (2020-03-01), pages 1-18, XP093294388, Basel, Switzerland ISSN: 2079-9292, DOI: 10.3390/electronics9030399 Retrieved from the Internet: URL:https://www.mdpi.com/2079-9292/9/3/399/pdf> * abstract * * Equations 1-4; figures 6-8 * ----- | 1-15 | TECHNICAL FIELDS SEARCHED (IPC) |

The present search report has been drawn up for all claims

| Place of search | Date of completion of the search | Examiner |
|---|---|---|
| The Hague | 10 July 2025 | Van der Meer, Paul |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 16 5790

This annex lists the patent family members relating to the patent documents cited in the above-mentioned European search report.
The members are as contained in the European Patent Office EDP file on
The European Patent Office is in no way liable for these particulars which are merely given for the purpose of information.

10-07-2025

| Patent document cited in search report | Publication date | Patent family member(s) | | Publication date |
|---|---|---|---|---|
| US 2022416688 A1 | 29-12-2022 | CN | 114747130 A | 12-07-2022 |
| | | DE | 112020005076 T5 | 21-07-2022 |
| | | JP | 7239734 B2 | 14-03-2023 |
| | | JP | WO2021100414 A1 | 27-05-2021 |
| | | US | 2022416688 A1 | 29-12-2022 |
| | | WO | 2021100414 A1 | 27-05-2021 |
| JP 2011050214 A | 10-03-2011 | JP | 5402403 B2 | 29-01-2014 |
| | | JP | 2011050214 A | 10-03-2011 |

EPO FORM P0459

For more details about this annex : see Official Journal of the European Patent Office, No. 12/82

**REFERENCES CITED IN THE DESCRIPTION**

**Patent documents cited in the description**

- US 11711003 B

**Non-patent literature cited in the description**

- **E. CLARKE**. Circuit Analysis of AC Power Systems. Wiley, 1943, vol. I,II